(19)

**Europäisches Patentamt**

**European Patent Office**

**Office européen des brevets**

(11) **EP 4 336 829 A1**

(12) **EUROPEAN PATENT APPLICATION**

published in accordance with Art. 153(4) EPC

(43) Date of publication:
**13.03.2024 Bulletin 2024/11**

(21) Application number: **22815293.0**

(22) Date of filing: **01.06.2022**

(51) International Patent Classification (IPC):
**H04N 19/13** (2014.01)    **G10L 25/30** (2013.01)

(52) Cooperative Patent Classification (CPC):
**G10L 25/30; H04N 19/13; H04N 19/176;**
**H04N 19/42; H04N 19/44; H04N 19/91**

(86) International application number:
**PCT/CN2022/096510**

(87) International publication number:
**WO 2022/253249 (08.12.2022 Gazette 2022/49)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **02.06.2021  CN 202110616029**
**17.06.2021  CN 202110674299**
**17.09.2021  CN 202111091143**

(71) Applicant: **Huawei Technologies Co., Ltd.**
**Longgang**
**Shenzhen, Guangdong 518129 (CN)**

(72) Inventors:
• **MAO, Jue**
**Shenzhen, Guangdong 518129 (CN)**

• **ZHAO, Yin**
**Shenzhen, Guangdong 518129 (CN)**
• **YAN, Ning**
**Shenzhen, Guangdong 518129 (CN)**
• **YANG, Haitao**
**Shenzhen, Guangdong 518129 (CN)**
• **ZHANG, Lian**
**Shenzhen, Guangdong 518129 (CN)**
• **WANG, Jing**
**Shenzhen, Guangdong 518129 (CN)**
• **SHI, Yibo**
**Shenzhen, Guangdong 518129 (CN)**

(74) Representative: **Körber, Martin Hans**
**Mitscherlich PartmbB**
**Patent- und Rechtsanwälte**
**Karlstraße 7**
**80333 München (DE)**

(54) **FEATURE DATA ENCODING METHOD AND APPARATUS AND FEATURE DATA DECODING METHOD AND APPARATUS**

(57)    This application provides picture or audio encoding and decoding methods and apparatuses, and relates to the field of artificial intelligence (AI)-based picture or audio encoding and decoding technologies, and specifically, to the field of neural network-based picture feature map or audio feature variable encoding and decoding technologies. The encoding method includes: obtaining a to-be-encoded target, where the to-be-encoded target includes a plurality of feature elements, and the plurality of feature elements include a first feature element. The method further includes: obtaining a probability estimation result of the first feature element; determining, based on the probability estimation result of the first feature element, whether to perform entropy encoding on the first feature element; and performing entropy encoding on the first feature element only when it is determined that entropy encoding needs to be performed on the first feature element. In this application, whether to encode a feature element is determined based on a probability estimation result. In this way, encoding and decoding complexity can be reduced without affecting encoding and decoding performance. The to-be-encoded target includes a picture feature map or audio feature variable.

EP 4 336 829 A1

1500

```
┌─────────────┐                              ┌─────────────┐
│   Encoder   │                              │   Decoder   │
└─────────────┘                              └─────────────┘
```

┌────────────────────────────────────────────┐
│ 1501: Obtain a picture feature map          │
└────────────────────────────────────────────┘

┌────────────────────────────────────────────┐
│ 1502: Extract side information of the picture│
│              feature map                     │
└────────────────────────────────────────────┘

┌────────────────────────────────────────────┐
│ 1503: Perform probability estimation to obtain│
│ probability estimation results of feature elements│
└────────────────────────────────────────────┘

┌────────────────────────────────────────────┐
│ 1504: Determine, based on the probability   │
│ estimation result, whether to perform entropy│
│ encoding on the feature element, and generate a│
│ compressed bitstream (it is determined based on a│
│ first parameter and a second parameter)     │
└────────────────────────────────────────────┘

1505: Send or store the
compressed bitstream

┌────────────────────────────────────────────┐
│ 1511: Obtain the to-be-decoded compressed bitstream│
└────────────────────────────────────────────┘

┌────────────────────────────────────────────┐
│ 1512: Obtain the probability estimation results of the│
│              feature elements                │
└────────────────────────────────────────────┘

┌────────────────────────────────────────────┐
│ 1513: Determine, based on the probability estimation│
│ result, whether to perform entropy decoding on the│
│ feature element to obtain the decoded feature map (it is│
│ determined based on the first parameter and the second│
│              parameter)                      │
└────────────────────────────────────────────┘

┌────────────────────────────────────────────┐
│ 1514: Reconstruct the decoded feature map or perform│
│              a machine task                  │
└────────────────────────────────────────────┘

FIG. 11A

## Description

## TECHNICAL FIELD

Embodiments of the present invention relate to the field of artificial intelligence (AI)-based picture or audio compression technologies, and in particular, to feature data encoding and decoding methods and apparatuses.

## BACKGROUND

Picture or audio encoding and decoding (encoding and decoding for short) are widely used in digital picture or audio applications such as broadcast digital television, picture or audio transmission over the Internet and mobile networks, video or voice chat, real-time conversation applications such as video or voice conferencing, DVDs and Blu-ray discs, picture or audio content capturing and editing systems, and secure applications of camcorders. A video includes a plurality of frames of pictures. Therefore, a picture in this application may be a single picture, or may be a picture in a video.

A large amount of video data needed to depict even a short video can be substantial, which may result in difficulties when the data is to be streamed or communicated across a network with a limited bandwidth capacity. Therefore, picture (or audio) data is generally compressed before being communicated across modern telecommunication networks. A size of picture (or audio) data may also be an issue when the picture (or audio) data is stored on a storage device because memory resources may be limited. A picture (or audio) compression device often uses software and/or hardware at a source side to encode the picture (or audio) data prior to transmission or storage. This decreases an amount of data needed to indicate a digital picture (or audio). The compressed data is then received at a destination side by a picture (or audio) decompression device. With limited network resources and ever increasing demands of higher picture (or audio) quality, improved compression and decompression techniques that improve a compression ratio with little to no sacrifice in picture (or audio) quality are desirable.

In recent years, deep learning is gaining popularity in the fields of picture (or audio) encoding and decoding. For example, Google has organized CLIC (Challenge on Learned Image Compression) competitions at the CVPR (IEEE Conference on Computer Vision and Pattern Recognition) for several consecutive years. The CLIC focuses on using deep neural networks to improve picture compression efficiency. A picture challenge category was also added to the CLIC 2020. Based on performance evaluation of the competition solution, comprehensive compression efficiency of a current picture encoding and decoding solution based on a deep learning technology is equivalent to that of latest-generation video picture encoding and decoding standard VVC (Versatile Video Coding), and has unique advantages in improving user-perceived quality.

Video standards of the VVC were completed in June 2020. The standards include almost all technical algorithms that can significantly improve compression efficiency. Therefore, it is difficult to make a breakthrough in technologies in short time to continue to study new compression coding algorithms along a conventional signal processing path. Different from conventional picture algorithms that optimize modules of picture compression through manual design, end-to-end AI picture compression is optimized as a whole. Therefore, the AI picture compression has better compression effect. A variational autoencoder (variational autoencoder, VAE) method is a mainstream technical solution of a current AI picture lossy compression technology. In the current mainstream technical solution, a picture feature map is obtained for a to-be-encoded picture by using an encoder network, and entropy encoding is further performed on the picture feature map. However, an entropy encoding process is excessively complex.

## SUMMARY

This application provides feature data encoding and decoding methods and apparatuses to reduce encoding and decoding complexity without affecting encoding and decoding performance.

According to a first aspect, a feature data encoding method is provided, including:

obtaining to-be-encoded feature data, where the to-be-encoded feature data includes a plurality of feature elements, and the plurality of feature elements include a first feature element;
obtaining a probability estimation result of the first feature element;
determining, based on the probability estimation result of the first feature element, whether to perform entropy encoding on the first feature element; and
performing entropy encoding on the first feature element only when it is determined that entropy encoding needs to be performed on the first feature element.

The feature data includes a picture feature map, an audio feature variable, or a picture feature map and an audio feature variable; and may be one-dimensional, two-dimensional, or multi-dimensional data output by an encoder network, where each piece of data is a feature element. It should be noted that meanings of a feature point and a feature element in this application are the same.

Specifically, the first feature element is any to-be-encoded feature element of the to-be-encoded feature data.

In a possibility, a probability estimation process of obtaining the probability estimation result of the first feature element may be implemented by using a probability estimation network. In another possibility, a probability estimation process may use a conventional non-network probability estimation method to perform probability estimation on the feature data.

It should be noted that, when only side information is used as an input of the probability estimation, probability estimation results of feature elements may be output in parallel. When the input of the probability estimation includes context information, the probability estimation results of the feature elements need to be output in series. The side information is feature information further extracted by inputting the feature data into a neural network, and a quantity of feature elements included in the side information is less than a quantity of feature elements of the feature data. Optionally, the side information of the feature data may be encoded into a bitstream.

In a possibility, when the first feature element of the feature data does not meet a preset condition, entropy encoding does not need to be performed on the first feature element of the feature data.

Specifically, if the current first feature element is a $P^{th}$ feature element of the feature data, after determining of the $P^{th}$ feature element is completed, and entropy encoding is performed or not performed based on a determining result, determining of a $(P+1)^{th}$ feature element of the feature data is started, and an entropy encoding process is performed or not performed based on a determining result. P is a positive integer and P is less than M, and M is the quantity of feature elements of the entire feature data. For example, for a second feature element, when it is determined that entropy encoding does not need to be performed on the second feature element, performing entropy encoding on the second feature element is skipped.

In the foregoing technical solution, whether entropy encoding needs to be performed is determined for each to-be-encoded feature element, so that entropy encoding processes of some feature elements are skipped, and a quantity of elements on which entropy encoding needs to be performed can be significantly reduced. In this way, entropy encoding complexity can be reduced.

In a possible implementation, the determining whether to perform entropy encoding on the first feature element includes: when the probability estimation result of the first feature element meets the preset condition, determining that entropy encoding needs to be performed on the first feature element; or when the probability estimation result of the first feature element does not meet the preset condition, determining that entropy encoding does not need to be performed on the first feature element.

In a possible implementation, when the probability estimation result of the first feature element is a probability value that a value of the first feature element is k, the preset condition is that the probability value that the value of the first feature element is k is less than or equal to a first threshold, where k is an integer.

k is a value in a possible value range of the value of the first feature element. For example, the value range of the first feature element may be [-255, 255]. k may be set to 0, and entropy encoding is performed on the first feature element whose probability value is less than or equal to 0.5. Entropy encoding is not performed on the first feature element whose probability value is greater than 0.5.

In a possible implementation, the probability value that the value of the first feature element is k is a maximum probability value in probability values of all possible values of the first feature element.

A first threshold selected for an encoded bitstream in a low bit rate case is less than a first threshold selected for the encoded bitstream in a high bit rate case. A specific bit rate is related to picture resolution and picture content. For example, the public Kodak dataset is used. A bit rate lower than 0.5 bpp is a low bit rate. Otherwise, a bit rate is a high bit rate.

In a case of a specific bit rate, the first threshold may be configured based on an actual requirement. This is not limited herein.

In the foregoing technical solution, the entropy encoding complexity can be flexibly reduced based on a requirement and by flexibly setting the flexible first threshold.

In a possible implementation, the probability estimation result of the first feature element includes a first parameter and a second parameter that are of probability distribution of the first feature element.

When the probability distribution is Gaussian distribution, the first parameter of the probability distribution of the first feature element is a mean value of the Gaussian distribution of the first feature element, and the second parameter of the probability distribution of the first feature element is a variance of the Gaussian distribution of the first feature element. Alternatively, when the probability distribution is Laplace distribution, the first parameter of the probability distribution of the first feature element is a location parameter of the Laplace distribution of the first feature element, and the second parameter of the probability distribution of the first feature element is a scale parameter of the Laplace distribution of the first feature element. The preset condition may be any one of the following:

an absolute value of a difference between the first parameter of the probability distribution of the first feature element and a value k of the first feature element is greater than or equal to a second threshold; the second parameter of the probability distribution of the first feature element is greater than or equal to a third threshold; or a sum of the second parameter of the probability distribution of the first feature element and an absolute value of a difference between the first parameter of the probability distribution of the first feature element and a value k of the first feature element is greater than or equal to a fourth threshold.

When the probability distribution is Gaussian mixture distribution, the first parameter of the probability distribution of the first feature element is a mean value of the Gaussian mixture distribution of the first feature element, and the second parameter of the probability distribution of the first feature element is a variance of the Gaussian mixture distribution of the first feature element. The preset condition may be any one of the following:

a sum of any variance of the Gaussian mixture distribution of the first feature element and a sum of absolute values of differences between all mean values of the Gaussian mixture distribution of the first feature element and a value k of the first feature element is greater than or equal to a fifth threshold;
a difference between any mean value of the Gaussian mixture distribution of the first feature element and a value k of the first feature element is greater than or equal to a sixth threshold; or
any variance of the Gaussian mixture distribution of the first feature element is greater than or equal to a seventh threshold.

When the probability distribution is asymmetric Gaussian distribution, the first parameter of the probability distribution of the first feature element is a mean value of the asymmetric Gaussian distribution of the first feature element, and second parameters of the probability distribution of the first feature element are a first variance and a second variance of the asymmetric Gaussian distribution of the first feature element. The preset condition may be any one of the following:

an absolute value of a difference between a mean value of the asymmetric Gaussian distribution of the first feature element and a value k of the first feature element is greater than or equal to an eighth threshold;
the first variance of the asymmetric Gaussian distribution of the first feature element is greater than or equal to a ninth threshold; or
the second variance of the asymmetric Gaussian distribution of the first feature element is greater than or equal to a tenth threshold.

When the probability distribution of the first feature element is the Gaussian mixture distribution, a determining value range of the first feature element is determined. A plurality of mean values of the probability distribution of the first feature element are not in the determining value range of the first feature element.

When the probability distribution of the first feature element is the Gaussian distribution, a determining value range of the first feature element is determined. The mean value of the probability distribution of the first feature element is not in the determining value range of the first feature element.

When the probability distribution of the first feature element is the Gaussian distribution, a determining value range of the first feature element is determined, and the determining value range includes a plurality of possible values of the first feature element. An absolute value of a difference between a mean value parameter of the Gaussian distribution of the first feature element and each value in the determining value range of the first feature element is greater than or equal to an eleventh threshold, or a variance of the probability distribution of the first feature element is greater than or equal to a twelfth threshold.

The value of the first feature element is not in the determining value range of the first feature element.

A probability value corresponding to the value of the first feature element is less than or equal to a thirteenth threshold.

In a possible implementation, the method further includes: constructing a threshold candidate list of the first threshold, putting the first threshold into the threshold candidate list of the first threshold, where there is an index number corresponding to the first threshold, and writing the index number of the first threshold into an encoded bitstream, where a length of the threshold candidate list of the first threshold may be set to T, and T is an integer greater than or equal to 1. It may be understood that another threshold may be constructed in a manner such as constructing the threshold candidate list of the first threshold. The another threshold has a corresponding index number that is written into the encoded bitstream.

Specifically, the index number is written into the bitstream, and may be stored in a sequence header (sequence header), a picture header (picture header), a slice/slice header (slice header), or SEI (supplemental enhancement information), and transmitted to a decoder side. Alternatively, another method may be used. This is not limited herein. A manner of constructing the candidate list is not limited.

In another possibility, decision information is obtained by inputting the probability estimation result into a generative network. The generative network may be a convolutional network, and may include a plurality of network layers. Any network layer may be a convolutional layer, a normalization layer, a non-linear activation layer, or the like.

In a possible implementation, a probability estimation result of the feature data is input into a generative network to obtain decision information of the first feature element. The decision information indicates whether to perform entropy encoding on the first feature element.

In a possible implementation, the decision information of the feature data is a decision map, and the decision map may also be referred to as a decision map. The decision map is preferably a binary map, and the binary map may also be referred to as a binary map. A value of decision information of a feature element in the binary map is usually 0 or 1. Therefore, when a value corresponding to a location at which the first feature element is located in the decision map is a preset value, entropy encoding needs to be performed on the first feature element. When a value corresponding to a location at which the first feature element is located in the decision map is not a preset value, entropy encoding does not need to be performed on the first feature element.

In a possible implementation, the decision information of the feature element of the feature data is a preset value. The preset value of the decision information is usually 1. Therefore, when the decision information is the preset value, entropy encoding needs to be performed on the first feature element. When the decision information is not the preset value, entropy encoding does not need to be performed on the first feature element. The decision information may be an identifier or an identifier value. Determining whether to perform entropy encoding on the first feature element depends on whether the identifier or the identifier value is the preset value. When the identifier or the identifier value is the preset value, entropy encoding needs to be performed on the first feature element. When the identifier or the identifier value is not the preset value, entropy encoding does not need to be performed on the first feature element. A set of decision information of the feature elements of the feature data may alternatively be floating point numbers. In other words, a value may be another value other than 0 and 1. In this case, the preset value may be set. When a value of the decision information of the first feature element is greater than or equal to the preset value, it is determined that entropy encoding needs to be performed on the first feature element. When a value of the decision information of the first feature element is less than the preset value, it is determined that entropy encoding does not need to be performed on the first feature element.

In a possible implementation, the method further includes: obtaining the feature data by a to-be-encoded picture passing through the encoder network; obtaining the feature data by rounding a to-be-encoded picture after the to-be-encoded picture passes through the encoder network; or obtaining the feature data by quantizing and rounding a to-be-encoded picture after the to-be-encoded picture passes through the encoder network.

The encoder network may use an autoencoder structure. The encoder network may be a convolutional neural network. The encoder network may include a plurality of subnets, and each subnet includes one or more convolutional layers. Network structures between the subnets may be the same or different.

The to-be-encoded picture may be an original picture or a residual picture.

It should be understood that the to-be-encoded picture may be in an RGB format or a representation format such as YUV or RAW. A preprocessing operation may be performed on the to-be-encoded picture before being input into the encoder network. The preprocessing operation may include operations such as conversion, block division, filtering, and pruning.

It should be understood that a plurality of to-be-encoded pictures or a plurality of to-be-encoded picture blocks are allowed to be input into encoder and decoder networks for processing within a same time stamp or at a same moment, to obtain the feature data.

According to a second aspect, a feature data decoding method is provided, including:

obtaining a bitstream of to-be-decoded feature data, where
the to-be-decoded feature data includes a plurality of feature elements, and the plurality of feature elements include a first feature element;
obtaining a probability estimation result of the first feature element;
determining, based on the probability estimation result of the first feature element, whether to perform entropy decoding on the first feature element; and
performing entropy decoding on the first feature element only when it is determined that entropy decoding needs to be performed on the first feature element.

It may be understood that the first feature element is any feature element of the to-be-decoded feature data. After determining of all feature elements of the to-be-decoded feature data is completed, and entropy decoding is performed or not performed based on a determining result, the decoded feature data is obtained.

The decoded feature data may be one-dimensional, two-dimensional, or multi-dimensional data, where each piece of data is a feature element. It should be noted that meanings of a feature point and a feature element in this application are the same.

Specifically, the first feature element is any to-be-decoded feature element of the to-be-decoded feature data.

In a possibility, a probability estimation process of obtaining the probability estimation result of the first feature element may be implemented by using a probability estimation network. In another possibility, a probability estimation process may use a conventional non-network probability estimation method to perform probability estimation on the feature data.

It should be noted that, when only side information is used as an input of the probability estimation, probability estimation results of feature elements may be output in parallel. When the input of the probability estimation includes context information, the probability estimation results of the feature elements need to be output in series. A quantity of feature elements included in the side information is less than a quantity of feature elements of the feature data.

In a possibility, a bitstream includes the side information, and the side information needs to be decoded in a process of decoding the bitstream.

Specifically, a determining process of each feature element of the feature data includes condition determining and determining, based on a condition determining result, whether to perform entropy decoding.

In a possibility, entropy decoding may be implemented by using a neural network.

In another possibility, entropy decoding may be implemented through conventional entropy decoding.

Specifically, if the current first feature element is a $P^{th}$ feature element of the feature data, after determining of the $P^{th}$ feature element is completed, and entropy decoding is performed or not performed based on a determining result, determining of a $(P+1)^{th}$ feature element of the feature data is started, and an entropy decoding process is performed or not performed based on a determining result. P is a positive integer and P is less than M, and M is the quantity of feature elements of the entire feature data. For example, for a second feature element, when it is determined that entropy decoding does not need to be performed on the second feature element, performing entropy decoding on the second feature element is skipped.

In the foregoing technical solution, whether entropy decoding needs to be performed is determined for each to-be-decoded feature element, so that entropy decoding processes of some feature elements are skipped, and a quantity of elements on which entropy decoding needs to be performed can be significantly reduced. In this way, entropy decoding complexity can be reduced.

In a possible implementation, the determining whether to perform entropy decoding on the first feature element of the feature data includes: when the probability estimation result of the first feature element of the feature data meets a preset condition, determining that entropy decoding needs to be performed on the first feature element; or when the probability estimation result of the first feature element does not meet a preset condition, determining that entropy decoding does not need to be performed on the first feature element, and setting a feature value of the first feature element to k, where k is an integer.

In a possible implementation, when the probability estimation result of the first feature element is a probability value that the value of the first feature element is k, the preset condition is that the probability value that the value of the first feature element is k is less than or equal to a first threshold, where k is an integer.

In a possibility, the first feature element is set to k when the preset condition is not met. For example, the value range of the first feature element may be [-255, 255]. k may be set to 0, and entropy encoding is performed on the first feature element whose probability value is less than or equal to 0.5. Entropy encoding is not performed on the first feature element whose probability value is greater than 0.5.

In another possibility, the value of the first feature element is determined by using a list when the preset condition is not met.

In another possibility, the first feature element is set to a fixed integer value when the preset condition is not met.

k is a value in a possible value range of the value of the first feature element.

In a possibility, k is a value corresponding to a maximum probability in all possible value ranges of the first feature element.

A first threshold selected for a decoded bitstream in a low bit rate case is less than a first threshold selected for the decoded bitstream in a high bit rate case. A specific bit rate is related to picture resolution and picture content. For example, the public Kodak dataset is used. A bit rate lower than 0.5 bpp is a low bit rate. Otherwise, a bit rate is a high bit rate.

In a case of a specific bit rate, the first threshold may be configured based on an actual requirement. This is not limited herein.

In the foregoing technical solution, the entropy decoding complexity can be flexibly reduced based on a requirement and by flexibly setting the flexible first threshold.

In a possible implementation, the probability estimation result of the first feature element includes a first parameter and a second parameter that are of probability distribution of the first feature element.

When the probability distribution is Gaussian distribution, the first parameter of the probability distribution of the first feature element is a mean value of the Gaussian distribution of the first feature element, and the second parameter of the probability distribution of the first feature element is a variance of the Gaussian distribution of the first feature element. Alternatively, when the probability distribution is Laplace distribution, the first parameter of the probability distribution of the first feature element is a location parameter of the Laplace distribution of the first feature element, and the second parameter of the probability distribution of the first feature element is a scale parameter of the Laplace distribution of the first feature element. The preset condition may be any one of the following:

an absolute value of a difference between the first parameter of the probability distribution of the first feature element and the value k of the first feature element is greater than or equal to a second threshold;
the second parameter of the first feature element is greater than or equal to a third threshold; or
a sum of the second parameter of the probability distribution of the first feature element and an absolute value of a difference between the first parameter of the probability distribution of the first feature element and the value k of the first feature element is greater than or equal to a fourth threshold.

When the probability distribution is Gaussian mixture distribution, the first parameter of the probability distribution of the first feature element is a mean value of the Gaussian mixture distribution of the first feature element, and the second parameter of the probability distribution of the first feature element is a variance of the Gaussian mixture distribution of the first feature element. The preset condition may be any one of the following:

a sum of any variance of the Gaussian mixture distribution of the first feature element and a sum of absolute values of differences between all mean values of the Gaussian mixture distribution of the first feature element and the value k of the first feature element is greater than or equal to a fifth threshold; a difference between any mean value of the Gaussian mixture distribution of the first feature element and the value k of the first feature element is greater than a sixth threshold; or any variance of the Gaussian mixture distribution of the first feature element is greater than or equal to a seventh threshold.

When the probability distribution is asymmetric Gaussian distribution, the first parameter of the probability distribution of the first feature element is a mean value of the asymmetric Gaussian distribution of the first feature element, and second parameters of the probability distribution of the first feature element are a first variance and a second variance of the asymmetric Gaussian distribution of the first feature element. The preset condition may be any one of the following:

an absolute value of a difference between a mean value parameter of the asymmetric Gaussian distribution of the first feature element and the value k of the first feature element is greater than an eighth threshold; the first variance of the asymmetric Gaussian distribution of the first feature element is greater than or equal to a ninth threshold; or the second variance of the asymmetric Gaussian distribution of the first feature element is greater than or equal to a tenth threshold.

When the probability distribution of the first feature element is the Gaussian mixture distribution, a determining value range of the first feature element is determined. A plurality of mean values of the probability distribution of the first feature element are not in the determining value range of the first feature element.

When the probability distribution of the first feature element is the Gaussian distribution, a determining value range of the first feature element is determined. The mean value of the probability distribution of the first feature element is not in the determining value range of the first feature element.

When the probability distribution of the first feature element is the Gaussian distribution, a determining value range of the first feature element is determined, and the determining value range includes a plurality of possible values of the first feature element. An absolute value of a difference between a mean value parameter of the Gaussian distribution of the first feature element and each value in the determining value range of the first feature element is greater than or equal to an eleventh threshold, or a variance of the probability distribution of the first feature element is greater than or equal to a twelfth threshold.

The value k of the first feature element is not in the determining value range of the first feature element.

A probability value corresponding to the value k of the first feature element is less than or equal to a thirteenth threshold.

In a possible implementation, a threshold candidate list of the first threshold is constructed, an index number of the threshold candidate list of the first threshold is obtained by decoding the bitstream, and a value of a location that corresponds to the index number of the first threshold and that is of the threshold candidate list of the first threshold is used as a value of the first threshold. A length of the threshold candidate list of the first threshold may be set to T, and T is an integer greater than or equal to 1. It may be understood that any other threshold may be constructed in a manner such as constructing the threshold candidate list of the first threshold. An index number corresponding to a threshold may be obtained through decoding, and a value in the constructed list is selected as the threshold based on the index number.

In another possibility, decision information is obtained by inputting the probability estimation result into a generative network. The generative network may be a convolutional network, and may include a plurality of network layers. Any network layer may be a convolutional layer, a normalization layer, a non-linear activation layer, or the like.

In a possible implementation, a probability estimation result of the feature data is input into a generative network to obtain decision information of the first feature element. The decision information indicates whether to perform entropy decoding on the first feature element.

In a possible implementation, the decision information of the feature elements of the feature data is a decision map, and the decision map may also be referred to as a decision map. The decision map is preferably a binary map, and the binary map may also be referred to as a binary map. A value of decision information of a feature element in the binary map is usually 0 or 1. Therefore, when a value corresponding to a location at which the first feature element is located in the decision map is a preset value, entropy decoding needs to be performed on the first feature element. When a value corresponding to a location at which the first feature element is located in the decision map is not a preset value, entropy decoding does not need to be performed on the first feature element.

A set of decision information of the feature elements of the feature data may alternatively be floating point numbers. In other words, a value may be another value other than 0 and 1. In this case, the preset value may be set. When a value of the decision information of the first feature element is greater than or equal to the preset value, it is determined that entropy decoding needs to be performed on the first feature element. When a value of the decision information of the first feature element is less than the preset value, it is determined that entropy decoding does not need to be performed on the first feature element.

In a possible implementation, a reconstructed picture is obtained by the feature data passing through a decoder network.

In another possible implementation, machine-oriented task data is obtained by the feature data passing through a decoder network. Specifically, the machine-oriented task data is obtained by the feature data passing through a machine-oriented task module, and the machine-oriented module includes a target recognition network, a classification network, or a semantic segmentation network.

According to a third aspect, a feature data encoding apparatus is provided, including:

an obtaining module, configured to: obtain to-be-encoded feature data, where the to-be-encoded feature data includes a plurality of feature elements, and the plurality of feature elements include a first feature element; and obtain a probability estimation result of the first feature element; and
an encoding module, configured to: determine, based on the probability estimation result of the first feature element, whether to perform entropy encoding on the first feature element; and perform entropy encoding on the first feature element only when it is determined that entropy encoding needs to be performed on the first feature element.

For further implementation functions of the obtaining module and the encoding module, refer to any one of the first aspect or implementations of the first aspect. Details are not described herein again.

According to a fourth aspect, a feature data decoding apparatus is provided, including:

an obtaining module, configured to: obtain a bitstream of to-be-decoded feature data, where the to-be-decoded feature data includes a plurality of feature elements, and the plurality of feature elements include a first feature element; and obtain a probability estimation result of the first feature element; and
a decoding module, configured to: determine, based on the probability estimation result of the first feature element, whether to perform entropy decoding on the first feature element; and perform entropy decoding on the first feature element only when it is determined that entropy decoding needs to be performed on the first feature element.

For further implementation functions of the obtaining module and the decoding module, refer to any one of the second aspect or implementations of the second aspect. Details are not described herein again.

According to a fifth aspect, this application provides an encoder, including a processing circuit, configured to determine the method according to the first aspect and any one of the first aspect.

According to a sixth aspect, this application provides a decoder, including a processing circuit, configured to determine the method according to the second aspect and any one of the second aspect.

According to a seventh aspect, this application provides a computer program product, including program code. When the program code is determined on a computer or a processor, the program code is used to determine the method according to the first aspect and any one of the first aspect, and the method according to the second aspect and any one of the second aspect.

According to an eighth aspect, this application provides an encoder, including one or more processors, and a non-transitory computer-readable storage medium, coupled to the processor and storing a program determined by the processor. When the program is determined by the processor, the decoder is enabled to determine the method according to the first aspect and any one of the first aspect.

According to a ninth aspect, this application provides a decoder, including one or more processors, and a non-transitory computer-readable storage medium, coupled to the processor and storing a program determined by the processor. When the program is determined by the processor, the encoder is enabled to determine the method according to the second aspect and any one of the second aspect.

According to a tenth aspect, this application provides a non-transitory computer-readable storage medium, including program code. When the program code is determined by a computer device, the program code is used to determine the method according to the first aspect and any one of the first aspect, and the method according to the second aspect and any one of the second aspect.

According to an eleventh aspect, the present invention relates to an encoding apparatus, which has a function of implementing behavior according to any one of the first aspect or method embodiments of the first aspect. The function may be implemented by hardware, or may be implemented by hardware determining corresponding software. The hardware or the software includes one or more modules corresponding to the foregoing function. In a possible design, the encoding apparatus includes: an obtaining module, configured to: transform an original picture or a residual picture into feature space by using an encoder network, and extract feature data for compression, where probability estimation is performed on the feature data to obtain probability estimation results of feature elements of the feature data; and an encoding module, configured to: determine, by using the probability estimation results of the feature elements of the feature data and based on a specific condition, whether entropy encoding is performed on the feature elements of the feature data, and complete encoding processes of all the feature elements of the feature data to obtain an encoded bitstream of the feature data. These modules may determine corresponding functions in the method example according to the first aspect and any one of the first aspect. For details, refer to the detailed descriptions in the method example. Details are not described herein again.

According to a twelfth aspect, the present invention relates to a decoding apparatus, which has a function of implementing behavior according to any one of the second aspect or method embodiments of the second aspect. The function may be implemented by hardware, or may be implemented by hardware determining corresponding software. The hardware or the software includes one or more modules corresponding to the foregoing function. In a possible design, the decoding apparatus includes an obtaining module, configured to: obtain a bitstream of to-be-decoded feature data, and perform probability estimation based on the bitstream of the to-be-decoded feature data to obtain probability estimation results of feature elements of the feature data; and a decoding module, configured to: determine, by using the probability estimation results of the feature elements of the feature data and based on a specific condition, whether entropy decoding is performed on the feature elements of the feature data, complete decoding processes of all the feature elements of the feature data to obtain the feature data, and decode the feature data to obtain a reconstructed picture or machine-oriented task data. These modules may determine corresponding functions in the method example according to the second aspect and any one of the second aspect. For details, refer to the detailed descriptions in the method example. Details are not described herein again.

According to a thirteenth aspect, a feature data encoding method is provided, including:

> obtaining to-be-encoded feature data, where the feature data includes a plurality of feature elements, and the plurality of feature elements include a first feature element;
> obtaining side information of the feature data, and inputting the side information of the feature data into a joint network to obtain decision information of the first feature element;
> determining, based on the decision information of the first feature element, whether to perform entropy encoding on the first feature element; and
> performing entropy encoding on the first feature element only when it is determined that entropy encoding needs to be performed on the first feature element.

The feature data is one-dimensional, two-dimensional, or multi-dimensional data output by an encoder network, where each piece of data is a feature element.

In a possibility, the side information of the feature data may be encoded into a bitstream. The side information is feature information further extracted by inputting the feature data into a neural network, and a quantity of feature elements included in the side information is less than a quantity of feature elements of the feature data.

The first feature element is any feature element of the feature data.

In a possibility, a set of decision information of the feature elements of the feature data may be represented in a manner such as a decision map. The decision map is one-dimensional, two-dimensional, or multi-dimensional picture data, and a size of the decision map is consistent with that of the feature data.

In a possibility, a joint network further outputs a probability estimation result of the first feature element. The probability estimation result of the first feature element includes a probability value of the first feature element, and/or a first parameter and a second parameter that are of probability distribution.

In the foregoing technical solution, whether entropy encoding needs to be performed is determined for each to-be-encoded feature element, so that entropy encoding processes of some feature elements are skipped, and a quantity of elements on which entropy encoding needs to be performed can be significantly reduced. In this way, entropy encoding complexity can be reduced.

In a possibility, when a value corresponding to a location at which the first feature element is located in the decision map is a preset value, entropy encoding needs to be performed on the first feature element. When a value corresponding to a location at which the first feature element is located in the decision map is not a preset value, entropy encoding does not need to be performed on the first feature element.

According to a fourteenth aspect, a feature data decoding method is provided, including:

> obtaining a bitstream of to-be-decoded feature data and side information of the to-be-decoded feature data, where
> the to-be-decoded feature data includes a plurality of feature elements, and the plurality of feature elements include a first feature element;
> inputting the side information of the to-be-decoded feature data into a joint network to obtain decision information of the first feature element;
> determining, based on the decision information of the first feature element, whether to perform entropy decoding on the first feature element; and

performing entropy decoding on the first feature element only when it is determined that entropy decoding needs to be performed on the first feature element.

In a possibility, a bitstream of the to-be-decoded feature data is decoded to obtain the side information. A quantity of feature elements included in the side information is less than a quantity of feature elements of the feature data.

The first feature element is any feature element of the feature data.

In a possibility, decision information of the feature elements of the feature data may be represented in a manner such as a decision map. The decision map is one-dimensional, two-dimensional, or multi-dimensional picture data, and a size of the decision map is consistent with that of the feature data.

In a possibility, a joint network further outputs a probability estimation result of the first feature element. The probability estimation result of the first feature element includes a probability value of the first feature element, and/or a first parameter and a second parameter that are of probability distribution.

In a possibility, when a value corresponding to a location at which the first feature element is located in the decision map is a preset value, entropy decoding needs to be performed on the first feature element. When a value corresponding to a location at which the first feature element is located in the decision map is not a preset value, entropy decoding does not need to be performed on the first feature element, and a feature value of the first feature element is set to k, where k is an integer.

In the foregoing technical solution, whether entropy decoding needs to be performed is determined for each to-be-encoded feature element, so that entropy decoding processes of some feature elements are skipped, and a quantity of elements on which entropy decoding needs to be performed can be significantly reduced. In this way, entropy decoding complexity can be reduced.

In the existing mainstream end-to-end feature data encoding and decoding solutions, entropy encoding and decoding or arithmetic encoding and decoding processes are excessively complex. In this application, information related to the probability distribution of the feature points in the to-be-encoded feature data is used to determine whether entropy encoding needs to be performed on a feature element of each piece of to-be-encoded feature data and whether entropy decoding needs to be performed on a feature element of each piece of to-be-decoded feature data, so that entropy encoding and decoding processes of some feature elements are skipped, and a quantity of elements on which encoding and decoding need to be performed can be significantly reduced. This reduces encoding and decoding complexity. In another aspect, a threshold may be flexibly set based on a requirement of an actual value of a bit rate of a bitstream, to control the value of the bit rate of the generated bitstream.

Details of one or more embodiments are described in detail in the accompanying drawings and the description below. Other features, objects, and advantages are apparent from the description, drawings, and claims.

**BRIEF DESCRIPTION OF DRAWINGS**

The following describes accompanying drawings used in embodiments of this application.

FIG. 1A is an example block diagram of a picture decoding system;

FIG. 1B is an implementation of a processing circuit of a picture decoding system;

FIG. 1C is a schematic block diagram of a picture decoding device;

FIG. 1D is an apparatus implementation diagram according to an embodiment of this application;

FIG. 2A is a system architecture diagram in a possible scenario according to this application;

FIG. 2B is a system architecture diagram in a possible scenario according to this application;

FIG. 3A to FIG. 3D are schematic block diagrams of an encoder;

FIG. 4A is a schematic diagram of an encoder network unit;

FIG. 4B is a schematic diagram of a network structure of an encoder network;

FIG. 5 is a schematic diagram of a structure of an encoding decision implementation unit;

FIG. 6 is an example output diagram of a joint network;

FIG. 7 is an example output diagram of a generative network;

FIG. 8 is a schematic implementation diagram of a decoding decision implementation;

FIG. 9 is an example diagram of a network structure of a decoder network;

FIG. 10A is an example diagram of a coding method according to an embodiment of this application;

FIG. 10B is a schematic block diagram of a picture feature map decoder according to an embodiment of this application;

FIG. 11A is an example diagram of a coding method according to an embodiment of this application;

FIG. 12 is an example diagram of a network structure of a side information extraction module;

FIG. 13A is an example diagram of a coding method according to an embodiment of this application;

FIG. 13B is a schematic block diagram of a picture feature map decoder according to an embodiment of this application;

FIG. 14 is an example diagram of a coding method according to an embodiment of this application;

FIG. 15 is an example diagram of a network structure of a joint network;

FIG. 16 is a schematic block diagram of a picture feature map decoder according to an embodiment of this application;

FIG. 17 is an example diagram of a coding method according to an embodiment of this application;

FIG. 18 is a schematic diagram of an example structure of an encoding apparatus according to this application; and

FIG. 19 is a schematic diagram of an example structure of a decoding apparatus according to this application.

## DESCRIPTION OF EMBODIMENTS

Terms such as "first" and "second" in embodiments of this application are only used for distinguishing and description, but cannot be understood as an indication or implication of relative importance, or an indication or implication of an order. In addition, the terms "include", "comprise", and any variant thereof are intended to cover non-exclusive inclusion, for example, inclusion of a series of steps or units. A method, a system, a product, or a device is not necessarily limited to clearly listed steps or units, but may include other steps or units that are not clearly listed and that are inherent to the process, the method, the product, or the device.

It should be understood that, in this application, "at least one (item)" refers to one or more, and "a plurality of" refers to two or more. The term "and/or" describes an association relationship of associated objects, and indicates that three relationships may exist. For example, "A and/or B" may indicate the following three cases: Only A exists, only B exists, and both A and B exist, where A and B may be singular or plural. The character "/" generally indicates an "or" relationship between the associated objects. "At least one of the following items (pieces)" or a similar expression thereof indicates any combination of these items, including a single item (piece) or any combination of a plurality of items (pieces). For example, at least one (piece) of a, b, or c may represent: a, b c, "a and b", "a and c", "b and c", or "a, b and c", where a, b and c may be singular or plural.

Embodiments of this application provide AI-based feature data encoding and decoding technologies, in particular, provide a neural network-based picture feature map and/or audio feature variable encoding and decoding technologies, and specifically provide an end-to-end-based picture feature map and/or audio feature variable encoding and decoding systems.

In the field of picture coding, the terms "picture (picture)" and "image (image)" may be used as synonyms. Picture coding (or generally referred to as coding) includes two parts: picture encoding and picture decoding. A video includes a plurality of pictures, and is a representation manner of continuous pictures. Picture encoding is determined at a source side, and usually includes processing (for example, compressing) an original video picture to reduce an amount of data required for representing the video picture (for more efficient storage and/or transmission). Picture decoding is determined on a destination side, and usually includes inverse processing in comparison with processing of an encoder to reconstruct the picture. Embodiments referring to "coding" of pictures or audios shall be understood as "encoding" or "decoding" of pictures or audios. A combination of an encoding part and a decoding part is also referred to as encoding and decoding (encoding and decoding, CODEC).

In a case of lossless picture coding, an original picture can be reconstructed. In other words, a reconstructed picture has same quality as the original picture (it is assumed that no transmission loss or other data loss occurs during storage or transmission). In a case of conventional lossy picture coding, further compression is determined through, for example, quantization, to reduce an amount of data required for representing a video picture, and the video picture cannot be completely reconstructed on a decoder side, in other words, quality of a reconstructed video picture is lower or worse compared to quality of the original video picture.

Because embodiments of this application relate to massive application of a neural network, for ease of understanding, the following describes terms and concepts related to the neural network that may be used in embodiments of this application.

(1) Neural network

The neural network may include neurons. The neuron may be an operation unit that uses $x_s$ and an intercept of 1 as an input. An output of the operation unit may be as follows:

$$h_{W,b}(x) = f\left(W^T x\right) = f\left(\sum_{s=1}^{n} W_s x_s + b\right) \quad (1\text{-}1)$$

s = 1, 2, ..., or n, n is a natural number greater than 1, $W_s$ is a weight of $x_s$, and b is bias of the neuron. f is an activation function (activation function) of the neuron, used to introduce a non-linear feature into the neural network, to convert an input signal in the neuron into an output signal. The output signal of the activation function may be used as an input of a next convolutional layer, and the activation function may be a sigmoid function. The neural network is a network constituted by connecting a plurality of single neurons together. To be specific, an output of a neuron may be an input of another neuron. An input of each neuron may be connected to a local receptive field of a previous layer to extract a feature of the local receptive field. The local receptive field may be a region including several neurons.

(2) Deep neural network

The deep neural network (deep neural network, DNN) is also referred to as a multi-layer neural network, and may be understood to be a neural network with a plurality of hidden layers. The DNN is divided based on locations of different layers. Neural networks inside the DNN may be classified into three types: an input layer, a hidden layer, and an output layer. Generally, the first layer is the input layer, the last layer is the output layer, and the middle layer is the hidden layer. Layers are fully connected. To be specific, any neuron at an $i^{th}$ layer is necessarily connected to any neuron at an $(i+1)^{th}$ layer.

Although the DNN seems complex, it is not complex in terms of work at each layer. Simply speaking, the DNN is the following linear relationship expression: $\vec{y} = \alpha(W\vec{x}+\vec{b})$, where $\vec{x}$ is an input vector, $\vec{y}$ is an output vector, $\vec{b}$ is an offset vector, $W$ is a weight matrix (also referred to as a coefficient), and $\alpha( )$ is an activation function. At each layer, only such a simple operation is performed on the input vector $\vec{x}$ to obtain the output vector $\vec{y}$. Because there are a plurality of layers in the DNN, there are also a plurality of coefficients $W$ and a plurality of offset vectors $\vec{b}$. Definitions of the parameters in the DNN are as follows: The coefficient $W$ is used as an example. It is assumed that in a DNN with three layers, a linear coefficient from the fourth neuron at the second layer to the second neuron at the third layer is defined as $W_{24}^{3}$. The superscript 3 represents a layer at which the coefficient $W$ is located, and the subscript corresponds to an output third-layer index 2 and an input second-layer index 4.

In conclusion, a coefficient from a $k^{th}$ neuron at an $(L-1)^{th}$ layer to a $j^{th}$ neuron at an $L^{th}$ layer is defined as $W_{jk}^{L}$.

It should be noted that the input layer does not have the parameter $W$. In the deep neural network, more hidden layers make the network more capable of describing a complex case in the real world. Theoretically, a model with more parameters has higher complexity and a larger "capacity". It indicates that the model can complete a more complex learning task. A process of training the deep neural network is a process of learning a weight matrix, and a final objective of training is to obtain weight matrices (weight matrices including vectors $W$ at a plurality of layers) of all layers in a trained deep neural network.

(3) Convolutional neural network

The convolutional neural network (convolutional neuron network, CNN) is a deep neural network with a convolutional structure. The convolutional neural network includes a feature extractor including a convolutional layer and a sub-sampling layer, and the feature extractor may be considered as a filter. The convolutional layer is a neuron layer that is in the convolutional neural network and at which convolution processing is performed on an input signal. At the convolutional layer of the convolutional neural network, one neuron may be connected to only a part of neurons at a neighboring layer. A convolutional layer usually includes several feature planes, and each feature plane may include some neurons arranged in a rectangle. Neurons of a same feature plane share a weight, and the shared weight herein is a convolution kernel. Weight sharing may be understood as that a picture information extraction manner is irrelevant to a location. The convolution kernel may be initialized in a form of a random-size matrix. In a process of training the convolutional neural network, the convolution kernel may obtain an appropriate weight through learning. In addition, a direct benefit brought by weight sharing is that connections between layers in the convolutional neural network are reduced and an overfitting risk is lowered.

(4) Entropy encoding

Entropy encoding is used to apply, for example, an entropy coding algorithm or scheme (for example, a variable length coding (variable length coding, VLC) scheme, a context adaptive VLC (context adaptive VLC, CAVLC) scheme, an arithmetic coding scheme, a binarization algorithm, a context adaptive binary arithmetic coding (context adaptive binary arithmetic coding, CABAC), syntax-based context-adaptive binary arithmetic coding (syntax-based context-adaptive binary arithmetic coding, SBAC), probability interval partitioning entropy (probability interval partitioning entropy, PIPE) coding, or another entropy coding method or technology) on quantized coefficients and other syntax elements to obtain encoded data which may be output through an output in a form of an encoded bitstream, so that a decoder or the like may receive and use parameters for decoding. The encoded bitstream may be transmitted to the decoder, or stored in a memory for subsequent transmission or retrieval by the decoder.

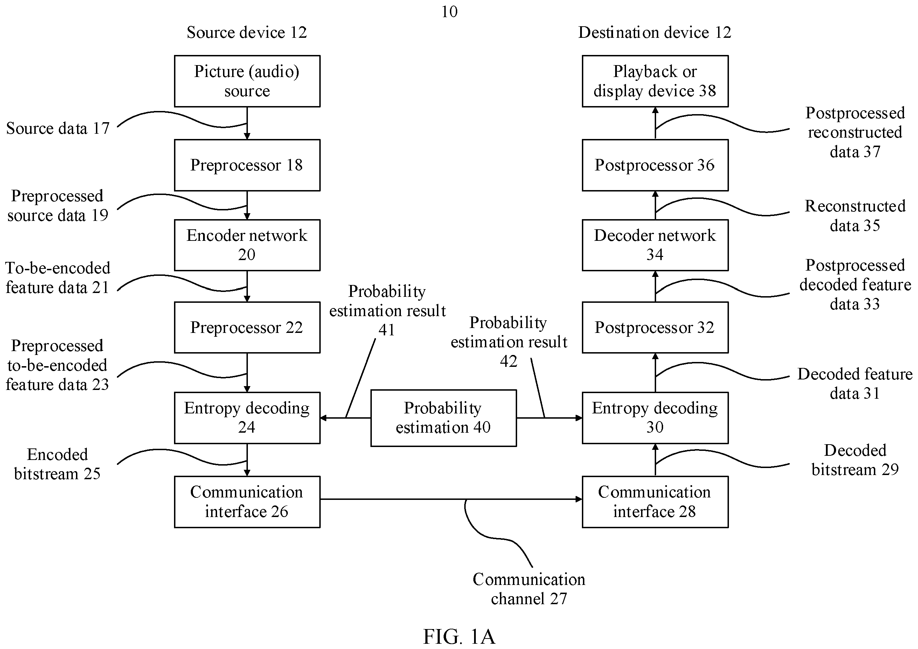

In the following embodiment of a coding system 10, an encoder 20A and a decoder 30A are described based on FIG. 1A to FIG. 15.

FIG. 1A is a schematic block diagram illustrating an example coding system 10, for example, a picture (or audio) coding system 10 (or coding system 10 for short) that may utilize techniques of this application. The encoder 20A and the decoder 30A in the picture coding system 10 represent devices and the like that may be configured to determine various technologies based on various examples described in this application.

As shown in FIG. 1A, the coding system 10 includes a source device 12 configured to provide an encoded bitstream 21, for example, an encoded picture (or audio), for a destination device 14 configured to decode the encoded bitstream 21.

The source device 12 includes the encoder 20A, and optionally includes a picture source 16, a preprocessor (or preprocessing unit) 18, a communication interface (or communication unit) 26, and probability estimation (or probability estimation unit) 40.

The picture (or audio) source 16 may include or be any type of picture capturing device configured to capture a real-world picture (or audio), and/or any type of a picture generating device, for example a computer-graphics processing unit configured to generate a computer animated picture, or any type of device configured to obtain and/or provide a real-world picture, a computer generated picture (for example, screen content, a virtual reality (virtual reality, VR) picture) and/or any combination thereof (for example, an augmented reality (augmented reality, AR) picture). The audio or picture source may be any type of memory or storage storing any foregoing audio or picture.

In distinction to the preprocessor (or preprocessing unit) 18 and processing determined by the preprocessor (or preprocessing unit) 18, a picture or audio (picture or audio data) 17 may also be referred to as an original picture or audio (original picture or audio data) 17.

The preprocessor 18 is configured to: receive the (original) picture (or audio) data 17, and perform preprocessing on the picture (or audio) data 17 to obtain a preprocessed picture or audio (or preprocessed picture or audio data) 19. For example, preprocessing determined by the preprocessor 18 may include trimming, color format conversion (for example, from RGB to YCbCr), color correction, or de-noising. It may be understood that the preprocessing unit 18 may be an optional component.

The encoder 20A includes an encoder network 20, entropy encoding 24, and optionally a preprocessor 22.

The picture (or audio) encoder network (or encoder network) 20 is configured to: receive the preprocessed picture (or audio) data 19, and provide the encoded picture (or audio) data 21.

The preprocessor 22 is configured to: receive the to-be-encoded feature data 21, and preprocess the to-be-encoded feature data 21 to obtain preprocessed to-be-encoded feature data 23. For example, preprocessing determined by the preprocessor 22 may include trimming, color format conversion (for example, from RGB to YCbCr), color correction, or de-noising. It may be understood that the preprocessing unit 22 may be an optional component.

The entropy encoding 24 is used to: receive the to-be-encoded feature data (or preprocess the to-be-encoded feature data) 23, and generate an encoded bitstream 25 based on a probability estimation result 41 provided by the probability estimation 40.

The communication interface 26 of the source device 12 may be configured to: receive the encoded bitstream 25, and transmit the encoded bitstream 25 (or any further processed version thereof) over a communication channel 27 to another device such as the destination device 14 or any other device for storage or direct reconstruction.

The destination device 14 includes the decoder 30A, and may optionally include a communication interface (or communication unit) 28, a postprocessor (or postprocessing unit) 36, and a display device 38.

The communication interface 28 of the destination device 14 is configured to: receive the encoded bitstream 25 (or any further processed version thereof) directly from the source device 12 or from any other source device such as a storage device, for example, an encoded bitstream data storage device, and provide the encoded bitstream 25 for the decoder 30A.

The communication interface 26 and the communication interface 28 may be configured to transmit or receive the encoded bitstream (or encoded bitstream data) 25 through a direct communication link between the source device 12 and the destination device 14, for example, a direct wired or wireless connection, or via any type of network, for example, a wired or wireless network or any combination thereof, or any type of private and public network, or any type of combination thereof.

The communication interface 26 may be, for example, configured to: package the encoded bitstream 25 into an appropriate format, for example, a packet, and/or process the encoded bitstream by using any type of transmission encoding or processing for transmission over a communication link or communication network.

The communication interface 28 corresponds to the communication interface 26, and for example, may be configured to: receive transmission data, and process the transmission data by using any type of corresponding transmission decoding or processing and/or decapsulation, to obtain the encoded bitstream 25.

Both the communication interface 26 and the communication interface 28 may be configured as unidirectional communication interfaces as indicated by the arrow for the communication channel 27 in FIG. 1A pointing from the source device 12 to the destination device 14, or bi-directional communication interfaces, and may be configured to: send and receive a message, to set up a connection, and acknowledge and exchange any other information related to the communication link and/or data transmission, for example, encoded picture data transmission.

The decoder 30A includes a decoder network 34, entropy decoding 30, and optionally a postprocessor 32.

The entropy decoding 30 is used to: receive the encoded bitstream 25, and provide decoded feature data 31 based on a probability estimation result 42 provided by the probability estimation 40.

The postprocessor 32 is configured to perform postprocessing on the decoded feature data 31 to obtain postprocessed decoded feature data 33. Postprocessing determined by the postprocessing unit 32 may include, for example, color format conversion (for example, from YCbCr to RGB), color correction, trimming, or resampling. It may be understood that the postprocessing unit 32 may be an optional component.

The decoder network 34 is used to: receive the decoded feature data 31 or the postprocessed decoded feature data 33, and provide reconstructed picture data 35.

The postprocessor 36 is configured to perform postprocessing on the reconstructed picture data 35 to obtain postprocessed reconstructed picture data 37. Postprocessing determined by the postprocessing unit 36 may include, for example, color format conversion (for example, from YCbCr to RGB), color correction, trimming, or resampling. It may be understood that the postprocessing unit 36 may be an optional component.

The display device 38 is configured to receive the reconstructed picture data 35 or the postprocessed picture data 37, to display a picture to a user, a viewer, or the like. The display device 38 may be or include any type of player or display for representing the reconstructed audio or picture, for example, an integrated or external display or monitor. For example, the display may include a liquid crystal display (liquid crystal display, LCD), an organic light emitting diode (organic light emitting diode, OLED) display, a plasma display, a projector, a micro LED display, a liquid crystal on silicon (liquid crystal on silicon, LCoS), a digital light processor (digital light processor, DLP), or any type of another display screen.

Although FIG. 1A shows the source device 12 and the destination device 14 as independent devices, the device embodiments may alternatively include both the source device 12 and the destination device 14, or include functions of both the source device 12 and the destination device 14, that is, including both the source device 12 or a corresponding function and the destination device 14 or a corresponding function. In these embodiments, the source device 12 or the corresponding function and the destination device 14 or the corresponding function may be implemented by using same hardware and/or software or by using separate hardware and/or software or any combination thereof.

Based on the description, existence and (accurate) division of different units or functions of the source device 12 and/or the destination device 14 shown in FIG. 1A may vary with actual devices and applications. This is obvious to a person skilled in the art.

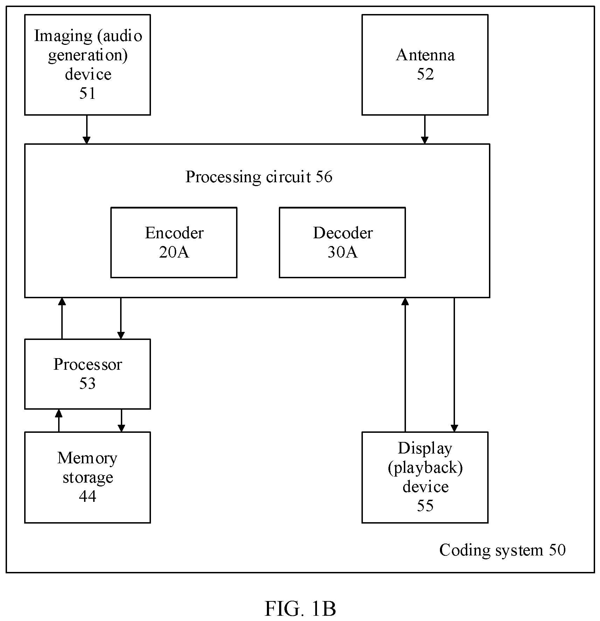

The feature data encoder 20A (for example, a picture feature map encoder or an audio feature variable encoder), the feature data decoder 30A (for example, a picture feature map decoder or an audio feature variable decoder), or both the feature data encoder 20A and the feature data decoder 30A may be implemented by using a processing circuit shown in FIG. 1B, for example, one or more microprocessors, a digital signal processor (digital signal processor, DSP), an application-specific integrated circuit (application-specific integrated circuit, ASIC), a field programmable gate array (field programmable gate array, FPGA), discrete logic, hardware, a dedicated processor for picture encoding, or any combination thereof. The feature data encoder 20A may be implemented by using the processing circuit 56, and the feature data decoder 30A may be implemented by using the processing circuit 56. The processing circuit 56 may be configured to determine various operations in the following. If the techniques are implemented partially in software, a device may store instructions for the software in a suitable, non-transitory computer-readable storage medium, and may determine the instructions in hardware by using one or more processors to determine the techniques of the present invention. As shown in FIG. 1B, one of the feature data encoder 20A and the feature data decoder 30A may be integrated into a single device as a portion of a combined encoder/decoder (encoder/decoder, CODEC).

The source device 12 and the destination device 14 may include any one of various devices, including any type of handheld device or fixed device, for example, a notebook or a laptop computer, a mobile phone, a smartphone, a tablet or a tablet computer, a camera, a desktop computer, a set-top box, a television, a display device, a digital media player, a video game console, a video stream device (for example, a content service server or a content distribution server), a broadcast receiving device, a broadcast transmitting device, and the like, and may not use or may use any type of operating system. In some cases, the source device 12 and the destination device 14 may be equipped with components for wireless communication. Therefore, the source device 12 and the destination device 14 may be wireless communication devices.

In some cases, the coding system 10 shown in FIG. 1A is merely an example. The technologies provided this application may be applicable to picture feature map or audio feature variable coding settings (for example, picture feature map encoding or picture feature map decoding), and the settings do not necessarily include any data communication between an encoding device and a decoding device. In another example, data is retrieved from a local memory, and sent over a network, and the like. A picture feature map or audio feature variable encoding device may encode the data and store the data in the memory, and/or the picture feature map or audio feature variable decoding device may retrieve the data from the memory and decode the data. In some examples, encoding and decoding are determined by devices that do not communicate with each other but encode data to the memory and/or retrieve data from the memory and decode the data.

FIG. 1B is a diagram of an example of a coding system 50 including the feature data encoder 20A in FIG. 1A and/or the feature data decoder 30A in FIG. 1B, according to an example embodiment. The coding system 50 may include an imaging (or audio generation) device 51, the encoder 20A and the decoder 30A (and/or a feature data encoder/decoder implemented by using the processing circuit 56), an antenna 52, one or more processors 53, one or more memory storages 54, and/or a display (or audio playback) device 55.

As shown in FIG. 1B, the imaging (or audio generation) device 51, the antenna 52, the processing circuit 56, the encoder 20A, the decoder 30A, the processor 53, the memory storage 54, and/or the display (or audio playback) device 55 can communicate with each other. In different examples, the coding system 50 may include only the encoder 20A or only the decoder 30A.

In some examples, the antenna 52 may be configured to transmit or receive an encoded bitstream of feature data. In addition, in some examples, the display (or audio playback) device 55 may be configured to present picture (or audio) data. The processing circuit 56 may include application-specific integrated circuit (application-specific integrated circuit, ASIC) logic, a graphics processing unit, a general-purpose processor, and the like. The coding system 50 may also include the optional processor 53. Similarly, the optional processor 53 may include application-specific integrated circuit (application-specific integrated circuit, ASIC) logic, a graphics processing unit, an audio processor, a general-purpose processor, and the like. In addition, the memory storage 54 may be any type of memory, for example, a volatile memory (for example, a static random access memory (static random access memory, SRAM), or a dynamic random access memory (dynamic random access memory, DRAM)), or a non-volatile memory (for example, a flash memory). In a non-limiting example, the memory storage 54 may be implemented by using a cache memory. In another example, the processing circuit 56 may include a memory (for example, a cache) configured to implement a picture buffer.

In some examples, the encoder 20A implemented by using a logic circuit may include a picture buffer (for example, implemented by using the processing circuit 56 or the memory storage 54) and a graphics processing unit (for example, implemented by using the processing circuit 56). The graphics processing unit may be communicatively coupled to the picture buffer. The graphics processing unit may include the encoder 20A implemented by using the processing circuit 56. The logic circuit may be configured to determine various operations in the specification.

In some examples, the decoder 30A may be implemented by using the processing circuit 56 in a similar manner, to implement the decoder 30 shown in FIG. 1B and/or various modules described with reference to any other decoder system or subsystem described in the specification. In some examples, the decoder 30A implemented by using the logic circuit may include a picture buffer (for example, implemented by using the processing circuit 56 or the memory storage 54) and a graphics processing unit (for example, implemented by using the processing circuit 56). The graphics processing unit may be communicatively coupled to the picture buffer. The graphics processing unit may include the picture decoder 30A implemented by using the processing circuit 56.

In some examples, the antenna 52 may be configured to receive an encoded bitstream of picture data. As described above, the encoded bitstream may include data, an indicator, an index value, mode selection data, and the like described in the specification, for example, data related to encoding partition, that are related to audio or video frame encoding. The coding system 50 may also include the decoder 30A that is coupled to the antenna 52 and that is configured to decode the encoded bitstream. The display (or audio playback) device 55 may be configured to present a picture (or audio).

It should be understood that, in this embodiment of this application, for the example described with reference to the encoder 20A, the decoder 30A may be configured to determine an inverse process. For a signaling syntax element, the decoder 30A may be configured to: receive and parse the syntax element, and decode related picture data correspondingly. In some examples, the encoder 20A may perform entropy encoding on the syntax element to obtain an encoded bitstream. In the example, the decoder 30A may parse the syntax element, and decode related picture data correspondingly.

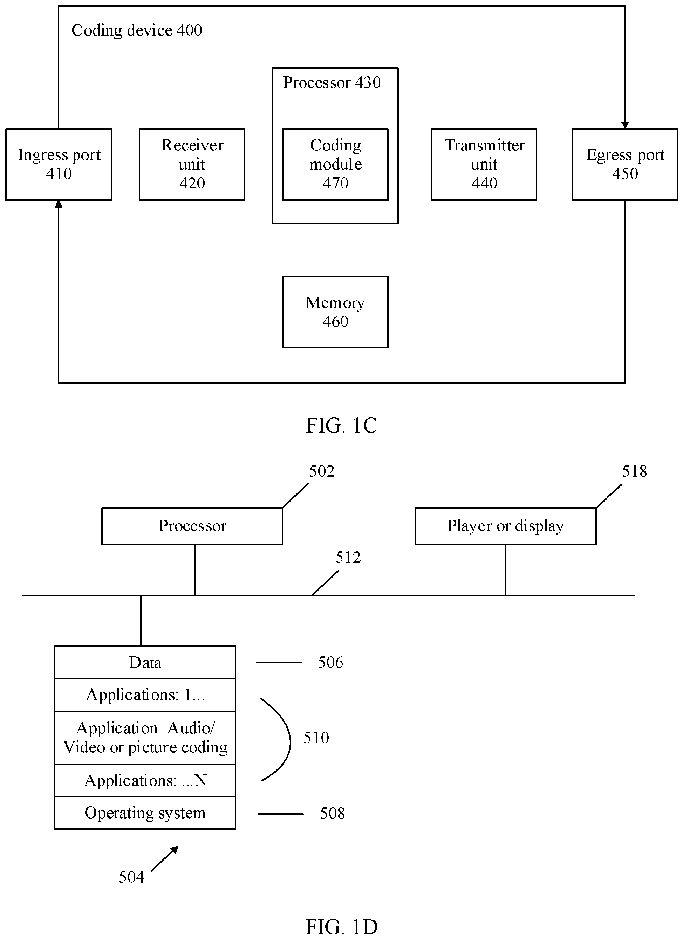

FIG. 1C is a schematic diagram of a coding device 400 according to an embodiment of the present invention. The coding device 400 is suitable for implementing the disclosed embodiments described in the specification. In an embodiment, the coding device 400 may be a decoder, for example, the picture feature map decoder 30A in FIG. 1A, or may be an encoder, for example, the picture feature map encoder 20A in FIG. 1A.

The picture coding device 400 includes an ingress port 410 (or input port 410) and a receiver unit (receiver unit, Rx) 420 that are configured to receive data; a processor, logic unit, or central processing unit (central processing unit, CPU) 430 configured to process the data, for example, the processor 430 may be a neural network processing unit 430; a transmitter unit (transmitter unit, Tx) 440 and an egress port 450 (or output port 450) that are configured to transmit the data; and a memory 460 configured to store the data. The picture (or audio) coding device 400 may further include an optical-to-electrical (optical-to-electrical, OE) component and an electrical-to-optical (electrical-to-optical, EO) component that are coupled to the ingress port 410, the receiver unit 420, the transmitter unit 440, and the egress port 450 for egress or ingress of an optical or electrical signal.

The processor 430 is implemented by hardware and software. The processor 430 may be implemented as one or more processor chips, cores (for example, multi-core processors), FPGAs, ASICs, and DSPs. The processor 430 communicates with the ingress port 410, the receiver unit 420, the transmitter unit 440, the egress port 450, and the memory 460. The processor 430 includes a coding module 470 (for example, a neural network NN-based coding module 470). The coding module 470 implements the disclosed embodiments described above. For example, the coding module 470 determines, processes, prepares, or provides various coding operations. Therefore, inclusion of the coding module 470 substantially improves a function of the coding device 400 and affects switching of the coding device 400 to a different status. Alternatively, the coding module 470 is implemented by using instructions stored in the memory 460 and determined by the processor 430.

The memory 460 includes one or more disks, tape drives, and solid-state drives and may be used as an over-flow data storage device, to store programs when such programs are selected for determining, and to store instructions and data that are read during program determining. The memory 460 may be volatile and/or non-volatile, and may be a read-only memory (read-only memory, ROM), a random access memory (random access memory, RAM), a ternary content-addressable memory (ternary content-addressable memory, TCAM), and/or a static random access memory (static random access memory, SRAM).

FIG. 1D is a simplified block diagram of an apparatus 500 that may be used as either or both of the source device 12 and the destination device 14 in FIG. 1A according to an embodiment.

A processor 502 in the apparatus 500 may be a central processing unit. Alternatively, the processor 502 may be any other type of device or a plurality of devices that can manipulate or process information and that are now-existing or hereafter developed. Although the disclosed implementations may be implemented by a single processor such as the processor 502 shown in the figure, advantages in speed and efficiency can be achieved by using more than one processor.

In an implementation, a memory 504 in the apparatus 500 can be a read only memory (ROM) device or a random access memory (RAM) device. Any other suitable type of storage device may be used as the memory 504. The memory 504 may include code and data 506 that are accessed by the processor 502 through a bus 512. The memory 504 may further include an operating system 508 and an application program 510, and the application program 510 includes at least one program that allows the processor 502 to determine the method in the specification. For example, the application program 510 may include applications 1 to N, and further include a picture coding application that determines the method in the specification.

The apparatus 500 may further include one or more output devices such as a display 518. In an example, the display 518 may be a touch sensitive display that combines a display with a touch sensitive element that may be configured to sense a touch input. The display 518 may be coupled to the processor 502 through the bus 512.

Although the bus 512 in the apparatus 500 is described as a single bus in the specification, the bus 512 may include a plurality of buses. Further, a secondary memory may be directly coupled to another component of the apparatus 500 or may be accessed via a network, and may include a single integrated unit such as a memory card or a plurality of units such as a plurality of memory cards. Therefore, the apparatus 500 may have a variety of configurations.

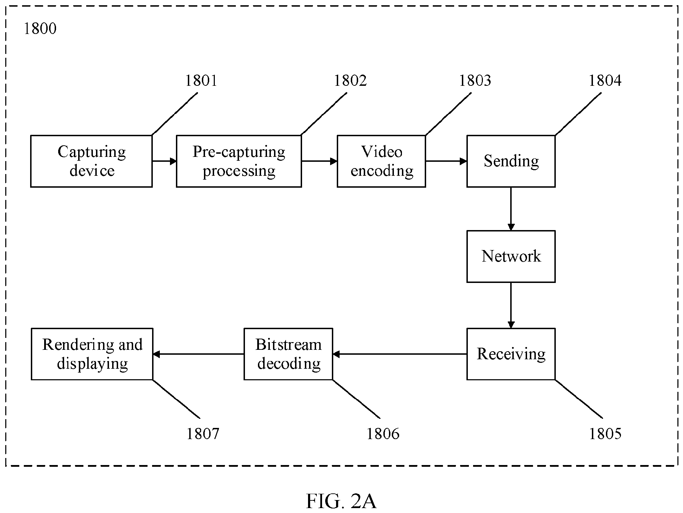

FIG. 2A shows a possible system architecture 1800 in picture feature map or audio feature variable encoding and decoding scenarios, including:

a capturing device 1801: a video capturing device completes capturing of original video (or audio);
pre-capturing processing 1802: a series of preprocessing is performed on the capturing of original video (or audio) to obtain video (or audio) data;
encoding 1803: video (or audio) encoding is used to: reduce encoding redundancy, and reduce a data transmission amount in a picture feature map or audio feature variable compression process;
sending 1804: compressed encoded bitstream data obtained through encoding is sent by using a sending module;
receiving 1805: the compressed encoded bitstream data is received by a receiving module through network transmission;
bitstream decoding 1806: bitstream decoding is performed on the bitstream data; and
rendering display (or playback) 1807: rendering display (or playback) is performed on decoded data.

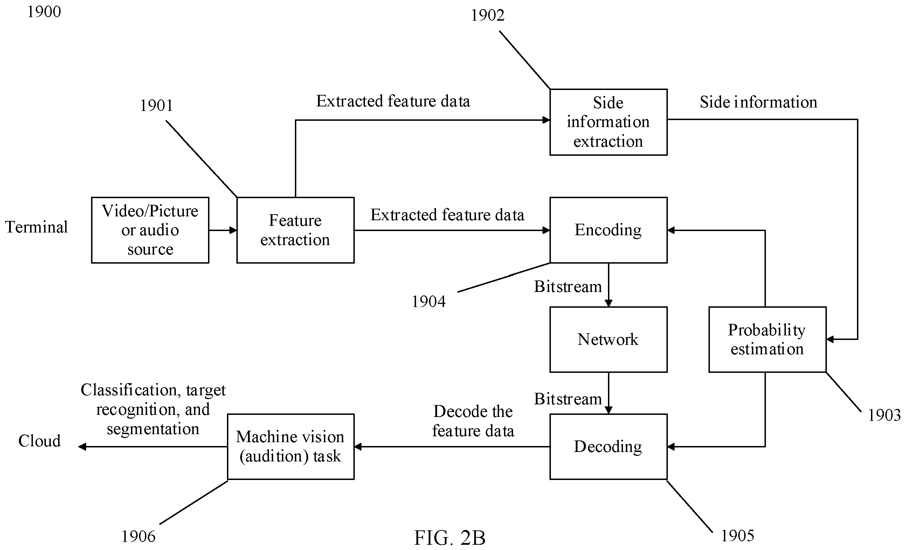

FIG. 2B shows a possible system architecture 1900 in a machine-oriented task scenario of a picture feature map (or audio feature variable), including:

feature extraction 1901: feature extraction is performed on a picture (or audio) source;
side information extraction 1902: side information extraction is performed on data obtained through feature extraction;
probability estimation 1903: the side information is used as an input of probability estimation, and probability estimation is performed on the feature map (or feature variable) to obtain a probability estimation result;
encoding 1904: entropy encoding is performed on the data obtained through feature extraction with reference to the probability estimation result to obtain a bitstream, where
optionally, before encoding is performed, a quantization or rounding operation is performed on the data obtained through feature extraction, and the quantized or rounded data obtained through feature extraction is encoded; and
optionally, entropy encoding is performed on the side information, so that the bitstream includes side information data;
decoding 1905: entropy decoding is performed on the bitstream with reference to the probability estimation result to obtain the picture feature map (or audio feature variable), where
optionally, if the bitstream includes the side information encoded data, entropy decoding is performed on the side information encoded data, and the decoded side information data is used as the input of the probability estimation to obtain the probability estimation result;

it should be noted that, when only the side information is used as the input of the probability estimation, probability estimation results of feature elements may be output in parallel, and when the input of the probability estimation includes context information, the probability estimation results of the feature elements need to be output in series; the side information is feature information further extracted by inputting the picture feature map or audio feature variable into a neural network, and a quantity of feature elements included in the side information is less than a quantity of feature elements of the picture feature map or audio feature variable; and optionally, the side information of the picture feature map or audio feature variable may be encoded into the bitstream; and

a machine vision task 1906: the machine vision (or audition) task is performed on a decoded feature map (or feature variable).

Specifically, decoded feature data is input into a machine vision (or audition) task network, and the network outputs one-dimensional, two-dimensional, or multi-dimensional data such as classification, target recognition, and semantic segmentation related to the vision (or audition) task.

In a possible implementation, in an implementation process of the system architecture 1900, feature extraction and the encoding process are implemented on a terminal, and decoding and the machine vision task are implemented on a cloud.

The encoder 20A may be configured to receive the picture (or picture data) or audio (or audio data) 17 through an input 202 or the like. The received picture, picture data, audio, and audio data may alternatively be the preprocessed picture (or preprocessed picture data) or audio (or preprocessed audio data) 19. For ease of simplicity, the following description uses the picture (or audio) 17. The picture (or audio) 17 may alternatively be referred to as a current picture or to-be-encoded picture (in particular, when the current picture is distinguished from other pictures in video encoding, for example, the other pictures are in a same video sequence, that is, include a previous encoded picture and/or decoded picture in the video sequence of the current picture), or a current audio or to-be-encoded audio.

A (digital) picture is or may be regarded as a two-dimensional array or matrix of samples with intensity values. A sample in the array may also be referred to as a pixel (pixel or pel) (a short form of a picture element). A quantity of samples in horizontal and vertical directions (or axes) of the array or picture defines a size and/or resolution of the picture. For representation of color, three color components are usually employed. To be specific, the picture may be represented as or include three sample arrays. In an RBG format or color space, a picture includes corresponding red, green and blue sample arrays. Similarly, each pixel may be represented in a luminance or chrominance format or color space, for example, YCbCr, which includes a luminance component indicated by Y (sometimes also L is used instead) and two chrominance components indicated by Cb and Cr. The luminance (luma) component Y represents brightness or gray level intensity (for example, the two are the same in a gray-scale picture), while the two chrominance (chrominance, chroma for short) components Cb and Cr represent chrominance or color information components. Correspondingly, a picture in a YCbCr format includes a luminance sample array of luminance sample values (Y), and two chrominance sample arrays of chrominance values (Cb and Cr). A picture in the RGB format may be converted or transformed into the YCbCr format and vice versa, and the process is also known as color transformation or conversion. If a picture is monochrome, the picture may include only a luminance sample array. Correspondingly, a picture may be, for example, an array of luminance samples in a monochrome format, or an array of luminance samples and two corresponding arrays of chrominance samples in 4:2:0, 4:2:2, and 4:4:4 colour formats. The picture encoder 20A does not limit color space of the picture.

In a possibility, an embodiment of the encoder 20A may include a picture (or audio) partitioning unit (not shown in FIG. 1A or FIG. 1B) configured to partition the picture (or audio) 17 into a plurality of (usually non-overlapping) picture blocks 203 or audio segments. These picture blocks may also be referred to as root blocks, macro blocks (H.264/AVC), or coding tree blocks (coding tree block, CTB) or coding tree units (coding tree unit, CTU) in the H.265/HEVC and VVC standards. The partitioning unit may be configured to: use a same block size for all pictures of a video sequence and a corresponding grid defining the block size; or change the block size between pictures, picture subsets, or groups of pictures, and partition each picture into corresponding blocks.

In another possibility, the encoder may be configured to receive directly the block 203 of the picture 17, for example, one, several or all blocks forming the picture 17. The picture block 203 may also be referred to as a current picture block or a to-be-encoded picture block.

Like the picture 17, the picture block 203 again is or may be regarded as a two-dimensional array or matrix of samples with intensity values (sample values), although of smaller dimension than the picture 17. In other words, the block 203 may include, for example, one sample array (for example, a luminance array in a case of a monochrome picture 17, or a luminance or chrominance array in a case of a color picture), three sample arrays (for example, one luminance array and two chrominance arrays in a case of a color picture 17), or any other quantity and/or type of arrays depending on a color format applied. A quantity of samples in horizontal and vertical directions (or axes) of the block 203 define a size of the block 203. Correspondingly, a block may be, for example, an array of M×N (M columns × N rows) samples or an array of M×N transform coefficients.

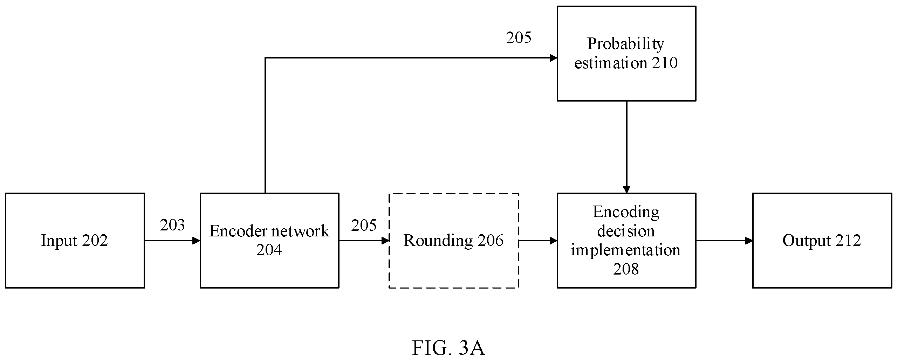

In another possibility, the encoder 20A shown in FIG. 1A and FIG. 1B or FIG. 3A to FIG. 3D is configured to encode the picture 17 block by block.

In another possibility, the encoder 20A shown in FIG. 1A and FIG. 1B or FIG. 3A to FIG. 3D is configured to encode the picture 17.

In another possibility, the encoder 20A shown in FIG. 1A and FIG. 1B or FIG. 3A to FIG. 3D may be further configured to partition or encode the picture by using a slice (also referred to as a video slice), where the picture may be partitioned into or encoded by using one or more slices (usually non-overlapping). Each slice may include one or more blocks (for example, coding tree units CTUs) or one or more groups of blocks (for example, tiles (tiles) in the H.265/HEVC/VVC standard or subpictures (subpictures) in the VVC standard).

In another possibility, the encoder 20A shown in FIG. 1A and FIG. 1B or FIG. 3A to FIG. 3D may be further configured to partition and/or encode the picture by using slices/tile groups (also referred to as video tile groups) and/or tiles (also referred to as video tiles), where the picture may be partitioned into or encoded by using one or more slices/tile groups (usually non-overlapping), and each slice/tile group may include one or more blocks (for example, CTUs) or one or more tiles. Each tile may be of a rectangular shape and may include one or more complete or fractional blocks (for example, CTUs).

Encoder network 20

The encoder network 20 is configured to obtain the picture feature map or audio feature variable based on input data and by using an encoder network.

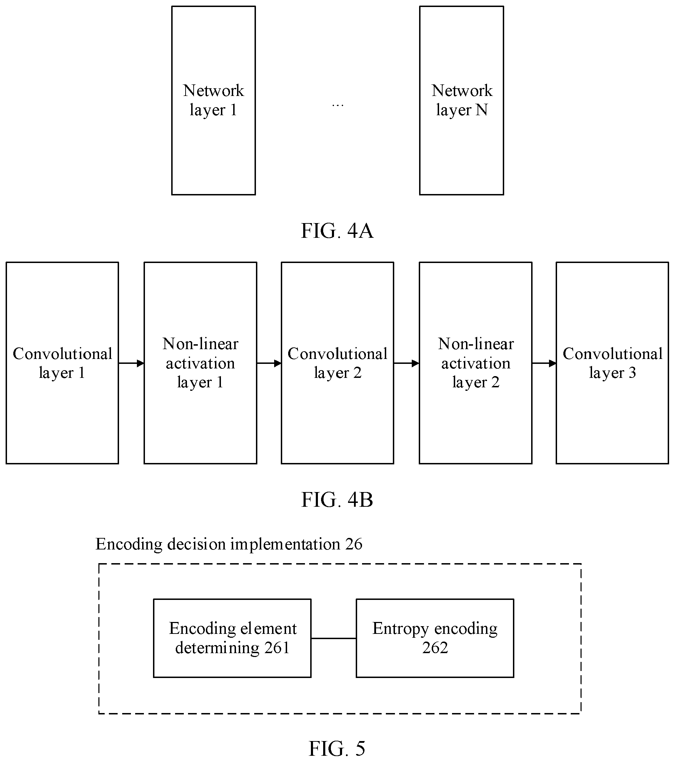

In a possibility, the encoder network 20 shown in FIG. 4A includes a plurality of network layers. Any network layer may be a convolutional layer, a normalization layer, a non-linear activation layer, or the like.

In a possibility, an input of the encoder network 20 is at least one to-be-encoded picture or at least one to-be-encoded picture block. The to-be-encoded picture may be an original picture, a lossy picture, or a residual picture.

In a possibility, an example of a network structure of the encoder network in the encoder network 20 is shown in FIG. 4B. It can be seen that in the example, the encoder network includes five network layers, and specifically includes three convolutional layers and two non-linear activation layers.

Rounding 24

The rounding is used to round the picture feature map or audio feature variable by using, for example, scalar quantization or vector quantization, to obtain the rounded picture feature map or audio feature variable.

In a possibility, the encoder 20A may be config-ured to output a quantization parameter (quantization parameter, QP), for example, directly output the quantization parameter or output the quantization parameter after the quantization parameter is encoded or compressed by an encoding decision implementation unit, so that, for example, the decoder 30A may receive and apply the quantization parameter for decoding.

In a possibility, the output feature map or feature audio feature variable is preprocessed before rounding, and the preprocessing may include trimming, color format conversion (for example, from RGB to YCbCr), color correction, de-noising, or the like.

Probability estimation 40

The probability estimation result of the picture feature map or audio feature variable is obtained through probability estimation and based on input feature map or feature variable information.

The probability estimation is used to perform probability estimation on the rounded picture feature map or audio feature variable.

The probability estimation may be a probability estimation network, the probability estimation network is a convolutional network, and the convolutional network includes a convolutional layer and a non-linear activation layer. FIG. 4B is used as an example. The probability estimation network includes five network layers, and specifically includes three convolutional layers and two non-linear activation layers. The probability estimation can be realized by using a conventional non-network probability estimation method. Probability estimation methods include but are not limited to equal maximum likelihood estimation, maximum posteriori estimation, maximum likelihood estimation, and another statistical method.

Encoding decision implementation 26

As shown in FIG. 5, the encoding decision implementation includes encoding element determining and entropy encoding. The picture feature map or audio feature variable is one-dimensional, two-dimensional, or multi-dimensional data output by the encoder network, where each piece of data is a feature element. Encoding element determining 261

The encoding element determining is determining each feature element of the picture feature map or audio feature variable based on probability estimation result information of the probability estimation, and determining, based on the determining result, specific feature elements on which entropy encoding is performed.

After an element determining process of a $P^{th}$ feature element of the picture feature map or audio feature variable is completed, an element determining process of a $(P+1)^{th}$ feature element of the picture feature map is started, where P is a positive integer and P is less than M.

Entropy encoding 262

The entropy encoding may use various disclosed entropy encoding algorithms to perform entropy encoding, for example, a variable length coding (variable length coding, VLC) scheme, a context adaptive VLC (context adaptive VLC, CAVLC) scheme, an entropy encoding scheme, a binarization algorithm, a context adaptive binary entropy encoding (context adaptive binary arithmetic coding, CABAC), syntax-based context-adaptive binary entropy encoding (syntax-based context-adaptive binary arithmetic coding, SBAC), probability interval partitioning entropy (probability interval partitioning entropy, PIPE) encoding, or another entropy encoding method or technology. Encoded picture data 25 that may be output in a form of an encoded bitstream 25 or the like through an output 212 is obtained, so that the decoder 30A or the like may receive and use the parameter for decoding. The encoded bitstream 25 may be transmitted to the decoder 30A, or stored in a memory for subsequent transmission or retrieval by the decoder 30A.

In another possibility, the entropy encoding may perform encoding by using an entropy encoding network, for example, implemented by using a convolutional network.

In a possibility, because the entropy encoding does not know a real character probability of the rounded feature map, the real character probability of the rounded feature map or related information may be collected and added to the entropy encoding, and the information is transmitted to a decoder side.

Joint network 44

The joint network obtains the probability estimation result and decision information of the picture feature map or audio feature variable based on the input side information. The joint network is a multi-layer network, the joint network may be a convolutional network, and the convolutional network includes a convolutional layer and a non-linear activation layer. Any network layer of the joint network may be a convolutional layer, a normalization layer, a non-linear activation layer, or the like.

The decision information may be one-dimensional, two-dimensional, or multi-dimensional data, and a size of the decision information may be consistent with that of the picture feature map.

The decision information may be output after any network layer of the joint network.

The probability estimation result may be output after any network layer of the joint network.

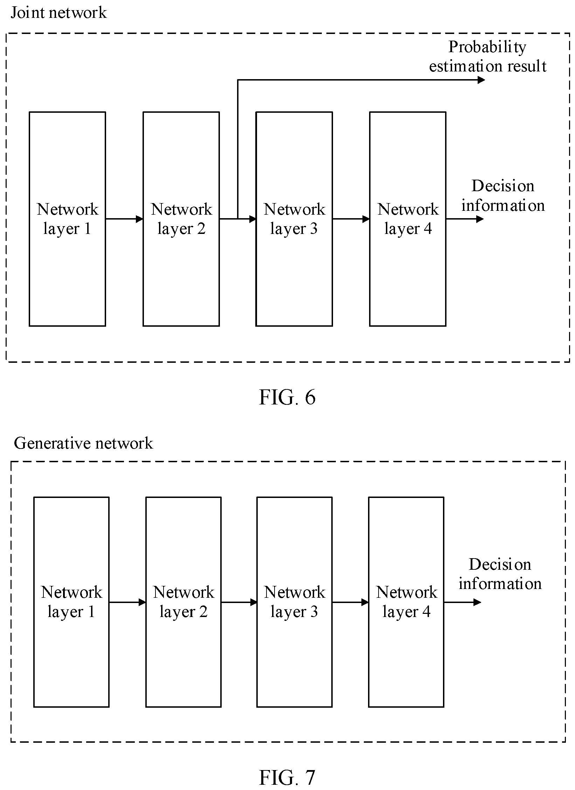

FIG. 6 is an output example of a network structure of a joint network. The network structure includes four network layers. The decision information is output after a fourth network layer, and the probability estimation result is output after a second network layer.

Generative network 46

The generative network obtains the decision information of the feature elements of the picture feature map based on the input probability estimation result. The generative network is a multi-layer network, the generative network may be a convolutional network, and the convolutional network includes a convolutional layer and a non-linear activation layer. Any network layer of the generative network may be a convolutional layer, a normalization layer, a non-linear activation layer, or the like.

The decision information may be output after any network layer of the generative network. The decision information may be one-dimensional, two-dimensional, or multi-dimensional data.

FIG. 7 is an example of outputting decision information by a network structure of a generative network. The network structure includes four network layers.

Decoding decision implementation 30

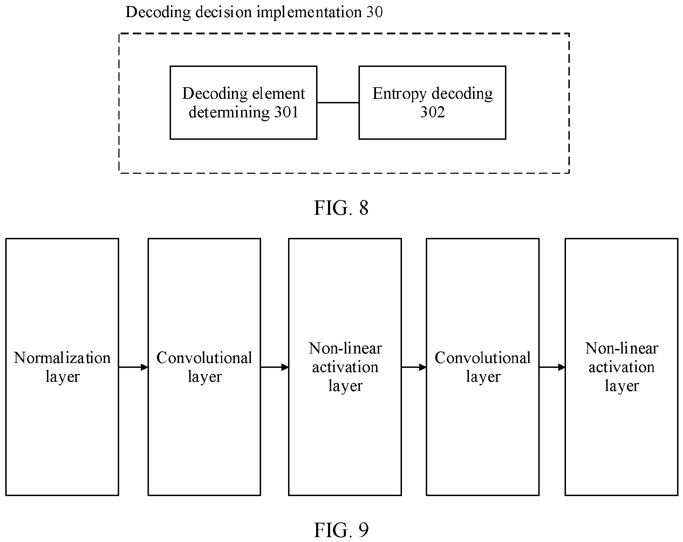

As shown in FIG. 8, the decoding decision implementation includes element determining and entropy decoding. The picture feature map or audio feature variable is one-dimensional, two-dimensional, or multi-dimensional data output by the decoding decision implementation, where each piece of data is a feature element.

Decoding element determining 301

The decoding element determining is determining each feature element of the picture feature map or audio feature variable based on the probability estimation result of the probability estimation, and determining, based on the determining result, specific feature elements on which entropy decoding is performed. The decoding element determining determines each feature element of the picture feature map or audio feature variable, and determines, based on the determining result, the specific feature elements on which entropy decoding is performed. It may be considered as an inverse process of determining, by the encoding element determining, each feature element of the picture feature map, and determining, based on the determining result, the specific feature elements on which entropy encoding is performed.

Entropy decoding 302

The entropy decoding may use various disclosed entropy decoding algorithms to perform entropy decoding, for example, a variable length coding (variable length coding, VLC) scheme, a context adaptive VLC (context adaptive VLC, CAVLC) scheme, an entropy decoding scheme, a binarization algorithm, a context adaptive binary entropy decoding (context adaptive binary arithmetic coding, CABAC), syntax-based context-adaptive binary entropy decoding (syntax-based context-adaptive binary arithmetic coding, SBAC), probability interval partitioning entropy (probability interval partitioning entropy, PIPE) encoding, or another entropy encoding method or technology. The encoded picture (or audio) data 25 that may be output in the form of the encoded bitstream 25 or the like through the output 212 is obtained, so that the decoder 30A or the like may receive and use the parameter for decoding. The encoded bitstream 25 may be transmitted to the decoder 30A, or stored in the memory for subsequent transmission or retrieval by the decoder 30A.

In another possibility, the entropy decoding may perform decoding by using an entropy decoding network, for example, implemented by using a convolutional network.

Decoder network 34

The decoder network is used to pass the decoded picture feature map or audio feature variable 31 or the postprocessed decoded picture feature map or audio feature variable 33 through the decoder network 34 to obtain the reconstructed picture (or audio) data 35 or machine-oriented task data in a pixel domain.

The decoder network includes a plurality of network layers. Any network layer may be a convolutional layer, a normalization layer, a non-linear activation layer, or the like. Operations such as superposition (concat), addition, and subtraction may exist in a decoder network unit 306.

In a possibility, structures of the network layers of the decoder network may be the same as or different from each other.

An example of a structure of the decoder network is shown in FIG. 9. It can be seen that in the example, the decoder network includes five network layers, and specifically includes one normalization layer, two convolutional layer, and two non-linear activation layers.

The decoder network outputs the reconstructed picture (or audio), or outputs the obtained machine-oriented task data. Specifically, the decoder network may include a target recognition network, a classification network, or a semantic segmentation network.

It should be understood that, in the encoder 20A and the decoder 30A, a processing result of a current step may be further processed and then output to a next step. For example, after an encoder unit or decoder unit, further operations or processing, for example, a clip (clip) or shift (shift) operation or filtering processing, may be performed on a processing result of the encoder unit or decoder unit.

Based on the foregoing description, the following provides some picture feature map or audio feature variable encoding and decoding methods according to embodiments of this application. For ease of description, the method embodiments described below are expressed as a combination of a series of action steps. However, a person skilled in the art should understand that specific implementations of the technical solutions of this application are not limited to a sequence of the described series of action steps.

The following describes in detail procedures of this application with reference to accompanying drawings. It should be noted that a process on an encoder side in a flowchart may be specifically executed by the encoder 20A, and a process on a decoder side in the flowchart may be specifically executed by the decoder 30A.

In Embodiment 1 to Embodiment 5, a first feature element or a second feature element is a current to-be-encoded feature element or a current to-be-decoded feature element, for example, $\hat{y}[x][y][i]$. The decision map may also be referred to as a decision map. The decision map is preferably a binary map, and the binary map may also be referred to as a binary map.

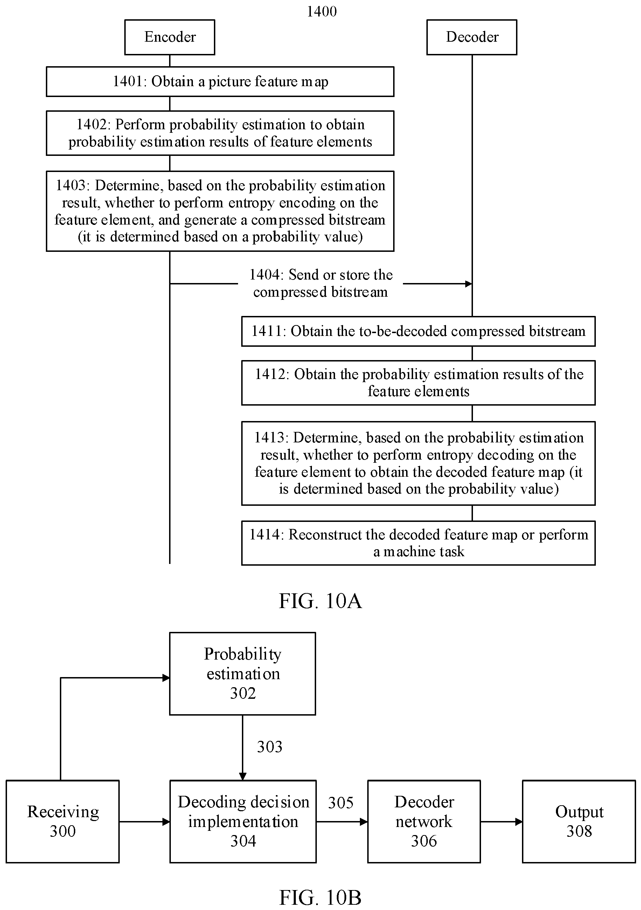

In Embodiment 1 of this application, FIG. 10A shows a specific implementation process 1400. Running steps are as follows.

Encoder side:

Step 1401: Obtain a picture feature map.

This step is specifically implemented by an encoder network 204 in FIG. 3A. For details, refer to the foregoing description of the encoder network 20. A picture is input into a feature extraction module to output the picture feature map $y$, and the feature map y may be three-dimensional data whose dimensions are w, x, h, x, and c. Specifically, the feature extraction module may be implemented by using an existing neural network. This is not limited herein. This step is the existing technology.

A feature quantization module quantizes each feature value of the feature map $y$, rounds feature values of floating-point numbers to obtain integer feature values through rounding, and obtains the quantized feature map $\hat{y}$. Refer to the description of the rounding 24 in the foregoing embodiment.

Step 1402: Perform probability estimation on the feature map $\hat{y}$ to obtain probability estimation results of feature elements, that is, probability distribution of each feature element $\hat{y}[x][y][i]$ of the feature map $\hat{y}$.

Parameters x, y, and i are positive integers, and coordinates (x, y, i) indicate a location of a current to-be-encoded feature element. Specifically, the coordinates (x, y, i) indicate the location of the current to-be-encoded feature element that is of the current three-dimensional feature map and that is relative to a feature element of the upper left vertex. This step is specifically implemented by probability estimation 210 in FIG. 3A. For details, refer to the foregoing description of the probability estimation 40. Specifically, a probability distribution model may be used to obtain the probability distribution. For example, a Gaussian single model (Gaussian single model, GSM) or a Gaussian mixture model (Gaussian mix model, GMM) is used for modeling. First, side information $\hat{z}$ and context information are input into a probability estimation network. Probability estimation is performed on each feature element $\hat{y}[x][y][i]$ of the feature map $\hat{y}$ to obtain the probability distribution of the feature elements $\hat{y}[x][y][i]$. The probability estimation network may use a deep learning-based network, for example, a recurrent neural network (recurrent neural network, RNN) and a convolutional neural network (convolutional neural network, CNN). This is not limited herein. The probability distribution is obtained by substituting a model parameter into the probability distribution model.

Step 1403: Perform entropy encoding on the feature map $\hat{y}$ to obtain a compressed bitstream, and generate the compressed bitstream.

This step is specifically implemented by encoding decision implementation 208 in FIG. 3A. For details, refer to the foregoing description of the encoding decision implementation 26. A probability P that a value of the current to-be-encoded feature element $\hat{y}[x][y][i]$ is k is obtained based on the probability distribution. When the probability estimation result P of the current to-be-encoded feature element $\hat{y}[x][y][i]$ does not meet a preset condition: P is greater than (or equal to) a first threshold T0, performing the entropy encoding process on the current to-be-encoded feature element is skipped. Otherwise, when the probability estimation result P of the current to-be-encoded feature element meets a preset condition: P is less than a first threshold T0, entropy encoding is performed on the current to-be-encoded feature element and the current to-be-encoded feature element is written into the bitstream. k may be any integer, for example, 0, 1, -1, 2, or 3. The first threshold T0 is any number that meets $0 < T0 < 1$, for example, a value is 0.99, 0.98, 0.97, 0.95, or the like (a threshold of each feature element may be considered to be the same).

Step 1404: An encoder sends or stores the compressed bitstream.

Decoder side:

Step 1411: Obtain the bitstream of the decoded picture feature map.

Step 1412: Perform probability estimation based on the bitstream to obtain the probability estimation results of the feature elements.

This step is specifically implemented by probability estimation 302 in FIG. 10B. For details, refer to the foregoing description of the probability estimation 40. Probability estimation is performed on each feature element $\hat{y}[x][y][i]$ of the to-be-decoded feature map $\hat{y}$ to obtain probability distribution of the to-be-decoded feature element $\hat{y}[x][y][i]$. The to-be-decoded feature map $\hat{y}$ includes a plurality of feature elements, and the plurality of feature elements include the current to-be-decoded feature element.

A diagram of a structure of a probability estimation network used by the decoder side is the same as that of the probability estimation network of the encoder side in this embodiment.

Step 1413: Perform entropy decoding on the to-be-decoded feature map $\hat{y}$.

This step is specifically implemented by decoding decision implementation 304 in FIG. 10B. For details, refer to the foregoing description of the decoding decision implementation 30. A probability P, that is, a probability estimation result P of the current to-be-decoded feature element, that a value of the current to-be-decoded feature element is k is obtained based on the probability distribution of the current to-be-decoded feature element. When the probability estimation result P does not meet a preset condition: P is greater than the first threshold T0, entropy decoding does not need to be performed on the current to-be-decoded feature element, and the value of the current to-be-decoded feature element is set to k. Otherwise, when the current to-be-decoded feature element meets a preset condition: P is less than or equal to the first threshold T0, entropy decoding is performed on the bitstream, and the value of the current to-be-decoded feature element is obtained.

An index number may be obtained from the bitstream by parsing the bitstream and based on the first threshold T0. The decoder side constructs a threshold candidate list in the same manner as the encoder, and then obtains a corresponding threshold according to a correspondence between a threshold and an index number that are in a preset threshold candidate list. The index number is obtained from the bitstream, in other words, the index number is obtained from a sequence header, a picture header, a slice/slice header, or SEI.

Alternatively, the bitstream may be directly parsed, and the threshold is obtained from the bitstream. Specifically, the threshold is obtained from the sequence header, the picture header, the slice/slice header, or the SEI.

Alternatively, a fixed threshold is directly set according to a threshold policy agreed with decoding.

Step 1414: Reconstruct the decoded feature map $\hat{y}$, or perform a corresponding machine task by inputting the decoded feature map into a machine-oriented vision task module to perform a corresponding machine task. This step may be specifically implemented by a decoder network 306 in FIG. 10B. For details, refer to the foregoing description of the decoder network 34.

Case 1: The feature map $\hat{y}$ obtained through entropy decoding is input into a picture reconstruction module, and a neural network outputs the reconstructed map. The neural network may use any structure, for example, a fully-connected network, a convolutional neural network, or a recurrent neural network. The neural network may use a multi-layer structure deep neural network structure to achieve better estimation effect.

Case 2: The feature map $\hat{y}$ obtained through entropy decoding is input into the machine-oriented vision task module to perform the corresponding machine task. For example, machine vision tasks such as object classification, recognition, and segmentation are completed.

The value k of the foregoing decoder side is set correspondingly to the value k of the encoder side.

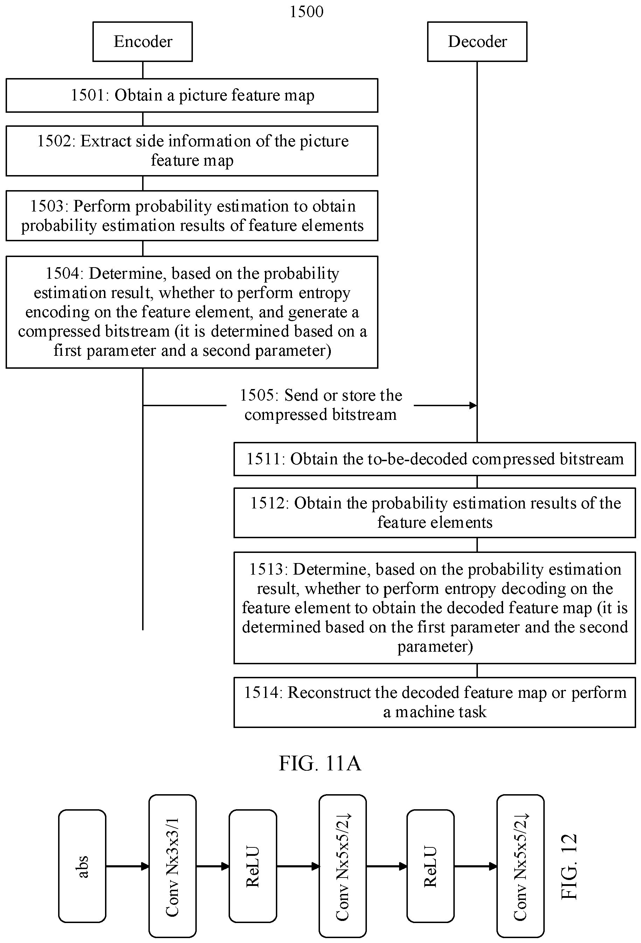

FIG. 11A shows a specific implementation process 1500 according to Embodiment 2 of this application. Running steps are as follows.

It should be noted that in a method 1 to a method 6 in this embodiment, a probability estimation result includes a first parameter and a second parameter. When probability distribution is Gaussian distribution, the first parameter is a mean value $\mu$, and the second parameter is a variance $\sigma$. When the probability distribution is Laplace distribution, the first parameter is a location parameter $\mu$, and the second parameter is a scale parameter b.

Encoder side:

Step 1501: Obtain a picture feature map.

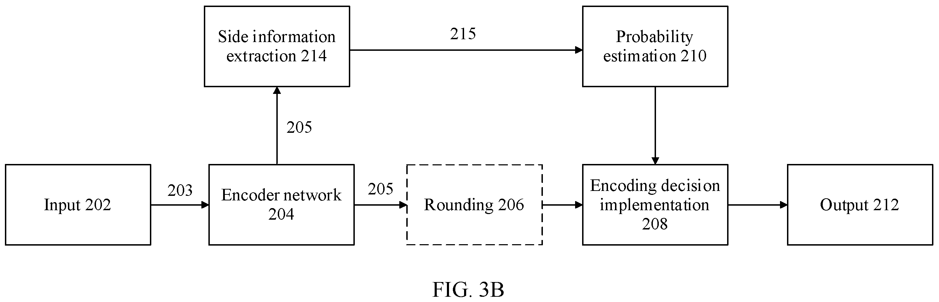

This step is specifically implemented by the encoder network 204 in FIG. 3B. For details, refer to the foregoing description of the encoder network 20. A picture is input into a feature extraction module to output the picture feature map $y$, and the feature map $y$ may be three-dimensional data whose dimensions are w, x, h, x, and c. Specifically, the feature extraction module may be implemented by using an existing neural network. This is not limited herein. This step is the existing technology.

A feature quantization module quantizes each feature value of the feature map $y$, rounds feature values of floating-point numbers to obtain integer feature values, and obtains the quantized feature map $\hat{y}$.

Step 1502: The picture feature map $\hat{y}$ is input into a side information extraction module, and side information $\hat{z}$ is output.

This step is specifically implemented by a side information extraction unit 214 in FIG. 3B. The side information extraction module may be implemented by using a network shown in FIG. 12. The side information $\hat{z}$ may be understood as a feature map $\hat{z}$ obtained by further extracting the feature map $\hat{y}$, and a quantity of feature elements included in $\hat{z}$ is less than that of the feature map $\hat{y}$.

It should be noted that entropy encoding may be performed on the side information $\hat{z}$ and the side information $\hat{z}$ is written into a bitstream in this step, or entropy encoding may be performed on the side information $\hat{z}$ and the side information $\hat{z}$ is written into the bitstream in subsequent step 1504. This is not limited herein.

Step 1503: Perform probability estimation on the feature map $\hat{y}$ to obtain probability estimation results of feature elements.

This step is specifically implemented by the probability estimation 210 in FIG. 3B. For details, refer to the foregoing description of the probability estimation 40. A probability distribution model may be used to obtain the probability estimation result and the probability distribution. The probability distribution model may be: a Gaussian single model (Gaussian single model, GSM), an asymmetric Gaussian model, a Gaussian mixture model (Gaussian mix model, GMM), or a Laplace distribution (Laplace distribution) model.

When the probability distribution model is the Gaussian model (the Gaussian single model, the asymmetric Gaussian model, or the Gaussian mixture model), first, the side information $\hat{z}$ or context information is input into a probability estimation network, and probability estimation is performed on each feature element $\hat{y}[x][y][i]$ of the feature map $\hat{y}$ to obtain values of the mean value parameter $\mu$ and the variance $\sigma$. Further, the mean value parameter $\mu$ and the variance $\sigma$ are input into the used probability distribution model to obtain the probability distribution. In this case, the probability estimation result includes the mean value parameter $\mu$ and the variance $\sigma$.

When the probability distribution model is the Laplace distribution model, first, the side information $\hat{z}$ or context information is input into a probability estimation network, and probability estimation is performed on each feature element $\hat{y}[x][y][i]$ of the feature map $\hat{y}$ to obtain values of the location parameter $\mu$ and the scale parameter b. Further, the location parameter $\mu$ and the scale parameter b are input into the used probability distribution model to obtain the probability distribution. In this case, the probability estimation result includes the location parameter $\mu$ and the scale parameter b.

Alternatively, the side information $\hat{z}$ and/or context information may be input into the probability estimation network, and probability estimation is performed on each feature element $\hat{y}[x][y][i]$ of the to-be-encoded feature map $\hat{y}$ to obtain probability distribution of the current to-be-encoded feature element $\hat{y}[x][y][i]$. A probability P that a value of the current to-be-encoded feature element $\hat{y}[x][y][i]$ is m is obtained based on the probability distribution. In this case, the probability estimation result is the probability P that the value of the current to-be-encoded feature element $\hat{y}[x][y][i]$ is m.

The probability estimation network may use a deep learning-based network, for example, a recurrent neural network (recurrent neural network, RNN) and a convolutional neural network (convolutional neural network, CNN). This is not limited herein.

Step 1504: Determine, based on the probability estimation result, whether entropy encoding needs to be performed on the current to-be-encoded feature element $\hat{y}[x][y][i]$; and perform, based on a determining result, entropy encoding and write the current to-be-encoded feature element $\hat{y}[x][y][i]$ into the compressed bitstream (encoded bitstream), or skip performing entropy encoding. Entropy encoding is performed on the current to-be-encoded feature element only when it is determined that entropy encoding needs to be performed on the current to-be-encoded first feature element.

This step is specifically implemented by the encoding decision implementation 208 in FIG. 3B. For details, refer to the foregoing description of the encoding decision implementation 26. One or more of the following methods may be used to determine, based on the probability estimation result, whether entropy encoding needs to be performed on the current to-be-encoded feature element $\hat{y}[x][y][i]$. Parameters x, y, and i are positive integers, and coordinates (x, y, i) indicate a location of the current to-be-encoded feature element. Specifically, the coordinates (x, y, i) indicate the location of the current to-be-encoded feature element that is of the current three-dimensional feature map and that is relative to a feature element of the upper left vertex.

Method 1: When the probability distribution model is the Gaussian distribution, whether to perform entropy encoding on the current to-be-encoded feature element is determined based on the probability estimation result of the first feature element. When the values of the mean value parameter $\mu$ and the variance $\sigma$ that are of the Gaussian distribution of the current to-be-encoded feature element do not meet a preset condition: an absolute value of a difference between the mean value $\mu$ and k is less than a second threshold T1, and the variance $\sigma$ is less than a third threshold T2, the entropy encoding process does not need to be performed on the current to-be-encoded feature element $\hat{y}[x][y][i]$. Otherwise, when a preset condition is met: when an absolute value of a difference between the mean value $\mu$ and k is greater than or equal to a second threshold T1, or the variance $\sigma$ is less than a third threshold T2, entropy encoding is performed on the current to-be-encoded feature element $\hat{y}[x][y][i]$ and the current to-be-encoded feature element $\hat{y}[x][y][i]$ is written into the bitstream. k is any integer, for example, 0, 1, -1, 2, or 3. A value of T2 is any number that meets 0<T2<1, for example, a value of 0.2, 0.3, 0.4, or the like. T1 is a number greater than or equal to 0 and less than 1, for example, 0.01, 0.02, 0.001, and 0.002.

In particular, when a value of k is 0, it is an optimal value. It may be directly determined that when an absolute value of the mean value parameter $\mu$ of the Gaussian distribution is less than T1, and the variance $\sigma$ of the Gaussian distribution is less than T2, performing the entropy encoding process on the current to-be-encoded feature element $\hat{y}[x][y][i]$ is skipped. Otherwise, entropy encoding is performed on the current to-be-encoded feature element $\hat{y}[x][y][i]$ and the current to-be-encoded feature element $\hat{y}[x][y][i]$ is written into the bitstream. The value of T2 is any number that meets 0<T2<1, for example, a value of 0.2, 0.3, 0.4, or the like. T1 is a number greater than or equal to 0 and less than 1, for example, 0.01, 0.02, 0.001, and 0.002.

Method 2: When the probability distribution is the Gaussian distribution, the values of the mean value parameter $\mu$ and the variance $\sigma$ of the Gaussian distribution of the current to-be-encoded feature element $\hat{y}[x][y][i]$ are obtained based on the probability estimation result. When a relationship between the mean value $\mu$, the variance $\sigma$, and k meets abs($\mu$ - k) + $\sigma$ < T3 (a preset condition is not met), performing the entropy encoding process on the current to-be-encoded feature element $\hat{y}[x][y][i]$ is skipped, where abs($\mu$-k) represents calculating an absolute value of a difference between the mean

value $\mu$ and k. Otherwise, when the probability estimation result of the current to-be-encoded feature element meets abs($\mu$ - k) + $\sigma$ ≥ T3 (a preset condition), entropy encoding is performed on the current to-be-encoded feature element $\hat{y}[x][y][i]$ and the current to-be-encoded feature element $\hat{y}[x][y][i]$ is written into the bitstream. k is any integer, for example, 0, 1, -1, -2, or 3. A fourth threshold T3 is a number greater than or equal to 0 and less than 1, for example, a value is 0.2, 0.3, 0.4, or the like.

Method 3: When the probability distribution is the Laplace distribution, the values of the location parameter $\mu$ and the scale parameter b that are of the Laplace distribution of the current to-be-encoded feature element $\hat{y}[x][y][i]$ are obtained based on the probability estimation result. When a relationship between the location parameter $\mu$, the scale parameter b, and k meets abs($\mu$ - k) + $\sigma$ < T4 (a preset condition is not met), performing the entropy encoding process on the current to-be-encoded feature element $\hat{y}[x][y][i]$ is skipped, where abs($\mu$-k) represents calculating an absolute value of a difference between the location parameter $\mu$ and k. Otherwise, when the probability estimation result of the current to-be-encoded feature element meets abs($\mu$ - k) + $\sigma$ ≥ T4 (a preset condition), entropy encoding is performed on the current to-be-encoded feature element $\hat{y}[x][y][i]$ and the current to-be-encoded feature element $\hat{y}[x][y][i]$ is written into the bitstream. k is any integer, for example, 0, 1, -1, -2, or 3. A fourth threshold T4 is a number greater than or equal to 0 and less than 0.5, for example, a value is 0.05, 0.09, 0.17, or the like.

Method 4: When the probability distribution is the Laplace distribution, the values of the location parameter $\mu$ and the scale parameter b that are of the Laplace distribution of the current to-be-encoded feature element $\hat{y}[x][y][i]$ are obtained based on the probability estimation result. When an absolute value of a difference between the location parameter $\mu$ and k is less than a second threshold T5, and the scale parameter b is less than a third threshold T6 (a preset condition is not met), performing the entropy encoding process on the current to-be-encoded feature element y[x][y][i] is skipped. Otherwise, when an absolute value of a difference between the location parameter $\mu$ and k is less than a second threshold T5, or the scale parameter b is greater than or equal to a third threshold T6 (a preset condition), entropy encoding is performed on the current to-be-encoded feature element $\hat{y}[x][y][i]$ and the current to-be-encoded feature element $\hat{y}[x][y][i]$ is written into the bitstream. k is any integer, for example, 0, 1, -1, -2, or 3. A value of T5 is 1e-2, and a value of T6 is any number that meets T6<0.5, for example, a value of 0.05, 0.09, 0.17, or the like.

In particular, when a value of k is 0, it is an optimal value. It may be directly determined that when an absolute value of the location parameter $\mu$ is less than T5, and the scale parameter b is less than T6, performing the entropy encoding process on the current to-be-encoded feature element $\hat{y}[x][y][i]$ is skipped. Otherwise, entropy encoding is performed on the current to-be-en-

coded feature element $\hat{y}[x][y][i]$ and the current to-be-encoded feature element $\hat{y}[x][y][i]$ is written into the bitstream. The value of the threshold T5 is 1e-2, and the value of T2 is any number that meets T6<0.5, for example, a value of 0.05, 0.09, 0.17, or the like.

Method 5: When the probability distribution is Gaussian mixture distribution, values of all mean value parameters $\mu_i$ and variances $\sigma_i$ that are of the Gaussian mixture distribution of the current to-be-encoded feature element $\hat{y}[x][y][i]$ are obtained based on the probability estimation result. When a sum of any variance of the Gaussian mixture distribution and a sum of absolute values of differences between all the mean values of the Gaussian mixture distribution and k is less than a fifth threshold T7 (a preset condition is not met), performing the entropy encoding process on the current to-be-encoded feature element $\hat{y}[x][y][i]$ is skipped. Otherwise, when a sum of any variance of the Gaussian mixture distribution and a sum of absolute values of differences between all the mean values of the Gaussian mixture distribution and k is greater than or equal to a fifth threshold T7 (a preset condition), entropy encoding is performed on the current to-be-encoded feature element $\hat{y}[x][y][i]$ and the current to-be-encoded feature element $\hat{y}[x][y][i]$ is written into the bitstream. k is any integer, for example, 0, 1, -1, -2, or 3. T7 is a number greater than or equal to 0 and less than 1, for example, a value is 0.2, 0.3, 0.4, or the like (a threshold of each feature element may be considered to be the same).

Method 6: A probability P that a value of the current to-be-encoded feature element $\hat{y}[x][y][i]$ is k is obtained based on the probability distribution. When the probability estimation result P of the current to-be-encoded feature element does not meet a preset condition: P is greater than (or equal to) a first threshold T0, performing the entropy encoding process on the current to-be-encoded feature element is skipped. Otherwise, when the probability estimation result P of the current to-be-encoded feature element meets a preset condition: P is less than a first threshold T0, entropy encoding is performed on the current to-be-encoded feature element and the current to-be-encoded feature element is written into the bitstream. k may be any integer, for example, 0, 1, -1, 2, or 3. The first threshold T0 is any number that meets $0 < T0 < 1$, for example, a value is 0.99, 0.98, 0.97, 0.95, or the like (a threshold of each feature element may be considered to be the same).

It should be noted that, in actual application, to ensure platform consistency, the thresholds T1, T2, T3, T4, T5, and T6 may be rounded, that is, shifted and scaled to integers.

It should be noted that, a method for obtaining the threshold may alternatively use one of the following methods. This is not limited herein.

Method 1: The threshold T1 is used as an example, any value within a value range of T1 is used as the threshold T1, and the threshold T1 is written into the bitstream. Specifically, the threshold is written into the bitstream, and may be stored in a sequence header, a picture header, a slice/slice header, or SEI, and transmitted to a decoder side. Alternatively, another method may be used. This is not limited herein. A similar method may also be used for the remaining thresholds T0, T2, T3, T4, T5, and T6.

Method 2: The encoder side uses a fixed threshold agreed with a decoder side. The fixed threshold does not need to be written into the bitstream, and does not need to be transmitted to the decoder side. For example, the threshold T1 is used as an example, and any value within a value range of T1 is directly used as a value of T1. A similar method may also be used for the remaining thresholds T0, T2, T3, T4, T5, and T6.

Method 3: A threshold candidate list is constructed, and a most possible value within a value range of T1 is put into the threshold candidate list. Each threshold corresponds to a threshold index number, an optimal threshold is determined, and the optimal threshold is used as a value of T1. The index number of the optimal threshold is used as the threshold index number of T1, and the threshold index number of T1 is written into the bitstream. Specifically, the threshold is written into the bitstream, and may be stored in a sequence header, a picture header, a slice/slice header, or SEI, and transmitted to a decoder side. Alternatively, another method may be used. This is not limited herein. A similar method may also be used for the remaining thresholds T0, T2, T3, T4, T5, and T6.

Step 1505: An encoder sends or stores the compressed bitstream.

Decoder side:

Step 1511: Obtain the bitstream of the to-be-decoded picture feature map.

Step 1512: Obtain the probability estimation results of the feature elements.

This step is specifically implemented by the probability estimation unit 302 in FIG. 11A. For details, refer to the foregoing description of the probability estimation 40. Entropy decoding is performed on the side information $\hat{z}$ to obtain the side information $\hat{z}$, and probability estimation is performed on each feature element $\hat{y}[x][y][i]$ of the to-be-decoded feature map $\hat{y}$ with reference to the side information $\hat{z}$, to obtain the probability estimation result of the current to-be-decoded feature element $\hat{y}[x][y][i]$.

It should be noted that, a probability estimation method used by the decoder side is correspondingly the same as that used by the encoder side in this embodiment, and a diagram of a structure of a probability estimation network used by the decoder side is the same as that of the probability estimation network of the encoder side in this embodiment. Details are not described herein again.

Step 1513: This step is specifically implemented by the decoding decision implementation 304 in FIG.

11A. For details, refer to the foregoing description of the decoding decision implementation 30. Whether entropy decoding needs to be performed on the current to-be-decoded feature element $\hat{y}[x][y][i]$ is determined based on the probability estimation result, and entropy decoding is performed or not performed based on the determining result to obtain the decoded feature map $\hat{y}$.

One or more of the following methods may be used to determine, based on the probability estimation result, whether entropy decoding needs to be performed on the current to-be-decoded feature element $\hat{y}[x][y][i]$.

Method 1: When the probability distribution model is the Gaussian distribution, the values of the mean value parameter $\mu$ and the variance $\sigma$ of the current to-be-decoded feature element $\hat{y}[x][y][i]$ are obtained based on the probability estimation result. When an absolute value of a difference between the mean value $\mu$ and k is less than a second threshold T1, and the variance $\sigma$ is less than a third threshold T2 (a preset condition is not met), a numerical value of the current to-be-decoded feature element $\hat{y}[x][y][i]$ is set to k, and performing the entropy decoding process on the current to-be-decoded feature element $\hat{y}[x][y][i]$ is skipped. Otherwise, when an absolute value of a difference between the mean value $\mu$ and k is less than a second threshold T1, or the variance $\sigma$ is greater than or equal to a third threshold T2 (a preset condition), entropy decoding is performed on the current to-be-decoded feature element $\hat{y}[x][y][i]$ to obtain the value of the current to-be-decoded feature element $\hat{y}[x][y][i]$.

In particular, when a value of k is 0, it is an optimal value. It may be directly determined that when an absolute value of the mean value parameter $\mu$ of the Gaussian distribution is less than T1, and the variance $\sigma$ of the Gaussian distribution is less than T2, the value of the current to-be-decoded feature element $\hat{y}[x][y][i]$ is set to k, and performing the entropy decoding process on the current to-be-decoded feature element $\hat{y}[x][y][i]$ is skipped. Otherwise, entropy decoding is performed on the current to-be-decoded feature element $\hat{y}[x][y][i]$, and the value of the current to-be-decoded feature element $\hat{y}[x][y][i]$ is obtained.

Method 2: When the probability distribution is the Gaussian distribution, the values of the mean value parameter $\mu$ and the variance $\sigma$ of the current to-be-decoded feature element $\hat{y}[x][y][i]$ are obtained based on the probability estimation result. When a relationship between the mean value $\mu$, the variance $\sigma$, and k meets abs($\mu$-k)+$\sigma$<T3 (a preset condition is not met), T3 is a fourth threshold, the value of the current to-be-decoded feature element $\hat{y}[x][y][i]$ is set to k, and performing the entropy decoding process on the current to-be-decoded feature element $\hat{y}[x][y][i]$ is skipped. Otherwise, when the probability estimation result of the current to-be-decoded feature element meets abs($\mu$ - k) + $\sigma$ $\geq$ T3 (a preset condition), entropy decoding is performed on the current to-be-decoded feature element $\hat{y}[x][y][i]$ to obtain the value of the current to-be-decoded feature element $\hat{y}[x][y][i]$.

Method 3: When the probability distribution is the Laplace distribution, the values of the location parameter $\mu$ and the scale parameter b are obtained based on the probability estimation result. When a relationship between the location parameter $\mu$, the scale parameter b, and k meets abs($\mu$-k)+$\sigma$<T4 (a preset condition is not met), T4 is a fourth threshold, the value of the current to-be-decoded feature element $\hat{y}[x][y][i]$ is set to k, and performing the entropy decoding process on the current to-be-decoded feature element $\hat{y}[x][y][i]$ is skipped. Otherwise, when the probability estimation result of the current to-be-decoded feature element meets abs($\mu$ - k) + $\sigma$ $\geq$ T4 (a preset condition), entropy decoding is performed on the current to-be-decoded feature element $\hat{y}[x][y][i]$ to obtain the value of the current to-be-decoded feature element $\hat{y}[x][y][i]$.

Method 4: When the probability distribution is the Laplace distribution, the values of the location parameter $\mu$ and the scale parameter b are obtained based on the probability estimation result. When an absolute value of a difference between the location parameter $\mu$ and k is less than a second threshold T5, and the scale parameter b is less than a third threshold T6 (a preset condition is not met), the value of the current to-be-decoded feature element $\hat{y}[x][y][i]$ is set to k, and performing the entropy decoding process on the current to-be-decoded feature element $\hat{y}[x][y][i]$ is skipped. Otherwise, when an absolute value of a difference between the location parameter $\mu$ and k is less than a second threshold T5, or the scale parameter b is greater than or equal to a third threshold T6 (a preset condition), entropy decoding is performed on the current to-be-decoded feature element $\hat{y}[x][y][i]$, and the value of the current to-be-decoded feature element $\hat{y}[x][y][i]$ is obtained.

In particular, when a value of k is 0, it is an optimal value. It may be directly determined that when an absolute value of the location parameter $\mu$ is less than T5, and the scale parameter b is less than T6, the value of the current to-be-decoded feature element $\hat{y}[x][y][i]$ is set to k, and performing the entropy decoding process on the current to-be-decoded feature element $\hat{y}[x][y][i]$ is skipped. Otherwise, entropy decoding is performed on the current to-be-decoded feature element $\hat{y}[x][y][i]$, and the value of the current to-be-decoded feature element $\hat{y}[x][y][i]$ is obtained.

Method 5: When the probability distribution is Gaussian mixture distribution, values of all mean value parameters $\mu_i$ and variances $\sigma_i$ that are of the Gaussian mixture distribution of the current to-be-decoded feature element $\hat{y}[x][y][i]$ are obtained based on the probability estimation result. When a sum of any variance of the Gaussian mixture distribution and a sum of absolute values of differences between all the mean values of the Gaussian mixture distribution and the value k of the current to-be-decoded feature element is less than a fifth threshold T7 (a preset condition is not met), the value of the current to-be-decoded feature element $\hat{y}[x][y][i]$ is set to k, and performing the entropy decoding process on the current to-be-decoded feature element $\hat{y}[x][y][i]$ is skipped. Otherwise, when a sum of any variance of the Gaussian mixture distribution and a sum of absolute values of differences between all the mean values of the Gaussian mixture distribution and the value k of the current to-be-decoded feature element is greater than or equal to a fifth threshold T7 (a preset condition), entropy decoding is performed on the current to-be-decoded feature element $\hat{y}[x][y][i]$, and the value of the current to-be-decoded feature element $\hat{y}[x][y][i]$ is obtained.

Method 6: A probability P, that is, a probability estimation result P of the current to-be-decoded feature element, that the value of the current to-be-decoded feature element is k is obtained based on the probability distribution of the current to-be-decoded feature element. When the probability estimation result P does not meet a preset condition: P is greater than a first threshold T0, entropy decoding does not need to be performed on the current to-be-decoded feature element, and the value of the current to-be-decoded feature element is set to k. Otherwise, when the current to-be-decoded feature element meets a preset condition: P is less than or equal to a first threshold T0, entropy decoding is performed on the bitstream, and the value of the current to-be-decoded feature element is obtained.

The value k of the foregoing decoder side is set correspondingly to the value k of the encoder side.

A method for obtaining the thresholds T0, T1, T2, T3, T4, T5, T6, and T7 corresponds to that of the encoder side, and one of the following methods may be used.

Method 1: The threshold is obtained from the bitstream. Specifically, the threshold is obtained from a sequence header, a picture header, a slice/slice header, or SEI.

Method 2: The decoder side uses a fixed threshold agreed with the encoder side.

Method 3: A threshold index number is obtained from the bitstream. Specifically, the threshold index number is obtained from a sequence header, a picture header, a slice/slice header, or SEI. Then, the decoder side constructs a threshold candidate list in the same manner as the encoder, and obtains a corresponding threshold in the threshold candidate list based on the threshold index number.

It should be noted that, in actual application, to ensure platform consistency, the thresholds T1, T2, T3, T4, T5, and T6 may be rounded, that is, shifted and scaled to integers.

Step 1514 is the same as step 1414.

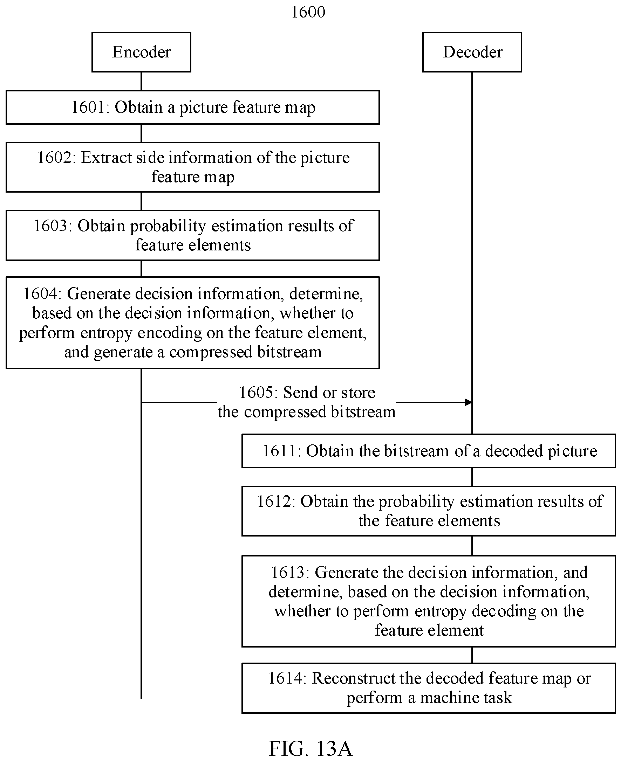

FIG. 13A shows a specific implementation process 1600 according to Embodiment 3 of this application. Running steps are as follows.

Encoder side:

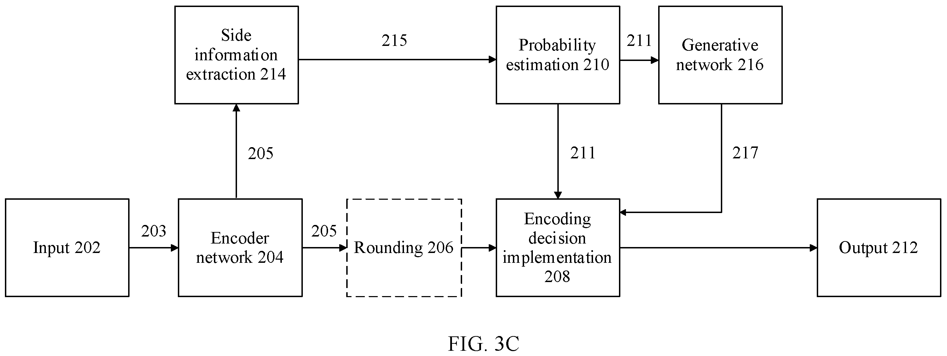

Step 1601 is the same as step 1501. This step is specifically implemented by the encoder network 204 in FIG. 3C. For details, refer to the foregoing description of the encoder network 20.

Step 1602 is the same as step 1502. This step is specifically implemented by the side information extraction 214 in FIG. 3C.

Step 1603: Perform probability estimation on a feature map $\hat{y}$ to obtain probability estimation results of feature elements.

This step may be specifically implemented by the probability estimation 210 in FIG. 3C. For details, refer to the foregoing description of the probability estimation 40. A probability distribution model may be used to obtain the probability estimation result. The probability distribution model may be a Gaussian single model, an asymmetric Gaussian model, a Gaussian mixture model, or a Laplace distribution model.

When the probability distribution model is the Gaussian model (the Gaussian single model, the asymmetric Gaussian model, or the Gaussian mixture model), first, side information $\hat{z}$ or context information is input into a probability estimation network, and probability estimation is performed on each feature element $\hat{y}[x][y][i]$ of the feature map $\hat{y}$ to obtain values of a model parameter mean value parameter $\mu$ and a variance $\sigma$, that is, the probability estimation result.

When the probability distribution model is the Laplace distribution model, first, side information $\hat{z}$ or context information is input into a probability estimation network, and probability estimation is performed on each feature element $\hat{y}[x][y][i]$ of the feature map y to obtain values of a model parameter location parameter $\mu$ and a scale parameter b, that is, the probability estimation result.

Further, the probability estimation results are input into the used probability distribution model to obtain probability distribution.

Alternatively, the side information $\hat{z}$ and/or context information may be input into the probability estimation network, and probability estimation is performed on each feature element $\hat{y}[x][y][i]$ of the to-be-encoded feature map $\hat{y}$ to obtain probability distribution of the current to-be-encoded feature element $\hat{y}[x][y][i]$. A probability P that a value of the current to-be-encoded feature element $\hat{y}[x][y][i]$ is m is obtained based on the probability distribution. m is any integer, for example, 0, 1, -1, -2, or 3.

The probability estimation network may use a deep learning-based network, for example, a recurrent neural network and a convolutional neural network. This is not limited herein.

Step 1604: Determine, based on the probability estimation result, whether to perform entropy encoding on the current to-be-encoded feature element. Entropy encoding is performed on the current to-be-encoded feature element based on a determining result and the current to-be-encoded feature element is written into an encoded bitstream, or entropy encoding is not performed. Entropy encoding is performed on the current to-be-encoded feature element only when it is determined that entropy encoding needs to be performed on the current to-be-encoded feature element.

This step is specifically implemented by a generative network 216 and the encoding decision implementation 208 in FIG. 3C. For details, refer to the foregoing description of the generative network 46 and the encoding decision implementation 26. The probability estimation result 211 is input into a determining module, and decision information 217 whose dimension is the same as that of the feature map $\hat{y}$ is output. In this embodiment, the decision information 217 may be a three-dimensional decision map. The determining module may be implemented by using a network method. To be specific, the probability estimation result or the probability distribution is input into a generative network shown in FIG. 7, and the network outputs a decision map. When the decision map $map[x][y][i]$ is a preset value, it indicates that entropy encoding needs to be performed on the current to-be-encoded feature element $\hat{y}[x][y][i]$ at a corresponding location, and entropy encoding is performed on the current to-be-encoded feature element based on the probability distribution. When the decision map $map[x][y][i]$ is a preset value, it indicates that a high probability value of the current to-be-encoded feature element $\hat{y}[x][y][i]$ at a corresponding location is k. When the decision map $map[x][y][i]$ is not a preset value, it indicates that entropy encoding does not need to be performed on the current to-be-encoded feature element $\hat{y}[x][y][i]$ at the corresponding location, in other words, the entropy encoding process is skipped. The decision information is a decision map whose dimension is the same as that of the feature map $\hat{y}$. The decision map $map[x][y][i]$ indicates a value at a coordinate location (x, y, i) in the decision map. When there are only two optional values of the current to-be-encoded feature element $\hat{y}$ of the decision map output by the generative network, the preset value is a specific value. For example, when the optional values of the current to-be-encoded feature element are 0 and 1, the preset value is 0 or 1. When there are a plurality of optional values of the current to-be-encoded feature element $\hat{y}$ of the decision map output by the generative network, the preset value is some specific values. For example, when the optional values of the current to-be-encoded feature element $\hat{y}$ are from 0 to 255, the preset value is a proper subset of 0 to 255.

In a possible implementation, the probability estimation result or the probability distribution of the current to-be-encoded feature element is input into the determining module, and the determining module directly outputs the decision information indicating whether entropy encoding needs to be performed on the current to-be-encoded feature element. For example, when the decision information output by the determining module is the preset value, it indicates that entropy encoding needs to be performed on the current to-be-encoded feature element. When the decision information output by the determining module is not the preset value, it indicates that entropy encoding does not need to be performed on the current to-be-encoded feature element. The determining module may be implemented by using the network method. To be specific, the probability estimation result or the probability distribution is input into the generative network shown in FIG. 7, and the network outputs the decision information, that is, the preset value.

Method 1: The decision information is a decision map whose dimension is the same as that of the feature map $\hat{y}$, and when the decision map $map[x][y][i]$ is the preset value, it indicates that entropy encoding needs to be performed on the current to-be-encoded feature element $\hat{y}[x][y][i]$ at the corresponding location, and entropy encoding is performed on the current to-be-encoded feature element based on the probability distribution. When the decision map $map[x][y][i]$ is not the preset value, it indicates that the high probability value of the current to-be-encoded feature element $\hat{y}[x][y][i]$ at the corresponding location is k. When the decision map $map[x][y][i]$ is 0, it indicates that entropy encoding does not need to be performed on the current to-be-encoded feature element $\hat{y}[x][y][i]$ at the corresponding location, in other words, the entropy encoding process is skipped. When there are only the two optional values of the feature element $\hat{y}$ of the decision map, the preset value is a specific value. For example, when the optional values of the feature element are 0 and 1, the preset value is 0 or 1. When there are the plurality of optional values of the feature element $\hat{y}$ of the decision map, the preset value is some specific values. For example, when the optional values of the feature element $\hat{y}$ are from 0 to 255, the preset value is a proper subset of 0 to 255.

Method 2: The decision information is a decision map whose dimension is the same as that of the feature map $\hat{y}$, and when the decision map $map[x][y][i]$ is greater than or equal to a threshold T0, it indicates that entropy encoding needs to be performed on the current to-be-encoded feature element $\hat{y}[x][y][i]$ at the corresponding location, and entropy encoding is performed on the current to-be-encoded feature element based on the probability distribution. When the decision map $map[x][y][i]$ is less than the threshold T0, it indicates that the high probability value of the current to-be-encoded feature element $\hat{y}[x][y][i]$ at the corresponding location is k, and indicates that entropy encoding does not need to be performed on the current to-be-encoded feature element $\hat{y}[x][y][i]$ at the corresponding location, in other words, the entropy encoding process is skipped. With reference to a numerical range of the decision map, T0 may be a mean value within the numerical range.

Method 3: The decision information may alternatively be an identifier or an identifier value directly output by a joint network. When the decision information is the preset value, it indicates that entropy encoding needs to be performed on the current to-be-encoded feature element. When the decision information output by the determining module is not the preset value, it indicates that entropy encoding does not need to be performed on the current to-be-encoded feature element. For example, when optional numerical values of the identifier or the identifier value are 0 and 1, correspondingly, the preset value is 0 or 1. When the identifier or the identifier value may alternatively have a plurality of optional values, the preset value is some specific values. For example, when the optional values of the identifier or the identifier value are from 0 to 255, the preset value is a proper subset of 0 to 255.

The high probability means that a probability that the value of the current to-be-encoded feature element $\hat{y}[x][y][i]$ is k is very high and is greater than the threshold P, where P may be a number greater than 0.9, for example, 0.9, 0.95, or 0.98.

Step 1605: An encoder sends or stores the compressed bitstream.

Step 1601 to step 1604 are performed on at least one feature element of the feature map $\hat{y}$ to obtain the compressed bitstream, and the compressed bitstream is transmitted to a decoder side.

Decoder side:

Step 1611: Obtain the to-be-decoded compressed bitstream.

Step 1612: Perform probability estimation on the to-be-decoded feature map $\hat{y}$ to obtain the probability estimation results of the feature elements.

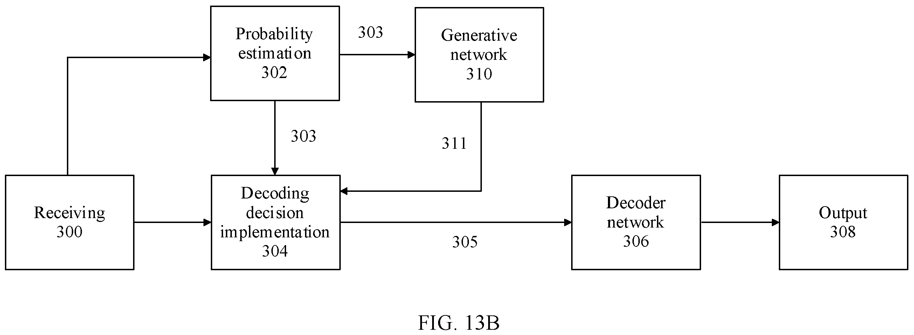

This step may be specifically implemented by the probability estimation 302 in FIG. 13B. For details, refer to the foregoing description of the probability estimation 40. The side information $\hat{z}$ is obtained from the bitstream, and the probability estimation result of the current to-be-decoded feature element is obtained by using the method in step 1603.

Step 1613: Obtain the decision information, and determine, based on the decision information, whether to perform entropy decoding.

This step may be specifically implemented by a generative network 310 and decoding decision implementation 304 in FIG. 13B. For details, refer to the foregoing description of the generative network 46 and the decoding decision implementation 30. Decision information 311 is obtained by using the same method as that of the encoder side in this embodiment. When the decision map $map[x][y][i]$ is the preset value, it indicates that entropy decoding needs to be performed on the current to-be-decoded feature element $\hat{y}[x][y][i]$ at the corresponding location, and entropy decoding is performed on the current to-be-decoded feature element based on the probability distribution. When the decision map $map[x][y][i]$ is not the preset value, it indicates that entropy decoding does not need to be performed on the current to-be-decoded feature element $\hat{y}[x][y][i]$ at the corresponding location, in other words, indicates that the corresponding location $\hat{y}[x][y][i]$ is the specific value k.

In a possible implementation, the probability estimation result or the probability distribution of the current to-be-decoded feature element is input into the determining module, and the determining module directly outputs the decision information indicating whether entropy decoding needs to be performed on the current to-be-decoded feature element. For example, when the decision information output by the determining module is the preset value, it indicates that entropy decoding needs to be performed on the current to-be-decoded feature element. When the decision information output by the determining module is not the preset value, it indicates that entropy decoding does not need to be performed on the current to-be-decoded feature element, and the value of the current to-be-decoded feature element is set to k. The determining module may be implemented by using the network method. To be specific, the probability estimation result or the probability distribution is input into the generative network shown in FIG. 8, and the network outputs the decision information, that is, the preset value. The decision information indicates whether to perform entropy decoding on the current to-be-decoded feature element, and the decision information may include the decision map.

Step 1614 is the same as step 1414.

The value k of the foregoing decoder side is set correspondingly to the value k of the encoder side.

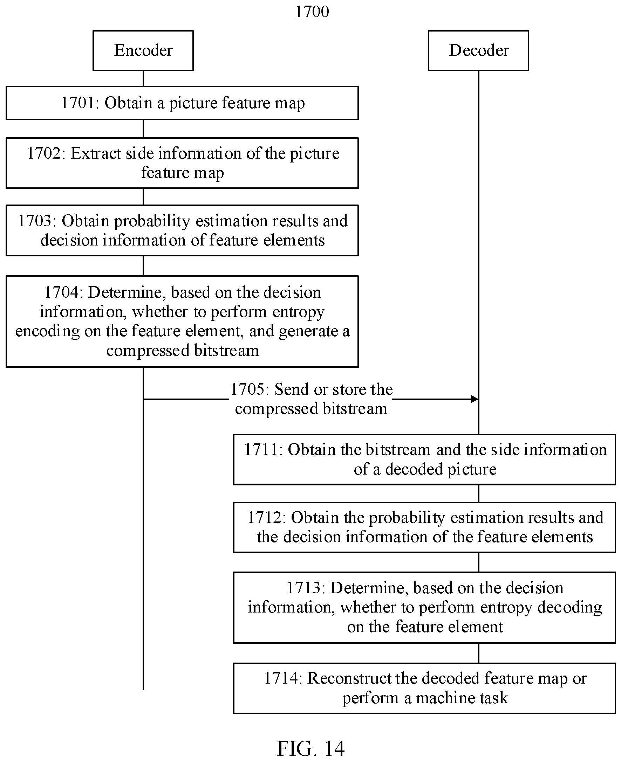

FIG. 14 shows a specific implementation process 1700 according to Embodiment 4 of this application. Running steps are as follows.

Encoder side:

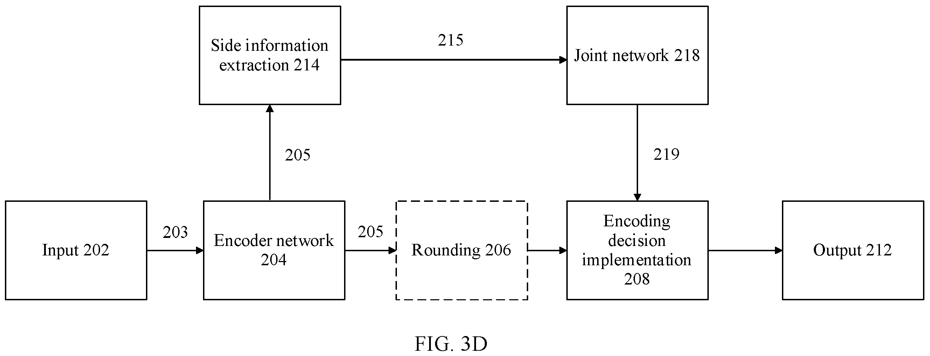

Step 1701 is the same as step 1501. This step may be specifically implemented by the encoder network 204 in FIG. 3D. For details, refer to the foregoing description of the encoder network 20.

Step 1702 is the same as step 1502. This step is specifically implemented by the side information extraction 214 in FIG. 3D.

Step 1703: Obtain a probability estimation result and decision information of each feature element of a feature map $\hat{y}$.

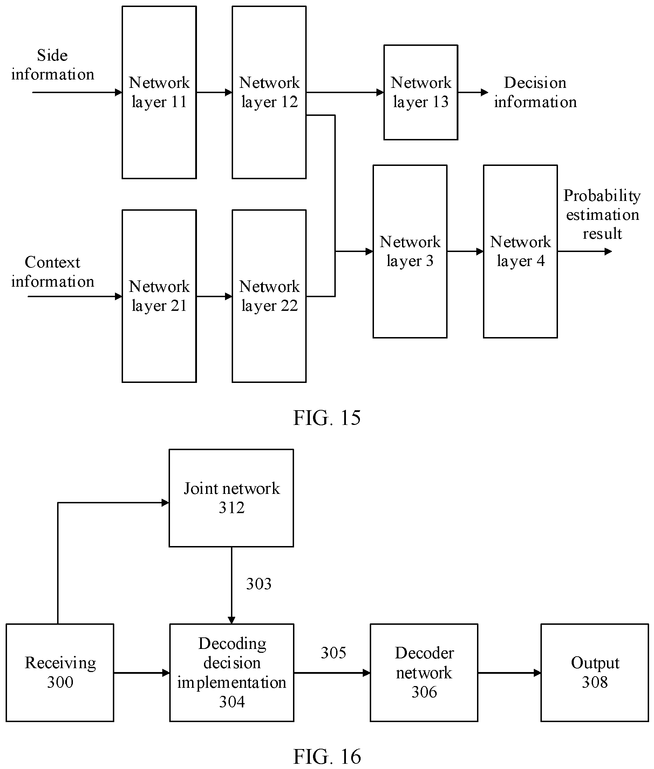

This step may be specifically implemented by a joint network 218 in FIG. 3D. For details, refer to the foregoing description of the joint network 34. Specifically, side information $\hat{z}$ and/or the context information are/is input into the joint network. The joint network outputs probability distribution and/or the probability estimation result of each feature element $\hat{y}[x][y][i]$ of the to-be-encoded feature map $y$, and decision information whose dimension is the same as that of the feature map $\hat{y}$. For example, when both the side information $\hat{z}$ and the context information are input into the joint network, a network structure shown in FIG. 15 may be used.

It should be noted that a specific structure of the joint network is not limited in this embodiment.

It should be noted that the decision information, the probability distribution, and/or the probability estimation result may all be output from different layers of the joint network. For example, in a case (1), a middle layer of the network outputs the decision information, and a last layer outputs the probability distribution and/or probability estimation result. In a case (2), a middle layer of the network outputs the probability distribution and/or probability estimation result, and a last layer outputs the decision information. In a case (3), a last layer of the network outputs the decision information, and the probability distribution and/or probability estimation result together.

When a probability distribution model is a Gaussian model (a Gaussian single model, an asymmetric Gaussian model, or a Gaussian mixture model), first, the side information $\hat{z}$ or context information is input into the joint network to obtain values of a model parameter mean value parameter $\mu$ and a variance $\sigma$, that is, the probability estimation result. Further, the probability estimation results are input into the Gaussian model to obtain the probability distribution.

When a probability distribution model is a Laplace distribution model, first, the side information $\hat{z}$ or context information is input into the joint network to obtain values of a model parameter location parameter $\mu$ and a scale parameter b, that is, the probability estimation result. Further, the probability estimation results are input into the Laplace distribution model to obtain the probability distribution.

Alternatively, the side information $\hat{z}$ and/or context information may be input into the joint network to obtain the probability distribution of the current to-be-encoded feature element $\hat{y}[x][y][i]$. A probability P, that is, the probability estimation result, that a value of the current to-be-encoded feature element $\hat{y}[x][y][i]$ is m is obtained based on the probability distribution. m is any integer, for example, 0, 1, -1, -2, or 3.

Step 1704: Determine, based on the decision information, whether to perform entropy encoding; and perform, based on a determining result, entropy encoding and write the current to-be-encoded feature element into a compressed bitstream (encoded bitstream), or skip performing entropy encoding. Entropy encoding is performed on the current to-be-encoded feature element only when it is determined that entropy encoding needs to be performed on the current to-be-encoded feature element. This step may be specifically implemented by the encoding decision implementation 208 in FIG. 3D. For details, refer to the foregoing description of the encoding decision implementation 26.

Method 1: The decision information is a decision map whose dimension is the same as that of the feature map y, and when the decision map map[x][y][i] is a preset value, it indicates that entropy encoding needs to be performed on the current to-be-encoded feature element $\hat{y}[x][y][i]$ at a corresponding location, and entropy encoding is performed on the current to-be-encoded feature element based on the probability distribution. When the decision map $map[x][y][i]$ is not the preset value, it indicates that a high probability value of the current to-be-encoded feature element $\hat{y}[x][y][i]$ at the corresponding location is k. When the decision map $map[x][y][i]$ is 0, it indicates that entropy encoding does not need to be performed on the current to-be-encoded feature element $\hat{y}[x][y][i]$ at the corresponding location, in other words, the entropy encoding process is skipped. When there are only two optional values of the current to-be-encoded feature element $\hat{y}$ of the decision map, the preset value is a specific value. For example, when the optional values of the current to-be-encoded feature element are 0 and 1, the preset value is 0 or 1. When there are a plurality of optional values of the current to-be-encoded feature element $\hat{y}$ of the decision map, the preset value is some specific values. For example, when the optional values of the current to-be-encoded feature element $\hat{y}$ are from 0 to 255, the preset value is a proper subset of 0 to 255.

Method 2: The decision information is a decision map whose dimension is the same as that of the feature map y, and when the decision map $map[x][y][i]$ is greater than or equal to a threshold T0, it indicates that entropy encoding needs to be performed on the current to-be-encoded feature element $\hat{y}[x][y][i]$ at a corresponding location, and entropy encoding is performed on the current to-be-encoded feature element based on the probability distribution. When the decision map $map[x][y][i]$ is less than the threshold T0, it indicates that a high probability value of the current to-be-encoded feature element $\hat{y}[x][y][i]$ at the corresponding location is k, and indicates that entropy encoding does not need to be performed on the current to-be-encoded feature element $\hat{y}[x][y][i]$ at the corresponding location, in other words, the entropy encoding process is skipped. With reference to a numerical range of the decision map map, T0 may be a mean value within the numerical range.

Method 3: The decision information may alternatively be an identifier or an identifier value directly output by the joint network. When the decision information is a preset value, it indicates that entropy encoding needs to be performed on the current to-be-encoded feature element. When the decision information output by a determining module is not a preset value, it indicates that entropy encoding does not need to be performed on the current to-be-encoded feature element. When there are only two optional values of the current to-be-encoded feature element of the decision map output by the joint network, the preset value is a specific value. For example, when the optional values of the current to-be-encoded feature element are 0 and 1, the preset value is 0 or 1. When there are a plurality of optional values of the current to-be-encoded feature element of the decision map output by the joint network, the preset value is some specific values. For example, when the optional values of the current to-be-encoded feature element are from 0 to 255, the preset value is a proper subset of 0 to 255.

The high probability means that a probability that the value of the current to-be-encoded feature element $\hat{y}[x][y][i]$ is m is very high. For example, when the value is k, the probability is greater than the threshold P, where P may be a number greater than 0.9, for example, 0.9, 0.95, or 0.98.

Step 1705: An encoder sends or stores the compressed bitstream.

Decoder side:

Step 1711: Obtain the bitstream of the to-be-decoded picture feature map, and obtain the side information $\hat{z}$ from the bitstream.

Step 1712: Obtain the probability estimation result and the decision information of each feature element of the feature map $\hat{y}$.

This step may be specifically implemented by a joint network 312 in FIG. 16. For details, refer to the foregoing description of the joint network 34. The probability estimation result and the decision information of each feature element of the feature map $\hat{y}$ are obtained. This is the same as step 1703.

Step 1713: Determine, based on the decision information, whether to perform entropy decoding, and perform or skip entropy decoding based on the determining result. This step may be specifically implemented by the decoding decision implementation 304 in FIG. 16. For details, refer to the foregoing description of the decoding decision implementation 30.

Method 1: The decision information is the decision map, and when the decision map $map[x][y][i]$ is the preset value, it indicates that entropy decoding needs to be performed on the current to-be-decoded feature element $\hat{y}[x][y][i]$ at a corresponding location, and entropy decoding is performed on the current to-be-decoded feature element based on the probability distribution. When the decision map is not the preset value $map[x][y][i]$, it indicates that entropy decoding does not need to be performed on the current to-be-decoded feature element $\hat{y}[x][y][i]$ at the corresponding location, in other words, indicates that the corresponding location $\hat{y}[x][y][i]$ is set to the specific value k.

Method 2: The decision information is a decision map map whose dimension is the same as that of the feature map $\hat{y}$, and when the decision map $map[x][y][i]$ is greater than or equal to a threshold T0, it indicates that entropy decoding needs to be performed on the current to-be-decoded feature element $\hat{y}[x][y][i]$ at a corresponding location. When the decision map $map[x][y][i]$ is less than the threshold T0, it indicates that a high probability value of the current to-be-decoded feature element $\hat{y}[x][y][i]$ at the corresponding location is k, and indicates that entropy decoding does not need to be performed on the current to-be-decoded feature element $\hat{y}[x][y][i]$ at the corresponding location, in other words, the corresponding location $\hat{y}[x][y][i]$ is set to the specific value k. A value of T0 is the same as that of the encoder side.

Method 3: The decision information may alternatively be an identifier or an identifier value directly output by the joint network. When the decision information is a preset value, it indicates that entropy decoding needs to be performed on the current to-be-decoded feature element. When the decision information output by a determining module is not a preset value, it indicates that entropy decoding does not need to be performed on the current to-be-decoded feature element, and the value of the current to-be-decoded feature element is set to k. When there are only two optional values of the current to-be-decoded feature element of the decision map output by the joint network, the preset value is a specific value. For example, when the optional values of the current to-be-decoded feature element are 0 and 1, the preset value is 0 or 1. When there are a plurality of optional values of the current to-be-decoded feature element of the decision map output by the joint network, the preset value is some specific values. For example, when the optional values of the current to-be-decoded feature element are from 0 to 255, the preset value is a proper subset of 0 to 255.

Step 1714 is the same as step 1414. This step may be specifically implemented by the decoder network unit 306 in the decoder 9C in the foregoing embodiment. For details, refer to the description of the decoder network unit 306 in the foregoing embodiment.

The value k of the foregoing decoder side is set correspondingly to the value k of the encoder side.

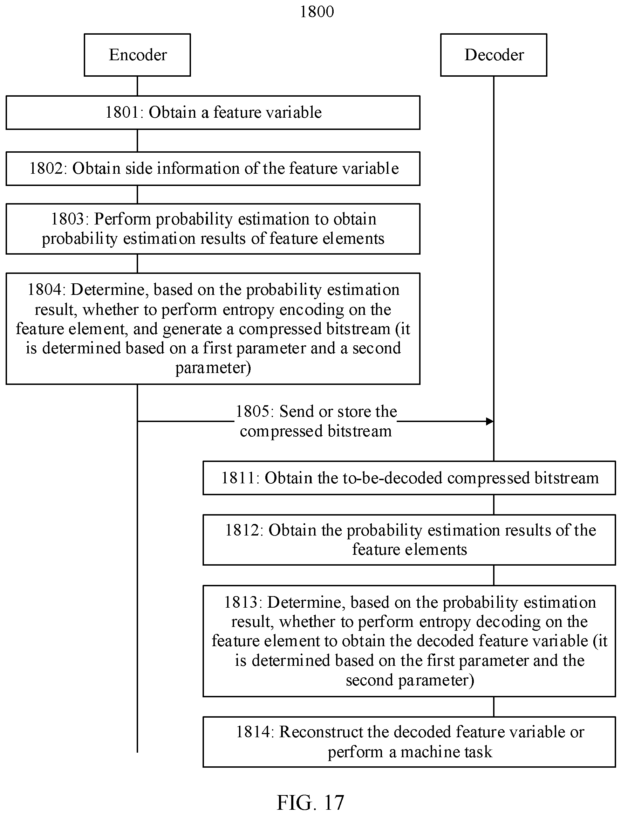

FIG. 17 shows a specific implementation process 1800 according to Embodiment 5 of this application. Running steps are as follows.

Step 1801: Obtain a feature variable of to-be-encoded audio data.

The to-be-encoded audio signal may be a time-domain audio signal. The to-be-encoded audio signal may be a frequency-domain signal obtained after time-frequency transformation is performed on the time-domain signal. For example, the frequency-domain signal may be a frequency-domain signal obtained after MDCT transformation is performed on the time-domain audio signal, and the time-domain audio signal is a frequency-domain signal obtained through FFT transformation. Alternatively, the to-be-encoded signal may be a signal obtained through QMF filtering. Alternatively, the to-be-encoded signal may be a residual signal, for example, another encoded residual signal or a residual signal obtained through LPC filtering.

Obtaining the feature variable of the to-be-encoded audio data may be extracting a feature vector based on the to-be-encoded audio signal, for example, extracting a Mel cepstrum coefficient based on the to-be-encoded audio signal; quantizing the extracted feature vector; and using the quantized feature vector as the feature variable of the to-be-encoded audio data.

Alternatively, obtaining the feature variable of the to-be-encoded audio data may be implemented by using an existing neural network. For example, the to-be-encoded audio signal is processed by an encoding neural network to obtain a latent variable, the latent variable output by the neural network is quantized, and the quantized latent variable is used as the feature variable of the to-be-encoded audio data. The encoding neural network processing is pre-trained, and a specific network structure and a training method of the encoding neural network are not limited in the present invention. For example, a fully-connected network or a CNN network may be selected for the encoding neural network. A quantity of layers included in the encoding neural network and a quantity of nodes at each layer are not limited in the present invention.

Forms of latent variables output by encoding neural networks of different structures may be different. For example, the encoding neural network is the fully-connected network. An output latent variable is a vector, and a dimension M of the vector is a size (latent size) of the latent variable, for example, y=[y(0), y(1), ..., y(M-1)]. The encoding neural network is the CNN network. An output latent variable is an N*M-dimensional matrix. N is a channel (channel) quantity of the CNN network, and M is a size (latent size) of a latent variable of each channel of the CNN network, for example,

$$y = \begin{bmatrix} y(0,0) & \cdots & y(0, M-1) \\ \vdots & \ddots & \vdots \\ y(N-1,0) & \cdots & y(N-1, M-1) \end{bmatrix}$$

a specific method for quantizing the latent variable output by the neural network may be performing scalar quantization on each element of the latent variable, and a quantization step of the scalar quantization may be determined based on different encoding rates. The scalar quantization may further have a bias. For example, after bias processing is performed on a to-be-quantized latent variable, scalar quantization is performed based on a determined quantization step. The quantization method for quantizing the latent variable may alternatively be implemented by using another existing quantization technology. This is not limited in the present invention.

Both the quantized feature vector or the quantized latent variable may be denoted as $\hat{y}$, that is, the feature variable of the to-be-encoded audio data.

Step 1802: The feature variable $\hat{y}$ of the to-be-encoded audio data is input into a side information extraction module, and side information $\hat{z}$ is output.

The side information extraction module may be implemented by using the network shown in FIG. 12. The side information $\hat{z}$ may be understood as a feature variable $\hat{z}$ obtained by further extracting the feature variable $\hat{y}$, and a quantity of feature elements included in $\hat{z}$ is less than that of the feature variable $\hat{y}$.

It should be noted that entropy encoding may be performed on the side information $\hat{z}$ and the side information $\hat{z}$ is written into a bitstream in this step, or entropy encoding may be performed on the side information $\hat{z}$ and the side information $\hat{z}$ is written into the bitstream in subsequent step 1804. This is not limited herein.

Step 1803: Perform probability estimation on the feature variable $\hat{y}$ to obtain probability estimation results of feature elements.

A probability distribution model may be used to obtain the probability estimation result and probability distribution. The probability distribution model may be: a Gaussian single model (Gaussian single model, GSM), an asymmetric Gaussian model, a Gaussian mixture model (Gaussian mix model, GMM), or a Laplace distribution (Laplace distribution) model.

The following uses an example in which the feature variable $\hat{y}$ is the N*M-dimensional matrix for description. The feature element of the current to-be-encoded feature variable $\hat{y}$ is denoted as $\hat{y}[j][i]$, where j ∈ [0, N - 1] and i ∈ [0, M - 1].

When the probability distribution model is the Gaussian model (the Gaussian single model, the asymmetric Gaussian model, or the Gaussian mixture model), first, the side information $\hat{z}$ or context information is input into a probability estimation network, and probability estimation is performed on each feature element $\hat{y}[j][i]$ of the feature variable $\hat{y}$ to obtain values of a mean value parameter μ and a variance σ. Further, the mean value parameter μ and the variance σ are input into the used probability distribution model to obtain the probability distribution. In this case, the probability estimation result includes the mean value parameter μ and the variance σ.

A variance may alternatively be estimated. For example, when the probability distribution model is the Gaussian model (the Gaussian single model, the asymmetric Gaussian model, or the Gaussian mixture model), first, the side information $\hat{z}$ or context information is input into a probability estimation network, and probability estimation is performed on each feature element $\hat{y}[j][i]$ of the feature variable $\hat{y}$ to obtain a value of the variance σ. Further, the variance σ is input into the used probability distribution model to obtain the probability distribution. In this case, the probability estimation result is the variance σ.

When the probability distribution model is the Laplace distribution model, first, the side information $\hat{z}$ or context information is input into a probability estimation network, and probability estimation is performed on each feature element $\hat{y}[j][i]$ of the feature variable $\hat{y}$ to obtain values of a location parameter μ and a scale parameter b. Further, the location parameter μ and the scale parameter b are input into the used probability distribution model to obtain the probability distribution. In this case, the probability estimation result includes the location parameter μ and the scale parameter b.

Alternatively, the side information $\hat{z}$ and/or context information may be input into the probability estimation network, and probability estimation is performed on each feature element $\hat{y}[j][i]$ of the to-be-encoded feature map $\hat{y}$ to obtain probability distribution of the current to-be-encoded feature element $\hat{y}[j][i]$. A probability P that a value of the current to-be-encoded feature element $\hat{y}[j][i]$ is m is obtained based on the probability distribution. In this case, the probability estimation result is the probability P that the value of the current to-be-encoded feature element $\hat{y}[j][i]$ is m.

The probability estimation network may use a deep learning-based network, for example, a recurrent neural network (recurrent neural network, RNN) and a convolutional neural network (convolutional neural network, CNN). This is not limited herein.

Step 1804: Determine, based on the probability estimation result, whether entropy encoding needs to be performed on the current to-be-encoded feature element; and perform, based on a determining result, entropy encoding and write the current to-be-encoded feature element into the compressed bitstream (encoded bitstream), or skip performing entropy encoding.

One or more of the following methods may be used to determine, based on the probability estimation result, whether entropy encoding needs to be performed on the current to-be-encoded feature element $\hat{y}[j][i]$. Parameters j and i are positive integers, and coordinates (j, i) indicate a location of the current to-be-encoded feature element. Alternatively, one or more of the following methods may be used to determine, based on the probability estimation result, whether entropy encoding needs to be performed on the current to-be-encoded feature element $\hat{y}[i]$. The parameter i is a positive integer, and a coordinate i indicates a location of the current to-be-encoded feature element.

An example in which whether entropy encoding needs to be performed on the current to-be-encoded feature element $\hat{y}[j][i]$ is determined based on the probability estimation result is used below for description. A method for determining whether entropy encoding needs to be performed on the current to-be-encoded feature element $\hat{y}[i]$ is similar. Details are not described herein again.

Method 1: When the probability distribution model is the Gaussian distribution, whether to perform entropy encoding on the current to-be-encoded feature element is determined based on the probability estimation result of the first feature element. When the values of the mean value parameter μ and the variance σ that are of the Gaussian distribution of the current to-be-encoded feature element meet a second condition: an absolute value of a difference between the mean value μ and k is less than a second threshold T1, and the variance σ is less than a third threshold T2, the entropy encoding process does not need to be performed on the current to-be-encoded feature element $\hat{y}[j][i]$. Otherwise, when a first condition is met: an absolute value of a difference between the mean value μ and k is greater than or equal to a second threshold T1, or the variance σ is less than a third threshold T2, entropy encoding is performed on the current to-be-encoded feature element $\hat{y}[j][i]$ and the current to-be-encoded feature element $\hat{y}[j][i]$ is written into the bitstream. k is any integer, for example, 0, 1, -1, 2, or 3. A value of T2 is any number that meets 0<T2<1, for example, a value of 0.2, 0.3, 0.4, or the like. T1 is a number greater than or equal to 0 and less than 1, for example, 0.01, 0.02, 0.001, and 0.002.

In particular, when a value of k is 0, it is an optimal value. It may be directly determined that when an absolute value of the mean value parameter μ of the Gaussian distribution is less than T1, and the variance σ of the Gaussian distribution is less than T2, performing the entropy encoding process on the current to-be-encoded feature element $\hat{y}[j][i]$ is skipped. Otherwise, entropy encoding is performed on the current to-be-encoded feature element $\hat{y}\hat{y}[j][i]$ and the current to-be-encoded feature element $\hat{y}\hat{y}[j][i]$ is written into the bitstream. The value of T2 is any number that meets 0<T2<1, for example, a value of 0.2, 0.3, 0.4, or the like. T1 is a number greater than or equal to 0 and less than 1, for example, 0.01, 0.02, 0.001, and 0.002.

Method 2: When the probability distribution is the Gaussian distribution, the values of the mean value parameter μ and the variance σ of the Gaussian distribution of the current to-be-encoded feature element $\hat{y}[j][i]$ are obtained based on the probability estimation result. When a relationship between the mean value μ, the variance σ, and k meets abs(μ - k) + σ < T3 (a second condition), performing the entropy encoding process on the current to-be-encoded feature element $\hat{y}[j][i]$ is skipped, where abs(μ-k) represents calculating an absolute value of a difference between the mean value μ and k. Otherwise, when the probability estimation result of the current to-be-encoded feature element meets abs(μ - k) + σ ≥ T3 (a first condition), entropy encoding is performed on the current to-be-encoded feature element $\hat{y}[j][i]$ and the current to-be-encoded feature element $\hat{y}[j][i]$ is written into the bitstream. k is any integer, for example, 0, 1, -1, -2, or 3. A fourth threshold T3 is a number greater than or equal to 0 and less than 1, for example, a value is 0.2, 0.3, 0.4, or the like.

When the probability distribution is the Gaussian distribution, if probability estimation is performed on each feature element $\hat{y}[j][i]$ of the feature variable $\hat{y}$, only the value of the variance σ of the Gaussian distribution of the current to-be-encoded feature element $\hat{y}[j][i]$ is obtained. When the variance σ meets σ < T3 (the second condition), performing the entropy encoding process on the current to-be-encoded feature element $\hat{y}[j][i]$ is skipped. Otherwise, when the probability estimation result of the current to-be-encoded feature element meets σ ≥ T3 (the first condition), entropy encoding is performed on the current to-be-encoded feature element $\hat{y}[j][i]$ and the current to-be-encoded feature element $\hat{y}[j][i]$ is written into the bitstream. The fourth threshold T3 is a number greater than or equal to 0 and less than 1, for example, the value is 0.2, 0.3, 0.4, or the like.

Method 3: When the probability distribution is the Laplace distribution, the values of the location parameter μ and the scale parameter b that are of the Laplace distribution of the current to-be-encoded feature element $\hat{y}[j][i]$ are obtained based on the probability estimation result. When a relationship between the location parameter μ, the scale parameter b, and k meets abs(μ - k) + σ < T4 (a second condition), performing the entropy encoding process on the current to-be-encoded feature element $\hat{y}[j][i]$ is skipped, where abs(μ-k) represents calculating an absolute value of a difference between the

location parameter $\mu$ and k. Otherwise, when the probability estimation result of the current to-be-encoded feature element meets abs($\mu$ - k) + $\sigma \geq$ T4 (a first condition), entropy encoding is performed on the current to-be-encoded feature element $\hat{y}[j][i]$ and the current to-be-encoded feature element $\hat{y}[j][i]$ is written into the bitstream. k is any integer, for example, 0, 1, -1, -2, or 3. A fourth threshold T4 is a number greater than or equal to 0 and less than 0.5, for example, a value is 0.05, 0.09, 0.17, or the like.

Method 4: When the probability distribution is the Laplace distribution, the values of the location parameter $\mu$ and the scale parameter b that are of the Laplace distribution of the current to-be-encoded feature element $\hat{y}[j][i]$ are obtained based on the probability estimation result. When an absolute value of a difference between the location parameter $\mu$ and k is less than a second threshold T5, and the scale parameter b is less than a third threshold T6 (a second condition), performing the entropy encoding process on the current to-be-encoded feature element $\hat{y}[j][i]$ is skipped. Otherwise, when an absolute value of a difference between the location parameter $\mu$ and k is less than a second threshold T5, or the scale parameter b is greater than or equal to a third threshold T6 (a first condition), entropy encoding is performed on the current to-be-encoded feature element $\hat{y}[j][i]$ and the current to-be-encoded feature element $\hat{y}[j][i]$ is written into the bitstream. k is any integer, for example, 0, 1, -1, -2, or 3. A value of T5 is 1e-2, and a value of T6 is any number that meets T6<0.5, for example, a value of 0.05, 0.09, 0.17, or the like.

In particular, when a value of k is 0, it is an optimal value. It may be directly determined that when an absolute value of the location parameter $\mu$ is less than T5, and the scale parameter b is less than T6, performing the entropy encoding process on the current to-be-encoded feature element $\hat{y}[j][i]$ is skipped. Otherwise, entropy encoding is performed on the current to-be-encoded feature element $\hat{y}[j][i]$ and the current to-be-encoded feature element $\hat{y}[j][i]$ is written into the bitstream. The value of the threshold T5 is 1e-2, and the value of T2 is any number that meets T6<0.5, for example, a value of 0.05, 0.09, 0.17, or the like.

Method 5: When the probability distribution is Gaussian mixture distribution, values of all mean value parameters $\mu_i$ and variances $\sigma_i$ that are of the Gaussian mixture distribution of the current to-be-encoded feature element $\hat{y}[j][i]$ are obtained based on the probability estimation result. When a sum of any variance of the Gaussian mixture distribution and a sum of absolute values of differences between all the mean values of the Gaussian mixture distribution and k is less than a fifth threshold T7 (a second condition), performing the entropy encoding process on the current to-be-encoded feature element $\hat{y}[j][i]$ is skipped. Otherwise, when a sum of any variance of the Gaussian mixture distribution and a sum of absolute values of differences between all the mean values of the Gaussian mixture distribution and k is greater than or equal to a fifth threshold T7 (a first condition), entropy encoding is performed on the current to-be-encoded feature element $\hat{y}[j][i]$ and the current to-be-encoded feature element $\hat{y}[j][i]$ is written into the bitstream. k is any integer, for example, 0, 1, -1, -2, or 3. T7 is a number greater than or equal to 0 and less than 1, for example, a value is 0.2, 0.3, 0.4, or the like (a threshold of each feature element may be considered to be the same).

Method 6: A probability P that a value of the current to-be-encoded feature element $\hat{y}[j][i]$ is k is obtained based on the probability distribution. When the probability estimation result P of the current to-be-encoded feature element meets a second condition: P is greater than (or equal to) a first threshold T0, performing the entropy encoding process on the current to-be-encoded feature element is skipped. Otherwise, when the probability estimation result P of the current to-be-encoded feature element meets a first condition: P is less than a first threshold T0, entropy encoding is performed on the current to-be-encoded feature element and the current to-be-encoded feature element is written into the bitstream. k may be any integer, for example, 0, 1, -1, 2, or 3. The first threshold T0 is any number that meets 0 < T0 < 1, for example, a value is 0.99, 0.98, 0.97, 0.95, or the like (a threshold of each feature element may be considered to be the same).

It should be noted that, in actual application, to ensure platform consistency, the thresholds T1, T2, T3, T4, T5, and T6 may be rounded, that is, shifted and scaled to integers.

It should be noted that, a method for obtaining the threshold may alternatively use one of the following methods. This is not limited herein.

Method 1: The threshold T1 is used as an example, any value within a value range of T1 is used as the threshold T1, and the threshold T1 is written into the bitstream. Specifically, the threshold is written into the bitstream, and may be stored in a sequence header, a picture header, a slice/slice header, or SEI, and transmitted to a decoder side. Alternatively, another method may be used. This is not limited herein. A similar method may also be used for the remaining thresholds T0, T2, T3, T4, T5, and T6.

Method 2: An encoder side uses a fixed threshold agreed with a decoder side, where the fixed threshold does not need to be written into the bitstream, and does not need to be transmitted to the decoder side. For example, the threshold T1 is used as an example, and any value within a value range of T1 is directly used as a value of T1. A similar method may also be used for the remaining thresholds T0, T2, T3, T4, T5, and T6.

Method 3: A threshold candidate list is constructed, and a most possible value within a value range of T1 is put into the threshold candidate list. Each threshold corresponds to a threshold index number, an optimal threshold is determined, and the optimal threshold is used as a value of T1. The index number of the optimal threshold is used as the threshold index number of T1, and the threshold index number of T1 is written into the bitstream. Specifically, the threshold is written into the bitstream, and may be stored in a sequence header, a picture header, a slice/slice header, or SEI, and transmitted to a decoder side. Alternatively, another method may be used. This is not limited herein. A similar method may also be used for the remaining thresholds T0, T2, T3, T4, T5, and T6.

Step 1805: An encoder sends or stores the compressed bitstream.

Decoder side:

Step 1811: Obtain the bitstream of the to-be-decoded audio feature variable.

Step 1812: Obtain the probability estimation results of the feature elements.

Entropy decoding is performed on the side information $\hat{z}$ to obtain the side information $\hat{z}$, and probability estimation is performed on each feature element $\hat{y}[j][i]$ of the to-be-decoded audio feature variable $\hat{y}$ with reference to the side information $\hat{z}$, to obtain the probability estimation result of the current to-be-decoded feature element $\hat{y}[j][i]$. The parameters j and i are positive integers, and the coordinates (j, i) indicate the location of the current to-be-decoded feature element. Alternatively, entropy decoding is performed on the side information $\hat{z}$ to obtain the side information $\hat{z}$, and probability estimation is performed on each feature element [i] of the to-be-decoded audio feature variable $\hat{y}$ with reference to the side information $\hat{z}$, to obtain the probability estimation result of the current to-be-decoded feature element $\hat{y}[i]$. The parameter i is a positive integer, and the coordinate i indicates the location of the current to-be-decoded feature element.

It should be noted that, a probability estimation method used by the decoder side is correspondingly the same as that used by the encoder side in this embodiment, and a diagram of a structure of a probability estimation network used by the decoder side is the same as that of the probability estimation network of the encoder side in this embodiment. Details are not described herein again.

1813: Whether entropy decoding needs to be performed on the current to-be-decoded feature element is determined based on the probability estimation result, and entropy decoding is performed or not performed based on the determining result to obtain the decoded feature variable $\hat{y}$.

One or more of the following methods may be used to determine, based on the probability estimation result, whether entropy decoding needs to be performed on the current to-be-decoded feature element $\hat{y}[j][i]$. Alternatively, one or more of the following methods may be used to determine, based on the probability estimation result, whether entropy decoding needs to be performed on the current to-be-decoded feature element $\hat{y}[i]$.

An example in which whether entropy decoding needs to be performed on the current to-be-decoded feature element $\hat{y}[j][i]$ is determined based on the probability estimation result is used below for description. A method for determining whether entropy decoding needs to be performed on the current to-be-decoded feature element $\hat{y}[i]$ is similar. Details are not described herein again.

Method 1: When the probability distribution model is the Gaussian distribution, the values of the mean value parameter $\mu$ and the variance $\sigma$ of the current to-be-decoded feature element $\hat{y}[j][i]$ are obtained based on the probability estimation result. When an absolute value of a difference between the mean value $\mu$ and k is less than a second threshold T1, and the variance $\sigma$ is less than a third threshold T2 (a second condition), a numerical value of the current to-be-decoded feature element $\hat{y}[j][i]$ is set to k, and performing the entropy decoding process on the current to-be-decoded feature element $\hat{y}[j][i]$ is skipped. Otherwise, when an absolute value of a difference between the mean value $\mu$ and k is less than a second threshold T1, or the variance $\sigma$ is greater than or equal to a third threshold T2 (a first condition), entropy decoding is performed on the current to-be-decoded feature element $\hat{y}[j][i]$ to obtain the value of the current to-be-decoded feature element $\hat{y}[j][i]$.

In particular, when a value of k is 0, it is an optimal value. It may be directly determined that when an absolute value of the mean value parameter $\mu$ of the Gaussian distribution is less than T1, and the variance $\sigma$ of the Gaussian distribution is less than T2, the value of the current to-be-decoded feature element $\hat{y}[j][i]$ is set to k, and performing the entropy decoding process on the current to-be-decoded feature element $\hat{y}[j][i]$ is skipped. Otherwise, entropy decoding is performed on the current to-be-decoded feature element $\hat{y}[j][i]$, and the value of the current to-be-decoded feature element $\hat{y}[j][i]$ is obtained.

Method 2: When the probability distribution is the Gaussian distribution, the values of the mean value parameter $\mu$ and the variance $\sigma$ of the current to-be-decoded feature element $\hat{y}[j][i]$ are obtained based on the probability estimation result. When a relationship between the mean value $\mu$, the variance $\sigma$, and k meets $abs(\mu-k)+\sigma<T3$ (a second condition), T3 is a fourth threshold, the value of the current to-be-decoded feature element $\hat{y}[j][i]$ is set to k, and performing the entropy decoding process on the current to-be-decoded feature element $\hat{y}[j][i]$ is skipped. Otherwise, when the probability estimation result of the current to-be-decoded feature element meets $abs(\mu-k)+\sigma\geq T3$ (a first condition), entropy decoding is performed on the current to-be-decoded feature element $\hat{y}[j][i]$ to obtain the value of the current to-be-decoded feature element $\hat{y}[j][i]$. When the probability distribution is the Gaussian distribution, only the value of the variance $\sigma$ of the current to-be-decoded feature element $\hat{y}[j][i]$ is obtained based on the probability estimation result. When a relationship of the variance $\sigma$ meets $\sigma<T3$ (the second condition), T3 is the fourth threshold, the value of the current to-be-decoded feature element $\hat{y}[j][i]$

is set to 0, and performing the entropy decoding process on the current to-be-decoded feature element $\hat{y}[j][i]$ is skipped. Otherwise, when the probability estimation result of the current to-be-decoded feature element meets $\sigma \geq T3$ (the first condition), entropy decoding is performed on the current to-be-decoded feature element $\hat{y}[j][i]$ to obtain the value of the current to-be-decoded feature element $\hat{y}[j][i]$.

Method 3: When the probability distribution is the Laplace distribution, the values of the location parameter $\mu$ and the scale parameter b are obtained based on the probability estimation result. When a relationship between the location parameter $\mu$, the scale parameter b, and k meets $abs(\mu-k)+\sigma<T4$ (a second condition), T4 is a fourth threshold, the value of the current to-be-decoded feature element $\hat{y}[j][i]$ is set to k, and performing the entropy decoding process on the feature element $\hat{y}[j][i]$ is skipped. Otherwise, when the probability estimation result of the current to-be-decoded feature element meets $abs(\mu - k) + \sigma \geq T4$ (a first condition), entropy decoding is performed on the feature element $\hat{y}[j][i]$ to obtain the value of the feature element $\hat{y}[j][i]$.

Method 4: When the probability distribution is the Laplace distribution, the values of the location parameter $\mu$ and the scale parameter b are obtained based on the probability estimation result. When an absolute value of a difference between the location parameter $\mu$ and k is less than a second threshold T5, and the scale parameter b is less than a third threshold T6 (a second condition), the value of the current to-be-decoded feature element $\hat{y}[j][i]$ is set to k, and performing the entropy decoding process on the current to-be-decoded feature element $\hat{y}[j][i]$ is skipped. Otherwise, when an absolute value of a difference between the location parameter $\mu$ and k is less than a second threshold T5, or the scale parameter b is greater than or equal to a third threshold T6 (a first condition), entropy decoding is performed on the current to-be-decoded feature element $\hat{y}[j][i]$, and the value of the current to-be-decoded feature element $\hat{y}[j][i]$ is obtained.

In particular, when a value of k is 0, it is an optimal value. It may be directly determined that when an absolute value of the location parameter $\mu$ is less than T5, and the scale parameter b is less than T6, the value of the current to-be-decoded feature element $\hat{y}[j][i]$ is set to k, and performing the entropy decoding process on the current to-be-decoded feature element $\hat{y}[j][i]$ is skipped. Otherwise, entropy decoding is performed on the current to-be-decoded feature element $\hat{y}[j][i]$, and the value of the current to-be-decoded feature element $\hat{y}[j][i]$ is obtained.

Method 5: When the probability distribution is Gaussian mixture distribution, values of all mean value parameters $\mu_i$ and variances $\sigma_i$ that are of the Gaussian mixture distribution of the current to-be-decoded feature element $\hat{y}[j][i]$ are obtained based on the probability estimation result. When a sum of any variance of the Gaussian mixture distribution and a sum of absolute values of differences between all the mean values of the Gaussian mixture distribution and k is less than a fifth threshold T7 (a second condition), the value of the current to-be-decoded feature element $\hat{y}[j][i]$ is set to k, and performing the entropy decoding process on the current to-be-decoded feature element $\hat{y}[j][i]$ is skipped. Otherwise, when a sum of any variance of the Gaussian mixture distribution and a sum of absolute values of differences between all the mean values of the Gaussian mixture distribution and k is greater than or equal to a fifth threshold T7 (a first condition), entropy decoding is performed on the current to-be-decoded feature element $\hat{y}[j][i]$, and the value of the current to-be-decoded feature element $\hat{y}[j][i]$ is obtained.

Method 6: A probability P, that is, a probability estimation result P of the current to-be-decoded feature element, that the value of the current to-be-decoded feature element is k is obtained based on the probability distribution of the current to-be-decoded feature element. When the probability estimation result P meets a second condition: P is greater than a first threshold T0, entropy decoding does not need to be performed on the first feature element, and the value of the current to-be-decoded feature element is set to k. Otherwise, when the current to-be-decoded feature element meets a first condition: P is less than or equal to a first threshold T0, entropy decoding is performed on the bitstream, and the value of the first feature element is obtained.

The value k of the foregoing decoder side is set correspondingly to the value k of the encoder side.

A method for obtaining the thresholds T0, T1, T2, T3, T4, T5, T6, and T7 corresponds to that of the encoder side, and one of the following methods may be used.

Method 1: The threshold is obtained from the bitstream. Specifically, the threshold is obtained from a sequence header, a picture header, a slice/slice header, or SEI.

Method 2: The decoder side uses a fixed threshold agreed with the encoder side.

Method 3: A threshold index number is obtained from the bitstream. Specifically, the threshold index number is obtained from a sequence header, a picture header, a slice/slice header, or SEI. Then, the decoder side constructs a threshold candidate list in the same manner as the encoder, and obtains a corresponding threshold in the threshold candidate list based on the threshold index number.

It should be noted that, in actual application, to ensure platform consistency, the thresholds T1, T2, T3, T4, T5, and T6 may be rounded, that is, shifted and scaled to integers.

Step 1814: Reconstruct the decoded feature variable y, or perform a corresponding machine task by inputting the decoded feature map into a machine-oriented audition task module to perform a corresponding machine task. This step may be specifically implemented by the decoder network 306 in FIG. 10B. For details, refer to the foregoing description of the decoder network 34.

Case 1: The feature variable $\hat{y}$ obtained through entropy decoding is input into a picture reconstruction module, and a neural network outputs a reconstructed audio. The neural network may use any structure, for example, a fully-connected network, a convolutional neural network, or a recurrent neural network. The neural network may use a multi-layer structure deep neural network structure to achieve better estimation effect.

Case 2: The feature variable $\hat{y}$ obtained through entropy decoding is input into the machine-oriented audition task module to perform the corresponding machine task. For example, machine audition tasks such as audio classification and recognition are completed.

The value k of the foregoing decoder side is set correspondingly to the value k of the encoder side.

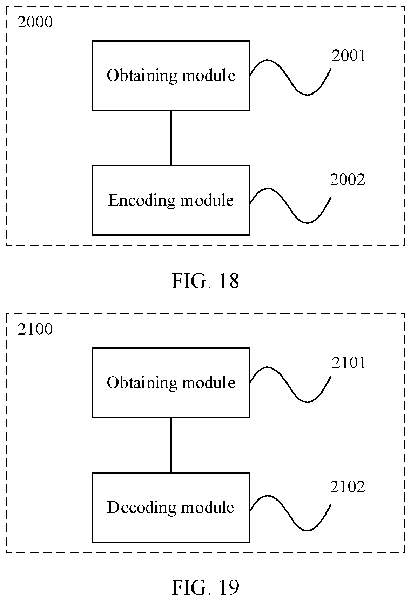

FIG. 18 is a schematic diagram of an example structure of an encoding apparatus according to this application. As shown in FIG. 18, the apparatus in this example may correspond to the encoder 20A. The apparatus may include an obtaining module 2001 and an encoding module 2002. The obtaining module 2001 may include the encoder network 204, rounding 206 (optional), the probability estimation 210, the side information extraction 214, the generative network 216 (optional), and the joint network 218 (optional) in the foregoing embodiment. The encoding module 2002 includes the encoding decision implementation 208 in the foregoing embodiment.

The obtaining module 2001 is configured to: obtain to-be-encoded feature data, where the to-be-encoded feature data includes a plurality of feature elements, and the plurality of feature elements include a first feature element; and obtain a probability estimation result of the first feature element. The encoding module 2002 is configured to: determine, based on the probability estimation result of the first feature element, whether to perform entropy encoding on the first feature element; and perform entropy encoding on the first feature element only when it is determined that entropy encoding needs to be performed on the first feature element.

In a possible implementation, the determining whether to perform entropy encoding on the first feature element of the feature data includes: When the probability estimation result of the first feature element of the feature data meets a preset condition, entropy encoding needs to be performed on the first feature element of the feature data. When the probability estimation result of the first feature element of the feature data does not meet a preset condition, entropy encoding does not need to be performed on the first feature element of the feature data.

In a possible implementation, the encoding module is further configured to determine, based on the probability estimation result of the feature data, that the probability estimation result of the feature data is input into a generative network, where the network outputs decision information. When a value of the decision information of the first feature element is 1, the first feature element of the feature data needs to be encoded. When the value of the decision information of the first feature element is not 1, the first feature element of the feature data does not need to be encoded.

In a possible implementation, the preset condition is that a probability value that the value of the first feature element is k is less than or equal to a first threshold, where k is an integer.

In a possible implementation, the preset condition is that an absolute value of a difference between a mean value of probability distribution of the first feature element and the value k of the first feature element is greater than or equal to a second threshold, or a variance of the first feature element is greater than or equal to a third threshold, where k is an integer.

In another possible implementation, the preset condition is that a sum of a variance of probability distribution of the first feature element and an absolute value of a difference between a mean value of the probability distribution of the first feature element and the value k of the first feature element is greater than or equal to a fourth threshold, where k is an integer.

In a possible implementation, the probability value that the value of the first feature element is k is a maximum probability value in probability values of all possible values of the first feature element.

In a possible implementation, probability estimation is performed on the feature data to obtain probability estimation results of feature elements of the feature data. The probability estimation result of the first feature element includes the probability value of the first feature element, and/or a first parameter and a second parameter that are of the probability distribution.

In a possible implementation, the probability estimation result of the feature data is input into the generative network to obtain the decision information of the first feature element. Whether to perform entropy encoding on the first feature element is determined based on the decision information of the first feature element.

In a possible implementation, when the decision information of the feature data is a decision map, and a value corresponding to a location at which the first feature element is located in the decision map is a preset value, it is determined that entropy encoding needs to be performed on the first feature element. When the value corresponding to the location at which the first feature element is located in the decision map is not a preset value, it is determined that entropy encoding does not need to be performed on the first feature element.

In a possible implementation, when the decision information of the feature data is the preset value, it is determined that entropy encoding needs to be performed on the first feature element. When the decision information is not the preset value, it is determined that entropy encoding does not need to be performed on the first feature element. In a possible implementation, the encoding module is further configured to: construct a threshold candidate list of the first threshold, put the first threshold into the threshold candidate list of the first threshold, where there is an index number corresponding to the first threshold, and write the index number of the first threshold into an encoded bitstream, where a length of the threshold candidate list of the first threshold may be set to T, and T is an integer greater than or equal to 1.

The apparatus in this embodiment may be used in the technical solutions implemented by the encoder in the method embodiments shown in FIG. 3A to FIG. 3D. Implementation principles and technical effect thereof are similar. Details are not described herein again.

FIG. 19 is a schematic diagram of an example structure of a decoding apparatus according to this application. As shown in FIG. 19, the apparatus in this example may correspond to the decoder 30. The apparatus may include an obtaining module 2101 and a decoding module 2102. The obtaining module 2101 may include the probability estimation 302, the generative network 310 (optional), and the joint network 312 in the foregoing embodiment. The decoding module 2102 includes the decoding decision implementation 304 and the decoder network 306 in the foregoing embodiment.

The obtaining module 2101 is configured to: obtain a bitstream of to-be-decoded feature data, where the to-be-decoded feature data includes a plurality of feature elements, and the plurality of feature elements include a first feature element; and obtain a probability estimation result of the first feature element. The decoding module 2102 is configured to: determine, based on the probability estimation result of the first feature element, whether to perform entropy decoding on the first feature element; and perform entropy decoding on the first feature element only when it is determined that entropy decoding needs to be performed on the first feature element.

In a possible implementation, the determining whether to perform entropy decoding on the first feature element of the feature data includes: When the probability estimation result of the first feature element of the feature data meets a preset condition, the first feature element of the feature data needs to be decoded. Alternatively, when the probability estimation result of the first feature element of the feature data does not meet a preset condition, the first feature element of the feature data does not need to be decoded, and a feature value of the first feature element is set to k, where k is an integer.

In a possible implementation, the decoding module is further configured to determine, based on the probability estimation result of the feature data, that the probability estimation result of the feature data is input into a determining network module, where the network outputs decision information. The first feature element of the feature data is decoded when a value of a location that is in the decision information and that corresponds to the first feature element of the feature data is 1. The first feature element of the feature data is not decoded when a value of a location that is in the decision information and that corresponds to the first feature element of the feature data is not 1, and the feature value of the first feature element is set to k, where k is an integer.

In a possible implementation, the preset condition is that a probability value that the value of the first feature element is k is less than equal to a first threshold, where k is an integer.

In another possible implementation, the preset condition is that an absolute value of a difference between a mean value of probability distribution of the first feature element and the value k of the first feature element is greater than or equal to a second threshold, or a variance of the probability distribution of the first feature element is greater than or equal to a third threshold.

In another possible implementation, the preset condition is that a sum of a variance of probability distribution of the first feature element and an absolute value of a difference between a mean value of the probability distribution of the first feature element and the value k of the first feature element is greater than or equal to a fourth threshold.

In a possible implementation, probability estimation is performed on the feature data to obtain probability estimation results of feature elements of the feature data. The probability estimation result of the first feature element includes the probability value of the first feature element, and/or a first parameter and a second parameter that are of the probability distribution.

In a possible implementation, the probability value that the value of the first feature element is k is a maximum probability value in probability values of all possible values of the first feature element.

In a possible implementation, a probability estimation result of an $N^{th}$ feature element includes at least one of the following: a probability value of the $N^{th}$ feature element, a first parameter and a second parameter that are of probability distribution, and decision information. The first feature element of the feature data is decoded when a value of a location that is in the decision information and that corresponds to the first feature element of the feature data is 1. The first feature element of the feature data is not decoded when a value of a location that is in the decision information and that corresponds to the first feature element of the feature data is not 1, and the feature value of the first feature element is set to k, where k is an integer.

In a possible implementation, the probability estimation result of the feature data is input into a generative network to obtain the decision information of the first feature element. When a value of the decision information of the first feature element is a preset value, it is determined that entropy decoding needs to be performed on the first feature element. When a value of the decision information of the first feature element is not a preset value, it is determined that entropy decoding does not need to be performed on the first feature element, and the feature value of the first feature element is set to k, where k is an integer and k is one of a plurality of candidate values of the first feature element.

In a possible implementation, the obtaining module is further configured to: construct a threshold candidate list of the first threshold, obtain an index number of the threshold candidate list of the first threshold by decoding the bitstream, and use, as a value of the first threshold, a value of a location that corresponds to the index number of the first threshold and that is of the threshold candidate list of the first threshold. A length of the threshold candidate list of the first threshold may be set to T, and T is an integer greater than or equal to 1.

The apparatus in this embodiment may be used in the technical solutions implemented by the decoder in the method embodiments shown in FIG. 10B, FIG. 13B, and FIG. 16. Implementation principles and technical effect thereof are similar. Details are not described herein again.

A person skilled in the art can appreciate that functions described with reference to various illustrative logical blocks, modules, and algorithm steps disclosed and described herein may be implemented by hardware, software, firmware, or any combination thereof. If implemented by software, the functions described with reference to the illustrative logical blocks, modules, and steps may be stored in or transmitted over a computer-readable medium as one or more instructions or code and determined by a hardware-based processing unit. The computer-readable medium may include a computer-readable storage medium, which corresponds to a tangible medium such as a data storage medium, or may include any communication medium that facilitates transmission of a computer program from one place to another (for example, according to a communication protocol). In this manner, the computer-readable medium may generally correspond to: (1) a non-transitory tangible computer-readable storage medium, or (2) a communication medium such as a signal or a carrier. The data storage medium may be any usable medium that can be accessed by one or more computers or one or more processors to retrieve instructions, code, and/or data structures for implementing the technologies described in this application. A computer program product may include a computer-readable medium.

By way of example and not limitation, such computer-readable storage media may include a RAM, a ROM, an EEPROM, a CD-ROM or another optical disc storage apparatus, a magnetic disk storage apparatus or another magnetic storage apparatus, a flash memory, or any other medium that can store required program code in a form of instructions or data structures and that can be accessed by a computer. In addition, any connection is properly referred to as a computer-readable medium. For example, if instructions are transmitted from a website, a server, or another remote source through a coaxial cable, an optical fiber, a twisted pair, a digital subscriber line (DSL), or a wireless technology such as infrared, radio, or microwave, the coaxial cable, the optical fiber, the twisted pair, the DSL, or the wireless technology such as infrared, radio, or microwave is included in a definition of the medium. However, it should be understood that the computer-readable storage medium and the data storage medium do not include connections, carriers, signals, or other transitory media, but actually mean non-transitory tangible storage media. Disks and discs used in this specification include a compact disc (CD), a laser disc, an optical disc, a digital versatile disc (DVD), and a Blu-ray disc. The disks usually reproduce data magnetically, whereas the discs reproduce data optically by using lasers. Combinations of the above should also be included within the scope of the computer-readable medium.

Instructions may be executed by one or more processors such as one or more digital signal processors (DSP), a general microprocessor, an application-specific integrated circuit (ASIC), a field programmable gate array (FPGA), or an equivalent integrated circuit or discrete logic circuit. Therefore, the term "processor" used in this specification may refer to the foregoing structure, or any other structure that may be applied to implementation of the technologies described in this specification. In addition, in some aspects, the functions described with reference to the illustrative logical blocks, modules, and steps described in this specification may be provided within dedicated hardware and/or software modules configured for encoding and decoding, or may be incorporated into a combined codec. In addition, the technologies may be completely implemented in one or more circuits or logic elements.

The technologies in this application may be implemented in various apparatuses or devices, including a wireless handset, an integrated circuit (IC), or a set of ICs (for example, a chip set). Various components, modules, or units are described in this application to emphasize functional aspects of devices configured to determine the disclosed techniques, but do not necessarily require implementation by different hardware units. Actually, as described above, various units may be combined into a codec hardware unit in combination with appropriate software and/or firmware, or may be provided by interoperable hardware units (including the one or more processors described above).

The foregoing descriptions are merely example specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A feature data encoding method, comprising:

   obtaining to-be-encoded feature data, wherein the to-be-encoded feature data comprises a plurality of feature elements, and the plurality of feature elements comprise a first feature element; obtaining a probability estimation result of the first feature element; determining, based on the probability estimation result of the first feature element, whether to perform entropy encoding on the first feature element; and performing entropy encoding on the first feature element only when it is determined that entropy encoding needs to be performed on the first feature element.

2. The method according to claim 1, wherein the determining, based on the probability estimation result of the first feature element, whether to perform entropy encoding on the first feature element comprises:

when the probability estimation result of the first feature element meets a preset condition, determining that entropy encoding needs to be performed on the first feature element; or when the probability estimation result of the first feature element does not meet a preset condition, determining that entropy encoding does not need to be performed on the first feature element.

3. The method according to claim 2, wherein when the probability estimation result of the first feature element is a probability value that a value of the first feature element is k, the preset condition is that the probability value that the value of the first feature element is k is less than or equal to a first threshold, wherein k is an integer, and k is one of a plurality of candidate values of the first feature element.

4. The method according to claim 2, wherein when the probability estimation result of the first feature element comprises a first parameter and a second parameter that are of probability distribution of the first feature element, the preset condition is:

an absolute value of a difference between the first parameter of the probability distribution of the first feature element and a value k of the first feature element is greater than or equal to a second threshold; the second parameter of the probability distribution of the first feature element is greater than or equal to a third threshold; or a sum of the second parameter of the probability distribution of the first feature element and an absolute value of a difference between the first parameter of the probability distribution of the first feature element and a value k of the first feature element is greater than or equal to a fourth threshold, wherein k is an integer, and k is one of a plurality of candidate values of the first feature element.

5. The method according to claim 4, wherein

when the probability distribution is Gaussian distribution, the first parameter of the probability distribution of the first feature element is a mean value of the Gaussian distribution of the first feature element, and the second parameter of the probability distribution of the first feature element is a variance of the Gaussian distribution of the first feature element; or when the probability distribution is Laplace distribution, the first parameter of the probability distribution of the first feature element is a location parameter of the Laplace distribution of the first feature element, and the second parameter of the probability distribution of the first feature element is a scale parameter of the Laplace distribution of the first feature element.

6. The method according to claim 3, wherein the method further comprises:
constructing a threshold candidate list, putting the first threshold into the threshold candidate list, and writing an index number corresponding to the first threshold into an encoded bitstream, wherein a length of the threshold candidate list is T, and T is an integer greater than or equal to 1.

7. The method according to claim 2, wherein when the probability estimation result of the first feature element is obtained through Gaussian mixture distribution, the preset condition is:

a sum of any variance of the Gaussian mixture distribution of the first feature element and a sum of absolute values of differences between all mean values of the Gaussian mixture distribution of the first feature element and a value k of the first feature element is greater than or equal to a fifth threshold; a difference between any mean value of the Gaussian mixture distribution of the first feature element and a value k of the first feature element is greater than or equal to a sixth threshold; or any variance of the Gaussian mixture distribution of the first feature element is greater than or equal to a seventh threshold, wherein k is an integer, and k is one of a plurality of candidate values of the first feature element.

8. The method according to claim 2, wherein when the probability estimation result of the first feature element is obtained through asymmetric Gaussian distribution, the preset condition is:

an absolute value of a difference between a mean value of the asymmetric Gaussian distribution of the first feature element and a value k of the first feature element is greater than or equal to an eighth threshold;

a first variance of the asymmetric Gaussian distribution of the first feature element is greater than or equal to a ninth threshold; or

a second variance of the asymmetric Gaussian distribution of the first feature element is greater than or equal to a tenth threshold, wherein

k is an integer, and k is one of a plurality of candidate values of the first feature element.

9. The method according to any one of claims 3 to 8, wherein

the probability value that the value of the first feature element is k is a maximum probability value in probability values of all candidate values of the first feature element.

10. The method according to claim 1, wherein the determining, based on the probability estimation result of the first feature element, whether to perform entropy encoding on the first feature element comprises:

inputting a probability estimation result of the feature data into a generative network to obtain decision information of the first feature element; and

determining, based on the decision information of the first feature element, whether to perform entropy encoding on the first feature element.

11. The method according to claim 10, wherein when decision information of the feature data is a decision map, and a value corresponding to a location at which the first feature element is located in the decision map is a preset value, it is determined that entropy encoding needs to be performed on the first feature element; and

when the value corresponding to the location at which the first feature element is located in the decision map is not the preset value, it is determined that entropy encoding does not need to be performed on the first feature element.

12. The method according to claim 10, wherein when decision information of the feature data is a preset value, it is determined that entropy encoding needs to be performed on the first feature element; and

when the decision information is not the preset value, it is determined that entropy encoding does not need to be performed on the first feature element.

13. The method according to any one of claims 1 to 12, wherein the plurality of feature elements further comprise a second feature element, and when it is determined that entropy encoding does not need to be performed on the second feature element, performing entropy encoding on the second feature element is skipped.

14. The method according to any one of claims 1 to 13, wherein the method further comprises:
writing, into the encoded bitstream, entropy encoding results of the plurality of feature elements comprising the first feature element.

15. A feature data decoding method, comprising:

obtaining a bitstream of to-be-decoded feature data, wherein

the to-be-decoded feature data comprises a plurality of feature elements, and the plurality of feature elements comprise a first feature element;

obtaining a probability estimation result of the first feature element;

determining, based on the probability estimation result of the first feature element, whether to perform entropy decoding on the first feature element; and

performing entropy decoding on the first feature element only when it is determined that entropy decoding needs to be performed on the first feature element.

16. The method according to claim 15, wherein the determining, based on the probability estimation result of the first feature element, whether to perform entropy decoding on the first feature element comprises:

when the probability estimation result of the first feature element meets a preset condition, determining that entropy decoding needs to be performed on the first feature element of the feature data; or

when the probability estimation result of the first feature element does not meet a preset condition, determining that entropy decoding does not need to be performed on the first feature element of the feature data, and setting a feature value of the first feature element to k, wherein k is an integer, and k is one of a plurality of candidate values of the first feature element.

17. The method according to claim 16, wherein when the probability estimation result of the first feature element is a probability value that the value of the first feature element is k, the preset condition is that the probability value that the value of the first feature element is k is less than or equal to a first threshold, wherein k is an integer, and k is one of the plurality of candidate values of the first feature element.

**18.** The method according to claim 16, wherein when the probability estimation result of the first feature element comprises a first parameter and a second parameter that are of probability distribution of the first feature element, the preset condition is:

an absolute value of a difference between the first parameter of the probability distribution of the first feature element and the value k of the first feature element is greater than or equal to a second threshold;
the second parameter of the probability distribution of the first feature element is greater than or equal to a third threshold; or
a sum of the second parameter of the probability distribution of the first feature element and an absolute value of a difference between the first parameter of the probability distribution of the first feature element and the value k of the first feature element is greater than or equal to a fourth threshold, wherein
k is an integer, and k is one of the plurality of candidate values of the first feature element.

**19.** The method according to claim 18, wherein

when the probability distribution is Gaussian distribution, the first parameter of the probability distribution of the first feature element is a mean value of the Gaussian distribution of the first feature element, and the second parameter of the probability distribution of the first feature element is a variance of the Gaussian distribution of the first feature element; or
when the probability distribution is Laplace distribution, the first parameter of the probability distribution of the first feature element is a location parameter of the Laplace distribution of the first feature element, and the second parameter of the probability distribution of the first feature element is a scale parameter of the Laplace distribution of the first feature element.

**20.** The method according to claim 16, wherein when the probability estimation result of the first feature element is obtained through Gaussian mixture distribution, the preset condition is:

a sum of any variance of the Gaussian mixture distribution of the first feature element and a sum of absolute values of differences between all mean values of the Gaussian mixture distribution of the first feature element and the value k of the first feature element is greater than or equal to a fifth threshold;
a difference between any mean value of the Gaussian mixture distribution of the first feature element and the value k of the first feature element is greater than or equal to a sixth threshold; or
any variance of the Gaussian mixture distribution of the first feature element is greater than or equal to a seventh threshold, wherein
k is an integer, and k is one of the plurality of candidate values of the first feature element.

**21.** The method according to claim 16, wherein when the probability estimation result of the first feature element is obtained through asymmetric Gaussian distribution, the preset condition is:

an absolute value of a difference between a mean value of the asymmetric Gaussian distribution of the first feature element and the value k of the first feature element is greater than or equal to an eighth threshold;
a first variance of the asymmetric Gaussian distribution of the first feature element is greater than or equal to a ninth threshold; or
a second variance of the asymmetric Gaussian distribution of the first feature element is greater than or equal to a tenth threshold, wherein
k is an integer, and k is one of the plurality of candidate values of the first feature element.

**22.** The apparatus according to any one of claims 16 to 21, wherein the probability value that the value of the first feature element is k is a maximum probability value in probability values of all candidate values of the first feature element.

**23.** The method according to claim 15, wherein the determining, based on the probability estimation result of the first feature element, whether to perform entropy decoding on the first feature element comprises:

inputting a probability estimation result of the feature data into a generative network to obtain decision information of the first feature element; and
determining, based on the decision information of the first feature element, whether to perform entropy decoding on the first feature element.

**24.** The method according to claim 23, wherein when decision information of the feature data is a decision map, and a value corresponding to a location at which the first feature element is located in the decision map is a preset value, it is determined that entropy decoding needs to be performed on the first feature element; and
when the value corresponding to the location at which the first feature element is located in the decision map is not the preset value, it is determined that entropy decoding does not need to be performed on the first feature element.

25. The method according to claim 23, wherein when decision information of the feature data is a preset value, it is determined that entropy decoding needs to be performed on the first feature element; and when the decision information is not the preset value, it is determined that entropy decoding does not need to be performed on the first feature element.

26. The method according to any one of claims 15 to 25, wherein the method further comprises:
   obtaining the reconstructed data or machine-oriented task data obtained after the feature data passes through a decoder network.

27. A feature data encoding apparatus, comprising:

   an obtaining module, configured to: obtain to-be-encoded feature data, wherein the to-be-encoded feature data comprises a plurality of feature elements, and the plurality of feature elements comprise a first feature element; and obtain a probability estimation result of the first feature element; and
   an encoding module, configured to: determine, based on the probability estimation result of the first feature element, whether to perform entropy encoding on the first feature element; and perform entropy encoding on the first feature element only when it is determined that entropy encoding needs to be performed on the first feature element.

28. The apparatus according to claim 27, wherein the determining, based on the probability estimation result of the first feature element, whether to perform entropy encoding on the first feature element comprises:

   when the probability estimation result of the first feature element meets a preset condition, determining that entropy encoding needs to be performed on the first feature element of the feature data; or
   when the probability estimation result of the first feature element does not meet a preset condition, determining that entropy encoding does not need to be performed on the first feature element of the feature data.

29. The apparatus according to claim 28, wherein when the probability estimation result of the first feature element is a probability value that a value of the first feature element is k, the preset condition is that the probability value that the value of the first feature element is k is less than or equal to a first threshold, wherein k is an integer, and k is one of a plurality of candidate values of the first feature element.

30. The apparatus according to claim 28, wherein when the probability estimation result of the first feature element comprises a first parameter and a second parameter that are of probability distribution of the first feature element, the preset condition is:

   an absolute value of a difference between the first parameter of the probability distribution of the first feature element and a value k of the first feature element is greater than or equal to a second threshold;
   the second parameter of the probability distribution of the first feature element is greater than or equal to a third threshold; or
   a sum of the second parameter of the probability distribution of the first feature element and an absolute value of a difference between the first parameter of the probability distribution of the first feature element and a value k of the first feature element is greater than or equal to a fourth threshold, wherein
   k is an integer, and k is one of a plurality of candidate values of the first feature element.

31. The apparatus according to claim 30, wherein

   when the probability distribution is Gaussian distribution, the first parameter of the probability distribution of the first feature element is a mean value of the Gaussian distribution of the first feature element, and the second parameter of the probability distribution of the first feature element is a variance of the Gaussian distribution of the first feature element; or
   when the probability distribution is Laplace distribution, the first parameter of the probability distribution of the first feature element is a location parameter of the Laplace distribution of the first feature element, and the second parameter of the probability distribution of the first feature element is a scale parameter of the Laplace distribution of the first feature element.

32. The apparatus according to claim 29, wherein the encoding module is further configured to: construct a threshold candidate list, put the first threshold into the threshold candidate list, and write an index number corresponding to the first threshold into an encoded bitstream, wherein a length of the threshold candidate list is T, and T is an integer greater than or equal to 1.

33. The apparatus according to claim 28, wherein when the probability estimation result of the first feature element is obtained through Gaussian mixture distribution, the preset condition is:

a sum of any variance of the Gaussian mixture distribution of the first feature element and a sum of absolute values of differences between all mean values of the Gaussian mixture distribution of the first feature element and a value k of the first feature element is greater than or equal to a fifth threshold;

a difference between any mean value of the Gaussian mixture distribution of the first feature element and a value k of the first feature element is greater than or equal to a sixth threshold; or any variance of the Gaussian mixture distribution of the first feature element is greater than or equal to a seventh threshold, wherein k is an integer, and k is one of a plurality of candidate values of the first feature element.

34. The apparatus according to claim 28, wherein when the probability estimation result of the first feature element is obtained through asymmetric Gaussian distribution, the preset condition is:

an absolute value of a difference between a mean value of the asymmetric Gaussian distribution of the first feature element and a value k of the first feature element is greater than or equal to an eighth threshold;
a first variance of the asymmetric Gaussian distribution of the first feature element is greater than or equal to a ninth threshold; or a second variance of the asymmetric Gaussian distribution of the first feature element is greater than or equal to a tenth threshold, wherein k is an integer, and k is one of a plurality of candidate values of the first feature element.

35. The method according to any one of claims 29 to 34, wherein
the probability value that the value of the first feature element is k is a maximum probability value in probability values of all candidate values of the first feature element.

36. The apparatus according to claim 27, wherein the determining, based on the probability estimation result of the first feature element, whether to perform entropy encoding on the first feature element comprises:

inputting a probability estimation result of the feature data into a generative network to obtain decision information of the first feature element; and
determining, based on the decision information of the first feature element, whether to perform entropy encoding on the first feature element.

37. The apparatus according to claim 36, wherein when decision information of the feature data is a decision map, and a value corresponding to a location at which the first feature element is located in the decision map is a preset value, it is determined that entropy encoding needs to be performed on the first feature element; and
when the value corresponding to the location at which the first feature element is located in the decision map is not the preset value, it is determined that entropy encoding does not need to be performed on the first feature element.

38. The apparatus according to claim 36, wherein when decision information of the feature data is a preset value, it is determined that entropy encoding needs to be performed on the first feature element; and when the decision information is not the preset value, it is determined that entropy encoding does not need to be performed on the first feature element.

39. The apparatus according to any one of claims 27 to 38, wherein the plurality of feature elements further comprise a second feature element, and when it is determined that entropy encoding does not need to be performed on the second feature element, performing entropy encoding on the second feature element is skipped.

40. The apparatus according to any one of claims 27 to 39, wherein the encoding module further comprises: writing, into the encoded bitstream, entropy encoding results of the plurality of feature elements comprising the first feature element.

41. A feature data decoding apparatus, comprising:

an obtaining module, configured to: obtain a bitstream of to-be-decoded feature data, wherein the to-be-decoded feature data comprises a plurality of feature elements, and the plurality of feature elements comprise a first feature element; and obtain a probability estimation result of the first feature element; and
a decoding module, configured to: determine, based on the probability estimation result of the first feature element, whether to perform entropy decoding on the first feature element; and perform entropy decoding on the first feature element only when it is determined that entropy decoding needs to be performed on the first feature element.

42. The apparatus according to claim 41, wherein the determining, based on the probability estimation result of the first feature element, whether to perform entropy decoding on the first feature element comprises:

when the probability estimation result of the first feature element meets a preset condition, determining that entropy decoding needs to be performed on the first feature element of the feature data; or

when the probability estimation result of the first feature element does not meet a preset condition, determining that entropy decoding does not need to be performed on the first feature element of the feature data, and setting a feature value of the first feature element to k, wherein k is an integer, and k is one of a plurality of candidate values.

43. The apparatus according to claim 42, wherein when the probability estimation result of the first feature element is a probability value that the value of the first feature element is k, the preset condition is that the probability value that the value of the first feature element is k is less than or equal to a first threshold, wherein k is an integer, and k is one of the plurality of candidate values of the first feature element.

44. The apparatus according to claim 42, wherein when the probability estimation result of the first feature element comprises a first parameter and a second parameter that are of probability distribution of the first feature element, the preset condition is:

an absolute value of a difference between the first parameter of the probability distribution of the first feature element and the value k of the first feature element is greater than or equal to a second threshold;
the second parameter of the probability distribution of the first feature element is greater than or equal to a third threshold; or
a sum of the second parameter of the probability distribution of the first feature element and an absolute value of a difference between the first parameter of the probability distribution of the first feature element and the value k of the first feature element is greater than or equal to a fourth threshold, wherein
k is an integer, and k is one of the plurality of candidate values of the first feature element.

45. The apparatus according to claim 44, wherein

when the probability distribution is Gaussian distribution, the first parameter of the probability distribution of the first feature element is a mean value of the Gaussian distribution of the first feature element, and the second parameter of the probability distribution of the first feature element is a variance of the Gaussian distribution of the first feature element; or
when the probability distribution is Laplace distribution, the first parameter of the probability distribution of the first feature element is a location parameter of the Laplace distribution of the first feature element, and the second parameter of the probability distribution of the first feature element is a scale parameter of the Laplace distribution of the first feature element.

46. The apparatus according to claim 42, wherein when the probability estimation result of the first feature element is obtained through Gaussian mixture distribution, the preset condition is:

a sum of any variance of the Gaussian mixture distribution of the first feature element and a sum of absolute values of differences between all mean values of the Gaussian mixture distribution of the first feature element and the value k of the first feature element is greater than or equal to a fifth threshold;
a difference between any mean value of the Gaussian mixture distribution of the first feature element and the value k of the first feature element is greater than or equal to a sixth threshold; or
any variance of the Gaussian mixture distribution of the first feature element is greater than or equal to a seventh threshold, wherein
k is an integer, and k is one of the plurality of candidate values of the first feature element.

47. The apparatus according to claim 42, wherein when the probability estimation result of the first feature element is obtained through asymmetric Gaussian distribution, the preset condition is:

an absolute value of a difference between a mean value of the asymmetric Gaussian distribution of the first feature element and the value k of the first feature element is greater than or equal to an eighth threshold;
a first variance of the asymmetric Gaussian distribution of the first feature element is greater than or equal to a ninth threshold; or
a second variance of the asymmetric Gaussian distribution of the first feature element is greater than or equal to a tenth threshold, wherein
k is an integer, and k is one of the plurality of candidate values of the first feature element.

48. The apparatus according to any one of claims 42 to 47, wherein the probability value that the value of the first feature element is k is a maximum probability value in probability values of all candidate values of the first feature element.

49. The apparatus according to claim 41, wherein the determining, based on the probability estimation result of the first feature element, whether to perform entropy decoding on the first feature element comprises:

inputting a probability estimation result of the feature data into a generative network to obtain decision information of the first feature element; and
determining, based on the decision information of the first feature element, whether to perform entropy decoding on the first feature element.

50. The apparatus according to claim 49, wherein when decision information of the feature data is a decision map, and a value corresponding to a location at which the first feature element is located in the decision map is a preset value, entropy decoding needs to be performed on the first feature element; and when the value corresponding to the location at which the first feature element is located in the decision map is not the preset value, entropy decoding does not need to be performed on the first feature element.

51. The apparatus according to claim 49, wherein when decision information of the feature data is a preset value, it is determined that entropy decoding needs to be performed on the first feature element; and when the decision information is not the preset value, it is determined that entropy decoding does not need to be performed on the first feature element.

52. The apparatus according to any one of claims 41 to 51, wherein
the decoding module is further configured to obtain the reconstructed data or machine-oriented task data by the feature data passing through a decoder network.

53. A feature data encoding method, comprising:

obtaining to-be-encoded feature data, wherein the feature data comprises a plurality of feature elements, and the plurality of feature elements comprise a first feature element;
obtaining side information of the feature data, and inputting the side information of the feature data into a joint network to obtain decision information of the first feature element;
determining, based on the decision information of the first feature element, whether to perform entropy encoding on the first feature element; and
performing entropy encoding on the first feature element only when it is determined that entropy encoding needs to be performed on the first feature element.

54. The method according to claim 53, wherein when the decision information of the feature data is a decision map, and a value corresponding to a location at which the first feature element is located in the decision map is a preset value, it is determined that entropy encoding needs to be performed on the first feature element; and
when the value corresponding to the location at which the first feature element is located in the decision map is not the preset value, it is determined that entropy encoding does not need to be performed on the first feature element.

55. The method according to claim 53, wherein when the decision information of the feature data is a preset value, it is determined that entropy encoding needs to be performed on the first feature element; and
when the decision information is not the preset value, it is determined that entropy encoding does not need to be performed on the first feature element.

56. The method according to any one of claims 53 to 55, wherein the plurality of feature elements further comprise a second feature element, and when it is determined that entropy encoding does not need to be performed on the second feature element, performing entropy encoding on the second feature element is skipped.

57. The method according to any one of claims 53 to 56, wherein the method further comprises:
writing, into an encoded bitstream, entropy encoding results of the plurality of feature elements comprising the first feature element.

58. A feature data decoding method, comprising:

obtaining a bitstream of to-be-decoded feature data and side information of the to-be-decoded feature data, wherein
the to-be-decoded feature data comprises a plurality of feature elements, and the plurality of feature elements comprise a first feature element;
inputting the side information of the to-be-decoded feature data into a joint network to obtain decision information of the first feature element;
determining, based on the decision information of the first feature element, whether to perform entropy decoding on the first feature element; and
performing entropy decoding on the first feature element only when it is determined that entropy decoding needs to be performed on the first feature element.

59. The method according to claim 58, wherein when the decision information of the feature data is a decision map, and a value corresponding to a location at which the first feature element is located in the decision map is a preset value, it is determined that entropy decoding needs to be performed on the first feature element; and

when the value corresponding to the location at which the first feature element is located in the decision map is not the preset value, it is determined that entropy decoding does not need to be performed on the first feature element, and a feature value of the first feature element is set to k, wherein k is an integer.

60. The method according to claim 58, wherein when the decision information of the feature data is a preset value, it is determined that entropy encoding needs to be performed on the first feature element; and

when the decision information is not the preset value, it is determined that entropy encoding does not need to be performed on the first feature element, and a feature value of the first feature element is set to k, wherein k is an integer.

61. The method according to any one of claims 58 to 60, wherein the method further comprises:
obtaining the reconstructed data or machine-oriented task data by the feature data passing through a decoder network.

62. An encoder, comprising a processing circuit, configured to perform the method according to any one of claims 1 to 14 and the method according to any one of claims 53 to 57.

63. A decoder, comprising a processing circuit, configured to perform the method according to any one of claims 15 to 26 and the method according to any one of claims 58 to 61.

64. A computer program product, comprising program code, wherein when the program code is determined on a computer or a processor, the program code is used to determine the method according to any one of claims 1 to 26 and the method according to any one of claims 53 to 61.

65. A non-transitory computer-readable storage medium, comprising a bitstream obtained by using the encoding method according to claim 14 or 57.

66. An encoder, comprising:

one or more processors; and
a non-transitory computer-readable storage medium, coupled to the processor and storing a program determined by the processor, wherein when the program is determined by the processor, the encoder is enabled to perform the method according to any one of claims 1 to 14 and the method according to any one of claims 53 to 57.

67. A decoder, comprising:

one or more processors; and
a non-transitory computer-readable storage medium, coupled to the processor and storing a program determined by the processor, wherein when the program is determined by the processor, the decoder is enabled to perform the method according to any one of claims 15 to 26 and the method according to any one of claims 58 to 61.

68. An encoder, comprising:

one or more processors; and
a non-transitory computer-readable storage medium, coupled to the processor and storing a program determined by the processor, wherein when the program is determined by the processor, the encoder is enabled to perform the method according to any one of claims 1 to 14 and the method according to any one of claims 53 to 57.

69. A picture or audio processor, comprising a processing circuit, configured to perform the method according to any one of claims 1 to 26 and the method according to any one of claims 53 to 61.

70. A non-transitory computer-readable storage medium, comprising program code, wherein when the program code is determined by a computer device, the program code is used to perform the method according to any one of claims 1 to 26 and the method according to any one of claims 53 to 61.

10

Source device 12

| Picture (audio) source | → | Preprocessor 18 | → | Encoder network 20 | → | Preprocessor 22 | → | Entropy decoding 24 | → | Communication interface 26 |

Source data 17

Preprocessed source data 19

To-be-encoded feature data 21

Preprocessed to-be-encoded feature data 23

Encoded bitstream 25

Probability estimation result 41

Probability estimation 40

Probability estimation result 42

Destination device 12

| Playback or display device 38 | ← | Postprocessor 36 | ← | Decoder network 34 | ← | Postprocessor 32 | ← | Entropy decoding 30 | ← | Communication interface 28 |

Postprocessed reconstructed data 37

Reconstructed data 35

Postprocessed decoded feature data 33

Decoded feature data 31

Decoded bitstream 29

Communication channel 27

FIG. 1A

Imaging (audio generation) device
51

Antenna
52

Processing circuit 56

Encoder
20A

Decoder
30A

Processor
53

Memory storage
44

Display (playback) device
55

Coding system 50

FIG. 1B

Coding device 400

Processor 430

| Ingress port 410 | Receiver unit 420 | Coding module 470 | Transmitter unit 440 | Egress port 450 |

Memory 460

FIG. 1C

502

Processor

518

Player or display

512

| Data | 506 |

| Applications: 1... |

| Application: Audio/ Video or picture coding |

| Applications: ...N |

510

| Operating system | 508 |

504

FIG. 1D

1800

1801

1802

1803

1804

| Capturing device | → | Pre-capturing processing | → | Video encoding | → | Sending |

Network

| Rendering and displaying | ← | Bitstream decoding | ← | Receiving |

1807

1806

1805

FIG. 2A

FIG. 2B

EP 4 336 829 A1

FIG. 3A

Input 202 — 203 → Encoder network 204 — 205 → Rounding 206 → Encoding decision implementation 208 → Output 212

Encoder network 204 — 205 → Probability estimation 210 → Encoding decision implementation 208

FIG. 3B

FIG. 3C

FIG. 3D

| Network layer 1 | ... | Network layer N |
|---|---|---|

FIG. 4A

| Convolutional layer 1 | → | Non-linear activation layer 1 | → | Convolutional layer 2 | → | Non-linear activation layer 2 | → | Convolutional layer 3 |
|---|---|---|---|---|---|---|---|---|

FIG. 4B

Encoding decision implementation 26

| Encoding element determining 261 | Entropy encoding 262 |
|---|---|

FIG. 5

Joint network

FIG. 6

Generative network

FIG. 7

Decoding decision implementation 30

```
┌ ─ ─ ─ ─ ─ ─ ─ ─ ─ ─ ─ ─ ─ ─ ─ ─ ─ ─ ─ ─ ─ ─ ┐
│   ┌─────────────────┐   ┌─────────────────┐   │
│   │ Decoding element│   │ Entropy decoding│   │
│   │ determining 301 │───│       302       │   │
│   └─────────────────┘   └─────────────────┘   │
└ ─ ─ ─ ─ ─ ─ ─ ─ ─ ─ ─ ─ ─ ─ ─ ─ ─ ─ ─ ─ ─ ─ ┘
```

FIG. 8

| Normalization layer | → | Convolutional layer | → | Non-linear activation layer | → | Convolutional layer | → | Non-linear activation layer |

FIG. 9

EP 4 336 829 A1

1400

| Encoder | | Decoder |

**1401: Obtain a picture feature map**

**1402: Perform probability estimation to obtain probability estimation results of feature elements**

**1403: Determine, based on the probability estimation result, whether to perform entropy encoding on the feature element, and generate a compressed bitstream (it is determined based on a probability value)**

1404: Send or store the compressed bitstream

**1411: Obtain the to-be-decoded compressed bitstream**

**1412: Obtain the probability estimation results of the feature elements**

**1413: Determine, based on the probability estimation result, whether to perform entropy decoding on the feature element to obtain the decoded feature map (it is determined based on the probability value)**

**1414: Reconstruct the decoded feature map or perform a machine task**

FIG. 10A

| Probability estimation 302 |

303

| Receiving 300 | Decoding decision implementation 304 | 305 | Decoder network 306 | Output 308 |

FIG. 10B

60

1500

| Encoder | | Decoder |

1501: Obtain a picture feature map

1502: Extract side information of the picture feature map

1503: Perform probability estimation to obtain probability estimation results of feature elements

1504: Determine, based on the probability estimation result, whether to perform entropy encoding on the feature element, and generate a compressed bitstream (it is determined based on a first parameter and a second parameter)

1505: Send or store the compressed bitstream

1511: Obtain the to-be-decoded compressed bitstream

1512: Obtain the probability estimation results of the feature elements

1513: Determine, based on the probability estimation result, whether to perform entropy decoding on the feature element to obtain the decoded feature map (it is determined based on the first parameter and the second parameter)

1514: Reconstruct the decoded feature map or perform a machine task

FIG. 11A

abs → Conv Nx3x3/1 → ReLU → Conv Nx5x5/2↓ → ReLU → Conv Nx5x5/2↓

FIG. 12

1600

```
┌──────────────┐                              ┌──────────────┐
│   Encoder    │                              │   Decoder    │
└──────┬───────┘                              └──────┬───────┘
```

┌────────────────────────────────────────────┐
│ 1601: Obtain a picture feature map          │
└────────────────────────────────────────────┘

┌────────────────────────────────────────────┐
│ 1602: Extract side information of the picture│
│              feature map                     │
└────────────────────────────────────────────┘

┌────────────────────────────────────────────┐
│ 1603: Obtain probability estimation results of│
│              feature elements                │
└────────────────────────────────────────────┘

┌────────────────────────────────────────────┐
│ 1604: Generate decision information, determine,│
│ based on the decision information, whether to│
│ perform entropy encoding on the feature element,│
│ and generate a compressed bitstream         │
└────────────────────────────────────────────┘

1605: Send or store
the compressed bitstream

┌────────────────────────────────────────────┐
│ 1611: Obtain the bitstream of a decoded picture│
└────────────────────────────────────────────┘

┌────────────────────────────────────────────┐
│ 1612: Obtain the probability estimation results of│
│           the feature elements              │
└────────────────────────────────────────────┘

┌────────────────────────────────────────────┐
│ 1613: Generate the decision information, and│
│ determine, based on the decision information,│
│ whether to perform entropy decoding on the  │
│              feature element                │
└────────────────────────────────────────────┘

┌────────────────────────────────────────────┐
│ 1614: Reconstruct the decoded feature map or│
│           perform a machine task            │
└────────────────────────────────────────────┘

FIG. 13A

FIG. 13B

1700

Encoder

Decoder

1701: Obtain a picture feature map

1702: Extract side information of the picture feature map

1703: Obtain probability estimation results and decision information of feature elements

1704: Determine, based on the decision information, whether to perform entropy encoding on the feature element, and generate a compressed bitstream

1705: Send or store the compressed bitstream

1711: Obtain the bitstream and the side information of a decoded picture

1712: Obtain the probability estimation results and the decision information of the feature elements

1713: Determine, based on the decision information, whether to perform entropy decoding on the feature element

1714: Reconstruct the decoded feature map or perform a machine task

FIG. 14

Side
information → | Network layer 11 | → | Network layer 12 | → | Network layer 13 | → Decision information

Context
information → | Network layer 21 | → | Network layer 22 | → | Network layer 3 | → | Network layer 4 | → Probability estimation result

FIG. 15

| Joint network 312 |

303

| Receiving 300 | → | Decoding decision implementation 304 | 305 → | Decoder network 306 | → | Output 308 |

FIG. 16

1800

```
┌─────────┐                                    ┌─────────┐
│ Encoder │                                    │ Decoder │
└─────────┘                                    └─────────┘
```

1801: Obtain a feature variable

1802: Obtain side information of the feature variable

1803: Perform probability estimation to obtain probability estimation results of feature elements

1804: Determine, based on the probability estimation result, whether to perform entropy encoding on the feature element, and generate a compressed bitstream (it is determined based on a first parameter and a second parameter)

1805: Send or store the compressed bitstream →

1811: Obtain the to-be-decoded compressed bitstream

1812: Obtain the probability estimation results of the feature elements

1813: Determine, based on the probability estimation result, whether to perform entropy decoding on the feature element to obtain the decoded feature variable (it is determined based on the first parameter and the second parameter)

1814: Reconstruct the decoded feature variable or perform a machine task

FIG. 17

2000

Obtaining module 2001

Encoding module 2002

FIG. 18

2100

Obtaining module 2101

Decoding module 2102

FIG. 19

**EP 4 336 829 A1**

## INTERNATIONAL SEARCH REPORT

International application No.

**PCT/CN2022/096510**

### A. CLASSIFICATION OF SUBJECT MATTER

H04N 19/13(2014.01)i; G10L 25/30(2013.01)i

According to International Patent Classification (IPC) or to both national classification and IPC

### B. FIELDS SEARCHED

Minimum documentation searched (classification system followed by classification symbols)

H04N,G10L

Documentation searched other than minimum documentation to the extent that such documents are included in the fields searched

Electronic data base consulted during the international search (name of data base and, where practicable, search terms used)

CNABS; CNTXT; WPABSC; ENTXTC; CNKI; DWPI; VEN; WOTXT; USTXT; IEEE; JVET: 特征, 概率, 熵编码, 判断, 决策, 高斯, 边信息, 神经网络, 跳过, 大于, 小于, feature, probability, entropy coding, decision, gauss, side information, neural network, skip, greater, smaller

### C. DOCUMENTS CONSIDERED TO BE RELEVANT

| Category* | Citation of document, with indication, where appropriate, of the relevant passages | Relevant to claim No. |
|---|---|---|
| Y | CN 111988629 A (FUJITSU LTD.) 24 November 2020 (2020-11-24) description, paragraphs 78-257, and figures 1-15 | 1-2, 10, 14-16, 23, 26-28, 36, 40-42, 49, 52-53, 57-58, 61-70 |
| Y | US 10652581 B1 (GOOGLE L.L.C.) 12 May 2020 (2020-05-12) description, column 17 | 1-2, 10, 14-16, 23, 26-28, 36, 40-42, 49, 52-53, 57-58, 61-70 |
| A | US 10127913 B1 (SIF CODEC LLC) 13 November 2018 (2018-11-13) entire document | 1-70 |
| A | CN 111107377 A (YAOKE INTELLIGENT TECHNOLOGY SHANGHAI CO., LTD.) 05 May 2020 (2020-05-05) entire document | 1-70 |

☐ Further documents are listed in the continuation of Box C.　　☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **26 July 2022** | **12 August 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/096510**

| Patent document cited in search report | | | Publication date (day/month/year) | Patent family member(s) | | | Publication date (day/month/year) |
|---|---|---|---|---|---|---|---|
| CN | 111988629 | A | 24 November 2020 | None | | | |
| US | 10652581 | B1 | 12 May 2020 | WO | 2020176144 | A1 | 03 September 2020 |
| | | | | CN | 113287306 | A | 20 August 2021 |
| | | | | US | 2020275130 | A1 | 27 August 2020 |
| | | | | EP | 3932055 | A1 | 05 January 2022 |
| US | 10127913 | B1 | 13 November 2018 | None | | | |
| CN | 111107377 | A | 05 May 2020 | None | | | |

Form PCT/ISA/210 (patent family annex) (January 2015)